# EUROPÄISCHE PATENTSCHRIFT

(11) **EP 3 077 440 B1**
(45) Veröffentlichungstag und Bekanntmachung des Hinweises auf die Patenterteilung: **30.10.2019**
(21) Anmeldenummer: 14812149.4
(22) Anmeldetag: 26.11.2014
(51) Int. Cl.: C08G 18/50, C08G 18/75, C08G 65/00, C08G 18/22, C08G 18/28, C08G 18/48, C09J 175/08

(54) **ALKOXYSILYLHALTIGE KLEBDICHTSTOFFE MIT INTRINSISCH REDUZIERTER VISKOSITÄT**
ALKOXYSILYL-CONTAINING ADHESIVE SEALANTS WITH INTRINSICALLY REDUCED VISCOSITY
MATIÈRES ADHÉSIVES ET D'ÉTANCHÉITÉ ALCOXYSILYLÉES À VISCOSITÉ INTRINSÈQUEMENT RÉDUITE

(30) Priorität: 03.12.2013 DE 102013224708
(43) Veröffentlichungstag der Anmeldung: 12.10.2016
(73) Patentinhaber: Evonik Degussa GmbH, 45128 Essen (DE)
(72) Erfinder: LOBERT, Matthias, 45309 Essen (DE); LEWIN, Anke, 40215 Düsseldorf (DE); FERENZ, Michael, 45147 Essen (DE); SCHUBERT, Frank, 47506 Neukirchen-Vluyn (DE)
(74) Vertreter: Evonik Patent Association
(86) Internationale Anmeldenummer: PCT/EP2014/075607
(87) Internationale Veröffentlichungsnummer: WO 2015/082264

(56) Entgegenhaltungen:
- US-A- 4 528 112
- US-A1- 2013 237 616

## Beschreibung

Gegenstand der vorliegenden Erfindung sind eine Zusammensetzung enthaltend spezielle Alkoxylierungsprodukte, ein Verfahren zu deren Herstellung sowie eine härtbare Zusammensetzung.

In einer Vielzahl von Arbeitsvorgängen und Fertigungsprozessen spielt die Verwendung von Klebstoffen und Klebdichtstoffen, welche zusätzlich eine abdichtende Funktion erfüllen, eine zunehmend wichtige Rolle. Diese Verfahren bieten gegenüber anderen Fügeverfahren, wie beispielsweise dem Schweißen oder Nieten, Vorteile hinsichtlich Gewicht und Kosten, aber auch Vorteile bei der Spannungsübertragung zwischen den Fügeteilen.

Gegenüber dem Fügen von unterschiedlichen Materialien hat Kleben zudem den Vorteil, dass es, insbesondere bei der Verwendung von elastischen Klebstoffen, das unterschiedliche Verformungsverhalten und Differenzen in thermischen Ausdehnungskoeffizienten der Materialien ausgleichen kann, und so das Fügen solcher Materialkombinationen erst ermöglicht.

Es finden sich in der Literatur verschiedene Beispiele für elastische Klebstoffe. Insbesondere haben in den letzten Jahren Klebstoffe auf Basis sogenannter silanmodifizierter Polymere aufgrund ihrer universellen Einsetzbarkeit eine breite Anwendung gefunden. Viele Beispiele in der Literatur befassen sich mit der Formulierung von Kleb-, Klebdichtstoff und Dichtstoffsystemen für eine Vielzahl von Anwendungen. Hier seien nur beispielhaft die Schriften WO 2006/136211 A1, EP 1036807 B1 und WO 2010/004038 A1 genannt, in denen die grundlegenden Konzepte der nach dem Stand der Technik üblichen Formulierungsbestandteile und Formulierungstechniken dargestellt sind. Üblicherweise handelt es sich bei dem verwendeten Basispolymer um einen Polyether, welcher in unterschiedlichen Verfahren mit feuchtigkeitsvernetzenden terminalen Alkoxysilangruppen versehen wurde. Zu dieser Produktgruppe gehören sowohl die von der Firma Kaneka unter dem Namen MS Polymer® vertriebenen silylierten Polyether, als auch die sogenannten silylierten Polyurethane (SPUR Produkte, beispielsweise Desmoseal® S, Bayer Materials Science).

Die Verwendung von Polyether-Backbones in diesen Produkten ist vor allem aufgrund ihrer geringen Glastemperatur und den somit auch bei niedrigen Temperaturen gewährleisteten elastischen Verformungscharakteristiken von Vorteil. Allerdings haben insbesondere die silylierten Polyether, wie in den Schriften JP 09012863, JP 09012861 und JP 07062222 beschrieben, aufgrund ihrer bei Einsatzbedingungen schwachen intermolekularen Wechselwirkung und der damit verbundenen reduzierten intermolekularen Übertragung von Kräften, nicht das optimale Profil für den Einsatz in Kleb- oder Dichtstoffen.

Silylierte Polyurethane, wie in DE 69831518 (WO 98/47939 A1) beschrieben, sind hier eindeutig im Vorteil, da die Urethanfunktionen und die je nach Produkt ebenfalls vorhandenen Harnstoff-Funktionen eine starke intermolekulare Kraftübertragung und somit hohe Festigkeiten der Verklebungen ermöglichen. Allerdings sind auch silylierte Polyurethane mit den Polyurethan-assoziierten Problemen, wie beispielsweise die fehlende Temperatur- und Vergilbungsbeständigkeit, sowie die für einige Anwendungen nicht ausreichende UV-Stabilität, behaftet.

Alkoxylierungsprodukte können gemäß Stand der Technik durch die Reaktion eines OH-Gruppe(n) tragenden Starters mit Propylenoxid und einer oder mehrerer Epoxidgruppen enthaltenden Alkoxysilylverbindung(en) und, je nach Ausführungsform einem oder mehreren Comonomeren durch Doppelmetallcyanidkatalysatoren (DMC-Katalysatoren), nach EP 2093244 (US 2010/0041910) und den in EP 2415796 (US 2012/028022) und EP 2415797 (US 2012/029090) beschriebenen Nachbehandlungsverfahren, sowie der noch unveröffentlichten Anmeldeschrift DE 10 2012 203737, hergestellt werden.

Neben den in den beiden vorherigen Abschnitten diskutierten Nachteilen, weisen alle bisher diskutierten Verbindungen eine weitere in vielen Fällen nachteilige Eigenschaft auf. Alle diskutierten Produkte basieren auf hochmolekularen Polyetherstrukturen von größer 4 000 g/mol und bringen somit auch eine erhöhte Viskosität einher. Die Viskosität ist in vielen Fällen so hoch, dass die Formulierung der jeweiligen Produkte erschwert wird.

Es besteht also ein Bedarf an alkoxysilylmodifizierten Polymeren, die die zuvor beschriebenen Vorteile dieser Produktklasse uneingeschränkt beibehalten, aber gleichzeitig eine deutlich geringere Viskosität aufweisen und somit vorteilhafter verarbeitbar sind.

Es hat nicht an Versuchen gefehlt dieser Schwäche, insbesondere der silylierten Polyether, durch Formulierungstricks entgegenzuwirken. So ist vor allem der Zusatz von Weichmachern zu dem silylierten Basispolymer eine weit verbreitete Möglichkeit niedrigviskosere und leichter verarbeitbare alkoxysilyl-funktionelle Polymere zu generieren. Weiterhin kann das Eigenschaftsprofil durch den Einsatz von Reaktivverdünnern modifiziert werden, wie in WO 2011/000843 A2 (US 2012/108730 A1) beschrieben.

Dieser Lösungsansatz ist jedoch nur bedingt akzeptiert, da dem Formulierer, welcher das Basispolymer formuliert, durch die zwingende Zugabe bestimmter Komponenten, die die Viskosität der Formulierung beeinflussen sollen, ein wichtiger Freiheitsgrad, nämlich die freie Formulierung nach seinen Wünschen zu modifizieren, genommen wird.

Aufgabe der vorliegenden Erfindung war es somit, Zusammensetzungen enthaltend alkoxysilyl-modifizierte Polymere herzustellen, welche auch ohne Zuhilfenahme von weiteren Stoffen, wie beispielsweise Weichmachern oder Reaktivverdünnern, niedrigere Viskositäten aufweisen, als vergleichbare bekannte Zusammensetzungen mit alkoxysilyl-modifizierten Polymeren. Weitere Aufgabe der vorliegenden Erfindung war es, ein einfaches Verfahren zur Herstellung solcher Zusammensetzungen bereitzustellen, sowie die Bereitstellung von härtbaren Zusammensetzungen basierend auf derartigen Basispolymeren.

Diese Aufgabe wurde gelöst durch Zusammensetzungen mit intrinsisch reduzierter Viskosität enthaltend bestimmte Mischungen aus alkoxysilyl-modifizierten Polymeren.

Unter Zusammensetzungen mit intrinsisch reduzierter Viskosität werden im Rahmen dieser Patentanmeldung solche Zusammensetzungen enthaltend alkoxysilylmodifizierten Polymere verstanden, welche eine reduzierte Viskosität gegenüber vergleichbaren, im Stand der Technik bekannten alkoxysilyl-modifizierten Polymeren aufweisen und deren reduzierte Viskosität nicht auf dem Zusatz einer oder mehrerer Hilfskomponenten zu den Polymer-Zusammensetzungen (nach deren Herstellung) beruht, sondern deren reduzierte Viskosität intrinsisch also "von innen heraus" hervorgerufen wird. Unter den Ausdruck reduzierte Viskosität, fallen im Rahmen dieser Patentanmeldung, alle Viskositäten, die um mindestens 5 % verringert, bevorzugt um mindestens 10 % verringert sind, bezogen auf die Viskosität einer Zusammensetzung enthaltend alkoxysilyl-modifizierten Polymers mit intrinsisch reduzierter Viskosität gegenüber vergleichbaren, Zusammensetzungen enthaltend alkoxysilyl-modifizierten Polymeren, bei gleichen Messbedingungen. Erfindungsgemäße Zusammensetzungen mit intrinsisch reduzierter Viskosität werden bevorzugt nach dem im Rahmen dieser Erfindung beschriebenen Verfahren erhalten.

Überraschenderweise wurde gefunden, dass Zusammensetzungen enthaltend alkoxysilyl-modifizierte Polymere mit intrinsisch reduzierter Viskosität erhalten werden können, wenn während des Herstellprozesses der alkoxysilyl-modifizierten Polymere aus einem OH-funktionellen Starter (1) im Alkoxylierungsschritt mit der Alkylenoxid-Addition anteilig ein weiterer OH-funktioneller Starter (2) zugesetzt wird. Die Viskosität der erfindungsgemäßen Produkte ist deutlich reduziert im Vergleich zu analogen Polymeren, welche ohne Zusatz OH-funktioneller Starter (2) hergestellt wurden, während sich die anwendungstechnischen Eigenschaften überraschenderweise gar nicht oder nicht wesentlich unterscheiden. Dies hat insbesondere den Vorteil, dass den erfindungsgemäßen Polymeren zum Erhalt einer guten Fließfähigkeit keine weiteren viskositätsreduzierenden Hilfskomponenten zugeführt werden müssen, was Kosten reduziert, die Handhabung des Polymers deutlich vereinfacht und zudem eine freiere Formulierbarkeit der erfindungsgemäßen Polymere ermöglicht. Darüber hinaus erleichtert die bessere Fließfähigkeit das Herstellungsverfahren in besonders hohem Maße, da auch hier ohne die Notwendigkeit von viskositätsreduzierenden Hilfskomponenten Kosten gesenkt und ein Zugabeschritt von viskositätsreduzierenden Hilfskomponenten eingespart werden kann.

Gegenstand der vorliegenden Erfindung ist deshalb ein Verfahren zur Herstellung von Alkyoxylierungsprodukten mit intrinsisch reduzierter Viskosität wie nachfolgend beschrieben, mit den Maßgaben von Anspruch 9.

Ein weiterer Gegenstand der vorliegenden Erfindung sind Zusammensetzungen mit intrinsisch reduzierter Viskosität enthaltend Alkyoxylierungsprodukte aus mindestens zwei unterschiedlichen Startern, mit den Maßgaben von Anspruch 1.

Ebenfalls Gegenstand der vorliegenden Erfindung sind Zusammensetzungen mit intrinsisch reduzierter Viskosität enthaltend Alkyoxylierungsprodukte aus mindestens zwei unterschiedlichen Startern und weitere Komponenten sowie deren Verwendung, insbesondere die Verwendung dieser Alkoxylierungsprodukte aus mindestens zwei unterschiedlichen Startern in härtbaren Zusammensetzungen.

Die erfindungsgemäßen Zusammensetzungen, das Verfahren zu deren Herstellung sowie deren Verwendung werden nachfolgend beispielhaft beschrieben, ohne dass die Erfindung auf diese beispielhaften Ausführungsformen beschränkt sein soll. Sind nachfolgend Bereiche, allgemeine Formeln oder Verbindungsklassen angegeben, so sollen diese nicht nur die entsprechenden Bereiche oder Gruppen von Verbindungen umfassen, die explizit erwähnt sind, sondern auch alle Teilbereiche und Teilgruppen von Verbindungen, die durch Herausnahme von einzelnen Werten (Bereichen) oder Verbindungen erhalten werden können. Werden im Rahmen der vorliegenden Beschreibung Dokumente zitiert, so soll deren Inhalt, insbesondere bezüglich der in Bezug genommenen Sachverhalte vollständig zum Offenbarungsgehalt der vorliegenden Erfindung gehören. Werden nachfolgend Angaben in Prozent gemacht, so handelt es sich, wenn nicht anders angegeben um Angaben in Gewichts-%. Werden nachfolgend Mittelwerte angegeben, so handelt es sich, wenn nicht anders angegeben, um das Zahlenmittel. Werden nachfolgend Stoffeigenschaften, wie z. B. Viskositäten oder ähnliches angegeben, so handelt es sich, wenn nicht anders angegeben, um die Stoffeigenschaften gemessen bei 25 °C. Die Viskosität wird bei einer Temperatur von 25 °C mit einer Scherrate von 10 1/s mit einem MCR 301 Rheometer der Firma Anton Paar bestimmt.

Der hydrophile oder hydrophobe Charakter der finalen alkoxysilyl-funktionellen Polymere mit intrinsisch reduzierter Viskosität kann durch Art und Aufbau der OH-Gruppe(n) tragenden Starter (1) und (2) und/oder durch ein oder mehrere Comonomere, die während der Synthese eingebracht werden, eingestellt werden. Die Viskosität des finalen alkoxysilyl-funktionellen Polymers mit intrinsisch reduzierter Viskosität kann durch Art und Menge, wie auch den Zeitpunkt der Zugabe der OH-funktionellen Starter (2) gezielt eingestellt werden.

Nach der EP 2 093 244 konnten erstmals Alkoxysilylgruppen tragende Alkoxylierungsprodukte hergestellt werden, die im Gegensatz zum bis dahin bekannten Stand der Technik Alkoxysilylgruppen entlang der Polyetherkette blockartig oder statistisch verteilt aufweisen und nicht nur an den Termini der Kette lokalisiert sind. Weiterhin zeichnen sich diese Verbindungen durch eine reaktionsbedingt endständige OH-Gruppe aus.

Aus dem Vorhandensein der OH-Gruppe und den hydrolyseempfindlichen Alkoxysilylgruppen in einem Molekül rührt die intrinsische Reaktivität der Verbindungen und leichte Vernetzbarkeit unter Bildung dreidimensionaler polymerer Netzwerke her. Allerdings haben Versuche auch gezeigt, dass die Reaktivität der OH-Gruppe gegebenenfalls zu hoch liegt, um eine für die Anforderungen die an 1-Komponentige Kleb- und Dichtstoffformulierungen ausreichende Lagerstabilität zu erreichen. Unter Lagerstabilität wird in diesem Kontext die Stabilität gegen Vernetzung bzw. Vergelung der fertigen, Katalysator enthaltenden, Formulierung bei Lagerung in einer marktüblichen Dickwandkartusche verstanden. Zu den genannten Verbindungen gehören insbesondere solche der Formel (I).

Im Rahmen der vorliegenden Erfindung umfasst der Begriff Alkoxylierungsprodukte oder Polyether sowohl Polyether, Polyetherole, Polyetheralkohole, Polyetheresterole aber auch Polyethercarbonatole, die gegebenenfalls synonym zueinander verwendet werden. Dabei ist nicht erforderlich, dass der Ausdruck "Poly" damit einhergehen muss, dass es sich um eine Vielzahl von Etherfunktionalitäten oder Alkoholfunktionalitäten im Molekül oder Polymer handelt. Vielmehr wird dadurch nur angedeutet, dass zumindest Wiederholungseinheiten einzelner Monomerbausteine oder aber Zusammensetzungen vorliegen, die eine höhere Molmasse und zudem auch noch eine gewisse Polydispersität aufweisen.

Das Wortfragment "Poly" umfasst im Zusammenhang mit dieser Erfindung nicht nur ausschließlich Verbindungen mit zumindest 3 Wiederholungseinheiten eines oder mehrerer Monomere im Molekül, sondern insbesondere auch solche Zusammensetzungen von Verbindungen, die eine Molekulargewichtsverteilung aufweisen und dabei ein mittleres Molekulargewicht von mindestens 200 g/mol besitzen. Bei dieser Definition ist dem Umstand Rechnung getragen, dass es auf dem betrachteten Gebiet der Technik üblich ist, solche Verbindungen bereits als Polymere zu bezeichnen, auch wenn sie nicht einer Polymerdefinition analog OECD- oder REACH-Richtlinien zu genügen scheinen.

Die verschiedenen Fragmente in den nachfolgenden Formeln (la), (II) und (IIa) können statistisch verteilt sein. Statistische Verteilungen können blockweise aufgebaut sein mit einer beliebigen Anzahl an Blöcken und einer beliebigen Sequenz oder sie können einer randomisierten Verteilung unterliegen, sie können auch alternierend aufgebaut sein oder auch über die Kette einen Gradienten bilden, insbesondere können sie auch alle Mischformen bilden, bei denen gegebenenfalls Gruppen unterschiedlicher Verteilungen aufeinander folgen können. Die Formeln (I), (la), (II) und (IIa), beschreiben Polymere, die eine Molgewichtsverteilung aufweisen. Daher stellen die Indizes das numerische Mittel über alle Monomereinheiten dar.

Die in den Formeln verwendeten Indexzahlen a, b, c, d, e, f, g, h, i, j, k, I, m, n, o, p, q, r, s, t, u, v, w, x und y sowie die Wertbereiche der angegebenen Indizes können als Mittelwerte der möglichen statistischen Verteilung der tatsächlichen vorhandenen Strukturen und/oder deren Mischungen verstanden werden. Dies gilt auch für als solche an sich exakt wiedergegebene Strukturformeln, wie beispielsweise für Formel (Ia), (II) und (IIa)

Überraschenderweise wurde nun gefunden, dass Zusammensetzungen enthaltend Alkyoxylierungsprodukte aus mindestens zwei unterschiedlichen OH-funktionellen Startern eine intrinsisch reduzierte Viskosität aufweisen. Erfindungswesentlich dabei ist es, dass die Zusammensetzung mit intrinsisch reduzierter Viskosität mindestens ein Alkyoxylierungsprodukt aus einem Starter (1) und mindestens ein Alkyoxylierungsprodukt aus einem Starter (2) enthält, wobei Starter (1) und Starter (2) voneinander unterschiedlich sein müssen. Prinzipiell können Starter (1) und Starter (2) beide verschiedene Alkohole, bevorzugt der nachfolgend genannten Alkohole sein. Bei Starter (2) handelt es sich dabei bevorzugt um Alkohole bzw. Polyole wie Methanol, 2,2,4-Trimethyl-1,3-pentandiol monoisobutyrat (Texanol, beispielsweise erhältlich von Exxon), Octanol, Decanol, Dodecanol, Ethanol, Propanol, iso-Propanol, Butanol, iso-Butanol, tert-Butanol, alle isomeren Pentanole, Fettalkohole wie Capronalkohol, Önanthalkohol, Caprylalkohol, Pelargon-, Caprinalkohol, 1-Undecanol, Laurylalkohol, 1-Tridecanol, Isotridecylalkohol, Myristylalkohol, 1-Pentadecanol, Cetylalkohol, Palmoleylalkohol, 1-Heptadecanol, Stearylalkohol, Isostearylalkohol, Oleylalkohol, Elaidylalkohol, Petroselinylalkohol, Linolylalkohol, Linolenylalkohol, 1-Nonadecanol, Elaeostearylalkohol, Arachylalkohol, 1-Heneicosanol, Gadoleylalkohol, Behenylalkohol, Erucylalkohol und Brassidylalkohol sowie deren technische Mischungen, Oxoalkohole, bevorzugt solche, die 2 bis 4 Methylgruppen als Verzweigungen tragen, oder Guerbetalkohole, die in 2-Stellung mit einer Alkylgruppe verzweigt wie 2-Ethylhexanol, 2-Propylheptanol, 2-Butyloctanol, 2-Hexyldecanol und/oder 2-Octyldodecanol, oder aromatische Startverbindungen wie Benzylalkohol und Phenolderivate, Catechole oder Resorcinole besonders bevorzugt Ethylenglykol, Propylenglykol, Di-/Triethylenglykol, 1,2-Propylenglykol, Di-/Tripropylenglykol, Neopentylglykol, 1,4-Butandiol, 1,2-Hexandiol, 1,6-Hexandiol, Trimethylolpropan, Di(trimethylol)ethan, Di(trimethylol)propan, Pentaerythrit, Di(pentaerythritol), Glycerin, Di(glycerin), Polyglycerin, Trimethylolpropan- oder Glycerinmonoether wie z. B. -monoallylether, besonders bevorzugt um Butanol, Ethanol oder Ethylhexanol, insbesondere bevorzugt um Butanol. Bei Starter (1) und Starter (2), insbesondere bei Starter (1) handelt es sich bevorzugt um höhermolekulare Verbindungen, bevorzugt mit Molmassen größer 200 g/mol, besonders bevorzugt größer 300 g/mol und insbesondere bevorzugt größer 400 g/mol, bevorzugt ausgewählt aus Polyethylenoxide, Polypropylenoxide, Polyester, Polycarbonate, Polycarbonatpolyole, Polyesterpolyole, Polyetherester, Polyetherole, Polyethercarbonate, Polyamide, Polyurethane und Zucker-basierte Alkoxylate, die gegebenenfalls eine oder mehrere Alkoxysilylgruppen aufweisen können. Besonders bevorzugt ist Starter (1) ausgewählt aus Polyetherolen, Polycarbonatpolyolen und Polyethercarbonaten.
Polycarbonatpolyole im Sinne dieser Erfindung sind bevorzugt a, ω-Dihydroxyfunktionelle Reaktionsprodukte mit mindestens 3 Carbonateinheiten, bevorzugt 3 bis 20 Carbonateinheiten. Bevorzugte Polycarbonatpolyole sind Reaktionsprodukte von CO₂ mit Diolen oder zyklischen Lactonen, wie beispielsweise Caprolacton, bevorzugt mit einem mittleren Molekulargewicht von 1000 bis 3000 g/mol. Bevorzugte Polycarbonatpolyole sind zum Beispiel auf dem Markt erhältlich unter den Markennamen ETERNACOLL® PH der UBE Chemical Europe S.A., Polyol C-series der Kuraray Europe GmbH, Durez®-ter S der Sumitomo Bakelite Europe oder Desmophen® C der Bayer Material Science GmbH.
Polyethercarbonate im Sinne dieser Erfindung sind bevorzugt Umsetzungprodukte der zuvor definierten Polycarbonatpolyole mit Alkylenoxiden.
Polyetherole sind bevorzugt Reaktionsprodukte aus Alkylenoxiden, bevorzugt handelt es sich bei den Polyetherolen um Polyethylenoxide, Polypropylenoxide. Ganz besonders bevorzugt sind Starter (1) ausgewählt aus Polyetherolen, Polycarbonatpolyolen und Polyethercarbonaten, insbesondere in den zuvor ausgeführten bevorzugten Ausführungsformen, und Starter (2) bevorzugt ausgewählt aus Butanol, Ethanol oder Ethylhexanol.

Hohe Reduktionen der Viskosität werden insbesondere erzielt, wenn Starter (1) eine Molmasse von größer 400 g/mol aufweist und Starter (2) eine Molmasse von kleiner gleich 400 g/mol aufweist. Überraschenderweise hat sich gezeigt, dass weiterhin eine besonders gute Reduktion der Viskosität erzielt werden kann, wenn die Molmasse von Starter (1) die Molmasse von Starter (2) um mindestens 200 g/mol, bevorzugt um mindestens 600 g/mol besonders bevorzugt um mindestens 1000 g/mol, übersteigt. Besonders bevorzugt ist die Molmasse von Starter (1) mindestens doppelt so groß wie die Molmasse von Starter (2).

Im Sinne dieser Erfindung werden Alkoxylierungsprodukte (1) durch die Umsetzung von Starter (1) bevorzugt mit Alkylenoxiden und Alkoxylierungsprodukte (2) durch die Umsetzung von Starter (2) bevorzugt mit Alkylenoxiden erhalten. Es handelt sich bei den Zusammensetzungen mit intrinsisch reduzierter Viskosität enthaltend Alkyoxylierungsprodukte um solche, in denen die Alkoxylierungsprodukte (1) aus Starter (1) aufgebaut sind aus Alkylenoxid, bevorzugt mindestens Ethylenoxid und/oder Propylenoxid, mindestens einem Alkoxysilylgruppen tragenden Epoxid und gegebenenfalls weiteren Monomeren und die Alkoxylierungsprodukte (2) aus Starter (2) aufgebaut sind aus Alkylenoxid, bevorzugt mindestens Ethylenoxid und/oder Propylenoxid und gegebenenfalls mindestens einem Alkoxysilylgruppen tragenden Epoxid und/oder weiteren Monomeren. Bevorzugt sind die Alkoxylierungsprodukte (2) aus Starter (2) aufgebaut aus Alkylenoxid und mindestens einem Alkoxysilylgruppen tragenden Epoxid.

Bevorzugte Alkoxylierungsprodukte (1) sind aufgebaut aus folgenden Monomerenanteilen 10 bis 97 Gew.-%, bevorzugt 20 bis 95 Gew.-%, insbesondere bevorzugt 30 bis 90 Gew.-% Propylenoxid, 0 bis 60 Gew.-%, bevorzugt 3 bis 40 Gew.-%, insbesondere bevorzugt 5 bis 30 Gew.-% Ethylenoxid, 0 bis 25 Gew.-%, bevorzugt 0,5 bis 15 Gew.-%, insbesondere bevorzugt 1 bis 10 Gew.-% Alkoxysilylgruppen tragendes Epoxid und 0 bis 25 Gew.-%, bevorzugt 0,1 bis 20 Gew.-%, insbesondere bevorzugt 0 bis 10 Gew.-% weitere Monomere, bevorzugt ausgewählt aus von Propylenoxid und Ethylenoxid verschiedenen Alkylenoxiden, wie Butylenoxid, Isobutylenoxid, Styroloxid und/oder weiteren Comonomeren wie ε-Caprolacton, Phthalsäureanhydrid, Glycidylethern wie tert-Butylphenylglycidylether, C₁₂/C₁₄-Fettalkoholglycidylether und 2-Ethylhexylglycidylether alle Gew.-% bezogen auf das Gesamtgewicht der Alkoxylierungsprodukte (1).
Bevorzugte Alkoxylierungsprodukte (2) sind aufgebaut aus folgenden 10 bis 97 Gew.-%, bevorzugt 20 bis 95 Gew.-%, insbesondere bevorzugt 30 bis 90 Gew.-% Propylenoxid, 0 bis 60 Gew.-%, bevorzugt 3 bis 40 Gew.-%, insbesondere bevorzugt 5 bis 30 Gew.-% Ethylenoxid, 0 bis 25 Gew.-%, bevorzugt 0,5 bis 15 Gew.-%, insbesondere bevorzugt 1 bis 10 Gew.-% Alkoxysilylgruppen tragendes Epoxid und 0 bis 25 Gew.-%, bevorzugt 0,1 bis 20 Gew.-%, insbesondere bevorzugt 0 bis 10 Gew.-% weitere Monomere, bevorzugt ausgewählt aus von Propylenoxid und Ethylenoxid verschiedenen Alkylenoxiden, wie Butylenoxid, Isobutylenoxid, Styroloxid und/oder weiteren Comonomeren wie ε-Caprolacton, Phthalsäureanhydrid, Glycidylethern wie tert-Butylphenylglycidylether, C₁₂/C₁₄-Fettalkoholglycidylether und 2-Ethylhexylglycidylether alle Gew.-% bezogen auf das Gesamtgewicht der Alkoxylierungsprodukte (2).

Es wurde zudem gefunden, dass neben der Variation der Molmassen der Starter (1) und (2) auch die OH-Funktionalität der Starter genutzt werden kann, um die intrinsisch reduzierte Viskosität der erfindungsgemäßen Zusammensetzungen zu steuern. So ist es besonders vorteilhaft für die Reduktion der Viskosität der Zusammensetzungen, wenn der Starter (1) eine höhere OH-Funktionalität, also mehr OH-Gruppen, aufweist als der Starter (2). In einer besonders bevorzugten Ausführungsform weist der Starter (1) t OH-Gruppen auf und Starter (2) t - 1 OH-Gruppen auf, mit t = 2 bis 8, bevorzugt 2 bis 5, besonders bevorzugt 2, 3 oder 4 und insbesondere 2.

Die erfindungsgemäßen Zusammensetzungen mit intrinsisch reduzierter Viskosität enthalten bevorzugt Alkoxylierungsprodukte (1) aus Starter (1), die die Strukturelemente der Formel (I) enthalten

Mᵢ Dⱼ Tₖ Qₗ URᵤ APᵥ Formel (I)

zeichnen sich dadurch aus, dass die Fragmente M, D, T, Q nicht untereinander, sondern über die Gruppen UR und/oder AP miteinander verknüpft sind, und die Gruppen UR und AP nicht untereinander verknüpft sind, sondern dementsprechend über die Fragmente M, D, T oder Q miteinander verknüpft sind. Für die Indices gilt:
i = 0 bis 16, bevorzugt 1 bis 12, besonders bevorzugt 2 bis 6
j = 0 bis 10, bevorzugt 1 bis 8, besonders bevorzugt 2 bis 6, insbesondere bevorzugt größer, gleich 1
k = 0 bis 6, bevorzugt größer 0 bis 4, insbesondere 0,5 bis 2,
I = 0 bis 4, bevorzugt größer 0 bis 3, insbesondere 0,5 bis 2,
u = 0 bis 17, bevorzugt 1 bis 15, mehr bevorzugt 2 bis 10, insbesondere 2 bis 8,
v = 0 bis 6, bevorzugt größer 0 bis 4, insbesondere 0,1 bis 2.
mit der Maßgabe, dass i + j + k + I > = 1 ist,
wobei für M die folgenden Alternativen gelten:
   M ist unabhängig voneinander ein Sauerstoffradikal tragender Kohlenwasserstoffrest mit einer minimalen numerischen Molmasse von 32 g/mol, und für den Fall, dass Starter (1) nur eine OH-Funktionalität aufweist (t = 1 OH-Gruppe) mit einer minimalen numerischen Molmasse von mindestens 400 g/mol, welcher gegebenenfalls durch Heteroatome unterbrochen sein kann, bevorzugt gesättigte oder ungesättigte, lineare oder verzweigte organische Kohlenwasserstoffreste, die als Heteroatome O, N und / oder S enthalten, besonders bevorzugt ein Polyether, bevorzugt mit 8 bis 400 Kohlenstoffatomen,
   oder M ist ein Rest der Formel (la) oder der Formel (Ib) oder der Formel (Ic), wobei Formel (la) 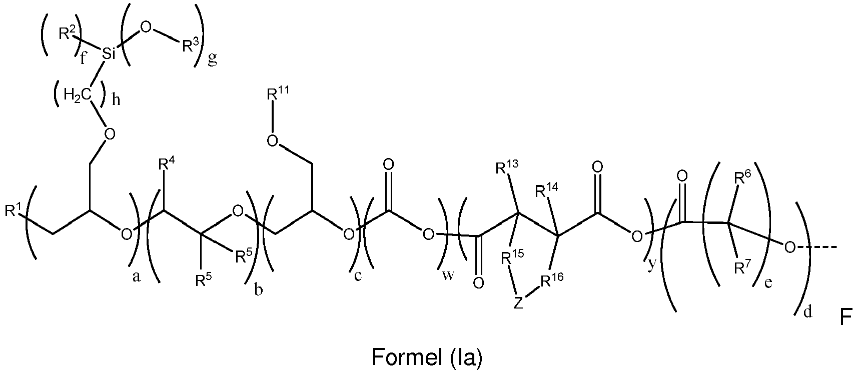
   wobei
   a = 0 bis 100, bevorzugt 1 bis 50, weiter bevorzugt größer 1 bis 10, insbesondere bevorzugt 1 bis 5, bevorzugt 1, 2 oder 3
   b = 0 bis 1000, bevorzugt 1 bis 500, weiter bevorzugt größer 1 bis 400, insbesondere bevorzugt 10 bis 300
   c = 0 bis 200, bevorzugt 1 bis 100, weiter bevorzugt größer 1 bis 80, insbesondere bevorzugt 0 bis 50
   d = 0 bis 200, bevorzugt 1 bis 100, weiter bevorzugt größer 1 bis 80, insbesondere bevorzugt 0 bis 50
   w = 0 bis 200, bevorzugt 1 bis 100, weiter bevorzugt größer 1 bis 80, insbesondere bevorzugt 0 bis 50
   y = 0 bis 500, bevorzugt 1 bis 300, besonders bevorzugt 2 bis 200 und insbesondere bevorzugt 0 bis 100 ist,
   e = 1 bis 10,
   f = 0 bis 2
   g = 1 bis 3
   mit der Maßgabe, dass g + f = 3
   h = 0 bis 10, bevorzugt 1 bis 6, insbesondere bevorzugt 1, 2 oder 3
   mit der Maßgabe, dass die Gruppen mit den Indices a, b, c, d, w und y frei permutierbar über die Molekülkette sind, wobei die Gruppen mit den Indices w und y jeweils nicht auf sich selbst oder auf die jeweils andere Gruppe folgen dürfen und
   mit der Maßgabe, dass die verschiedenen Monomereinheiten sowohl der Fragmente mit den Indices a, b, c, d, w und y als auch der gegebenenfalls vorhandenen Polyoxyalkylenkette des Substituenten R¹ untereinander blockweise aufgebaut sein können, wobei einzelne Blöcke auch mehrfach vorkommen können und untereinander statistisch verteilt sein können, oder aber einer statistischen Verteilung unterliegen und zudem untereinander frei permutierbar, im Sinne von in beliebiger Reihenfolge anzuordnen sind, mit der Einschränkung, dass die Gruppen mit den Indices w und y jeweils nicht auf sich selbst oder auf die jeweils andere Gruppe folgen dürfen,
   und wobei
   - R¹ =: unabhängig voneinander ein gesättigter oder ungesättigter, linearer oder verzweigter organischer Kohlenwasserstoffrest ist, der als Heteroatome O, S und / oder N enthalten kann, bevorzugt enthält der Kohlenwasserstoffrest 1 bis 400 Kohlenstoffatome, bevorzugt 2, 3 oder 4 bis 200 Kohlenstoffatome,
   - R² =: unabhängig voneinander eine Alkylgruppe mit 1 bis 8 Kohlenstoffatomen, insbesondere Methyl- oder Ethyl-, Propyl-, Isopropyl-,
   - R³ =: unabhängig voneinander eine Alkylgruppe mit 1 bis 8 Kohlenstoffatomen, insbesondere Methyl-, Ethyl-, Propyl-, Isopropyl-,
   - R⁴ =: unabhängig voneinander ein Wasserstoffradikal, eine Alkylgruppe mit 1 bis 20 Kohlenstoffatomen, eine Aryl- oder Alkarylgruppe, bevorzugt Wasserstoff, Methyl-, Ethyl-, Octyl-, Decyl-, Dodecyl-, Phenyl-, Benzyl-, besonders bevorzugt Wasserstoff, Methyl- oder Ethyl-,
   - R⁵ =: unabhängig voneinander ein Wasserstoffradikal oder eine Alkylgruppe mit 1 bis 8 Kohlenstoffatomen, bevorzugt Wasserstoff, Methyl- oder Ethyl-, insbesondere bevorzugt Wasserstoff, oder R⁴ und einer der Reste R⁵ können gemeinsam einen Ring bilden, der die Atome, an die R⁴ und R⁵ gebunden sind, einschließt, bevorzugt enthält dieser Ring 5 bis 8 Kohlenstoffatome,
   - R⁶ und R⁷ =: unabhängig voneinander ein Wasserstoffradikal, eine Alkylgruppe mit 1 bis 20 Kohlenstoffatomen, eine Aryl- oder Alkarylgruppe und/oder eine Alkoxygruppe, bevorzugt eine Methylgruppe,
   - R¹¹ =: unabhängig voneinander ein gesättigter oder ungesättigter, aliphatischer oder aromatischer Kohlenwasserstoffrest mit 2 bis 30 C-Atomen, insbesondere bis 24 C-Atomen, der gegebenenfalls substituiert ist, bevorzugt handelt es sich um eine Alkylgruppe mit 1 bis 16 Kohlenstoffatomen, besonders bevorzugt mit 6 bis 12 Kohlenstoffatomen, deren Kette durch Sauerstoff unterbrochen sein kann und weiter funktionelle Gruppen tragen kann wie z.B. Carboxylgruppen gegebenenfalls mit Alkoholen wie z.B. Methanol, Ethanol, Propanol, Butanol oder Hexanol verestert, Hydroxygruppen gegebenenfalls mit Säuren wie Essigsäure, Buttersäure, Neodecansäure oder (Meth)Acrylsäure bzw. den Polymerisaten der (Meth)Acrylsäure verestert, oder eine Arylgruppe mit 6 bis 20 Kohlenstoffatomen, oder eine Alkarylgruppe mit 7 bis 30, bevorzugt 7 bis 20 Kohlenstoffatomen,bevorzugt ausgewählt aus Methyl-, Ethyl-, Propyl-, Butyl-, iso-Butyl-, tert-Butyl-, 2-Pentyl-, 3-Pentyl-, 2-Methylbutyl-, 3-Methylbutyl-, 2-Methyl-2-butyl-, 3-Methyl-2-butyl-, 2,2-Dimethylpropyl-, Hexyl-, Heptyl-, Octyl-, 2-Ethylhexyl-, 2-Propylheptyl-, 2-Butyloctanyl-, 2-Methylundecyl-, 2-Propylnonyl-, 2-Ethyldecyl-, 2-Pentylheptyl-, 2-Hexyldecyl-, 2-Butyltetradecyl-, 2-Dodecylhexadecyl-, 2-Tetradecyloctadecyl-, 3,5,5-Trimethylhexyl-, Isononanyl-, Isotridecyl-, Isomyristyl-, Isostearyl-, 2-Octyldodecyl- Triphenylmethyl-, C(O)-(CH₂)₅-C-(CH₃)₃- (Rest der Neodecansäure), C₁₂/C₁₄-Alkyl-, Phenyl-, Kresyl-, tert-Butylphenyl- oder Benzylgruppe, besonders bevorzugt eine 2-Ethylhexyl-, C(O)-(CH₂)₅-C-(CH₃)₃-(Rest der Neodecansäure), C₁₂/C₁₄-Alkyl-, Phenyl-, Kresyl-, tert-Butylphenylgruppe, ganz besonders bevorzugt eine tert-Butylphenyl- oder 2-Ethylhexylgruppe,
   - R¹³, R¹⁴ =: unabhängig voneinander Wasserstoff und/oder ein organischer Rest, bevorzugt Alkyl-, Alkenyl-, Alkyliden, Alkoxy-, Aryl- und/oder Aralkylgruppen, oder gegebenenfalls können R¹³ und/oder R¹⁴ auch nicht vorhanden sein, wobei wenn R¹³ und R¹⁴ nicht vorhanden sind, statt der Reste R¹³ und R¹⁴ eine C=C Doppelbindung vorhanden ist, das überbrückende Fragment Z kann vorhanden oder nicht vorhanden sein, ist das überbrückende Fragment Z nicht vorhanden so sind,
   - R¹⁵ und R¹⁶ =: unabhängig voneinander Wasserstoff und/oder ein organischer Rest, bevorzugt Alkyl-, Alkenyl-, Alkyliden, Alkoxy-, Aryl- und/oder Aralkylgruppen, wobei für den Fall, dass einer der Reste R¹³ oder R¹⁴ nicht vorhanden ist, der jeweilige geminale Rest (also R¹⁵ wenn R¹³ nicht vorhanden ist und R¹⁶ wenn R¹⁴ nicht vorhanden ist) ein Alkylidenrest, bevorzugt Methyliden (=CH2), ist, ist das überbrückende Fragment Z vorhanden, so sind
   - R¹⁵ und R¹⁶ =: Kohlenwasserstoffreste , die cycloaliphatisch oder aromatisch über das Fragment Z verbrückt sind, wobei Z einen divalenten Alkylen- oder Alkenylenrest darstellt, der weiter substituiert sein kann, das Fragment mit dem Index y kann beispielsweise durch den Einbau cyclischer Anhydride erhalten werden, bevorzugte cyclische Anhydride sind Succinanhydrid, Maleinsäureanhydrid, Itaconanhydrid, Glutaranhydrid, Adipinanhydrid, Citraconanhydrid, Phthalsäureanhydrid, Hexahydrophthalsäureanhydrid und Trimellitanhydrid sowie polyfunktionelle Säureanhydride wie Pyromellit-Dianhydrid, Benzophenon-3,3',4,4'-tetracarbonsäure-Dianhydrid, 1,2,3,4-Butantetracarbonsäuredianhydrid oder radikalisch polymerisierte Homo- oder Copolymerisate von Maleinsäureanhydrid mit Ethylen, Isobutylene, Acrylnitril, Vinylacetat oder Styrol, besonders bevorzugte Anhydride sind Succinanhydrid, Maleinsäureanhydrid, Itaconanhydrid, Glutaranhydrid, Adipinanhydrid, Citraconanhydrid, Phthalsäureanhydrid, Hexahydrophthalsäureanhydrid,
wobei Formel (Ib) 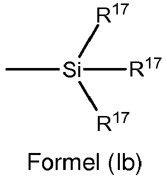 mit
- R¹⁷ =: unabhängig voneinander eine lineare oder verzweigte, gesättigte oder ungesättigte, gegebenenfalls weiter substituierte Alkylgruppe mit 1 bis 30 Kohlenstoffatomen, eine Aryl- oder Alkarylgruppe, bevorzugt Methyl-, Ethyl-, Octyl-, Decyl-, Dodecyl-, Phenyl-, Benzyl-, besonders bevorzugt Methyl- oder Ethyl- ist,
wobei Formel (Ic): 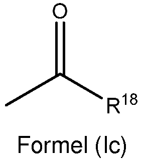 mit
- R¹⁸: unabhängig voneinander eine zweibindige lineare oder cyclische, gesättigte oder ungesättigte Alkylgruppe, die substituiert sein kann, bevorzugt eine Methyl-, Ethyl-, Propyl- oder Isopropylgruppe, oder
eine Arylgruppe, bevorzugt eine Phenylgruppe oder
eine mindestens zweifach substituierte Arylgruppe, die bevorzugt mindestens eine weitere Carbonsäurefunktion tragen kann, bevorzugt Acetatrest, Propionatrest, Phthalsäurerest, Itaconsäurerest, Hexahydrophthalsäurerest oder Maleinsäurerest, ist
und wobei für die Fragmente D, T und Q gilt:
D ist ein Polyetherrest -(D^{A})ₜ-D^{X} mit t gleich 2,
T ist ein Polyetherrest -(D^{A})ₜ-D^{X} mit t gleich 3 und
Q ist ein Polyetherrest -(D^{A})ₜ-D^{X} mit t gleich 4,
mit
- D^{X}: ein t-valenter funktioneller, gesättigter oder ungesättigter, linearer oder verzweigter organischer Kohlenwasserstoffrest ist, der als Heteroatome O, S, Si und / oder N enthalten kann, wobei jeder der Reste D^{A} kovalent an den Rest D^{X}gebunden ist,
bevorzugt enthält der Kohlenwasserstoffrest 8 bis 1500 Kohlenstoffatome, bevorzugt ist die Kohlenstoffkette des Kohlenwasserstoffrestes durch Sauerstoffatome unterbrochen, bevorzugt enthält der Kohlenwasserstoffrest Siliziumatom-haltige Substituenten,
bevorzugt sind die Siliziumatom-haltigen Substituenten Alkoxysilylgruppen, bevorzugt ist der von Sauerstoffatomen unterbrochene Kohlenwasserstoffrest ein Polyoxyalkylenrest, Polyetherrest und/oder Polyetheralkoxyrest, oder
- D^{X}: kann eine einfach oder mehrfach annelierte phenolische Gruppe sein,
oder besonders bevorzugt kann D^{X} ein t-valenter Rest von einem t-fach hydroxyliertem Alkohol, Polyetherol, Polyesterol, Siloxan, perfluorierten Polyetherol, (poly)-Urethan oder Saccharid, bevorzugt OH-funktionelle Polyether, Polyester, Polycarbonate, Polyetherester oder perfluorierten Polyether und Mischpolymere daraus, insbesondere bevorzugt OH-funktionelle Polyether oder Polyester, sein,
und wobei D^{A} ein Fragment der Formel (II) 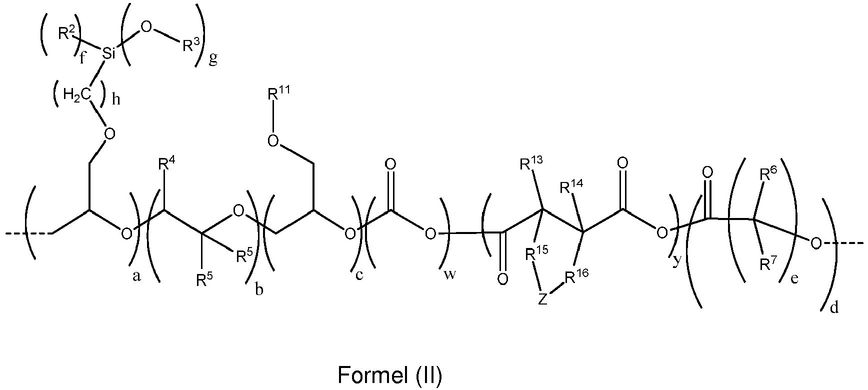
ist, mit a bis h, w und y und R² bis R¹⁶ unabhängig voneinander definiert wie in Formal (la),
mit der Maßgabe, dass die Summe aller Indizes b der Formeln (Ia) und (II) mindestens 1, bevorzugt mindestens 2, insbesondere bevorzugt mindestens 3 ergibt und die Summe aller Indizes a der Formeln (la) und (II) gleich oder größer 1 sein muss.

In einer besonders bevorzugten Ausführungsform können die Polyetherreste D mit einer dihydroxysubstituierten Verbindung gestartete Polyether sein, die Polyetherreste T können ein mit einer trihydroxysubstituierten Verbindung gestartete Polyether sein, die Polyetherreste Q können mit einer tetrahydroxy substituierten Verbindung gestartete Polyether sein und/oder das Fragment M kann ein mit einer monohydroxy substituierten Verbindung gestarteter Polyether sein.
- UR: sind unabhängig voneinander gleiche oder verschiedene divalente Reste der Form -U-D^{C}-U-,
oder ein monovalenter Rest der der Form D^{D}-U-,
oder ein trivalenter Rest der Form D^{E}U₃,
oder ein tetravalenter Rest der Form D^{F}U₄,
wobei U eine -C(O)-NH-Gruppe ist, die über den Stickstoff an D^{C}, D^{E}, D^{F} bzw. D^{D} gebunden ist, und
- D^{C}: unabhängig voneinander ein divalenter substituierter oder unsubstituierter, linearer oder verzweigter, gesättigter oder ungesättigter Kohlenwasserstoffrest mit 1 bis 30 Kohlenstoffatomen, ausgewählt aus Alkyl-, Alkenyl-, Aryl- oder Alkarylresten, welcher gegebenenfalls durch Heteroatome wie O, N und / oder S unterbrochen sein kann, eine Aryl-oder Alkarylgruppe ist, bevorzugt ist D^{C} ein divalenter Kohlenwasserstoffrest mit 6 - 30 Kohlenstoffatomen, insbesondere bevorzugt ist D^{C} gleich ein Isophoronrest,
- D^{E}: unabhängig voneinander ein trivalenter substituierter oder unsubstituierter, linearer oder verzweigter, gesättigter oder ungesättigter Kohlenwasserstoffrest mit 1 bis 30 Kohlenstoffatomen, ausgewählt aus Alkyl-, Alkenyl-, Aryl- oder Alkarylresten, welcher gegebenenfalls durch Heteroatome wie O, N und / oder S unterbrochen sein kann, welche gegebenenfalls weitere funktionelle Gruppen tragen kann, wie z.B. Allophanat- oder Biuret-Gruppen und
- D^{F}: unabhängig voneinander ein tetravalenter substituierter oder unsubstituierter, linearer oder verzweigter, gesättigter oder ungesättigter Kohlenwasserstoffrest mit 1 bis 30 Kohlenstoffatomen, ausgewählt aus Alkyl-, Alkenyl-, Aryl- oder Alkarylresten, welcher gegebenenfalls durch Heteroatome wie O, N und / oder S unterbrochen sein kann, welche gegebenenfalls weitere funktionelle Gruppen tragen kann, wie z.B. Allophanat- oder Biuret-Gruppen und
- D^{D}: unabhängig voneinander ein monovalenter linearer oder verzweigter, gesättigter oder ungesättigter Kohlenwasserstoffrest mit 1 bis 30 Kohlenstoffatomen, ausgewählt aus Alkyl-, Alkenyl-, Aryl- oder Alkarylresten, welcher gegebenenfalls durch Heteroatome wie O, N und / oder S unterbrochen und zudem weiter substituiert sein kann, z.B. mit Alkyl-trialkoxysilan- oder Alkyl-alkyldialkoxysilan-Gruppen, wobei der Kohlenwasserstoffrest vorzugsweise von 1 bis 30, bevorzugt von 2 bis 18 und besonders bevorzugt von 3 bis 10 Kohlenstoffatome aufweist, und insbesondere ein Methyl-, Ethyl-, Propyl, oder Butyl-Rest, 3-Isocyanatopropyltrimethoxysilan, 3-Isocyanatopropyltriethoxysilan, bevorzugt ist D^{D} ein monovalenter Kohlenwasserstoffrest mit 4 - 20 Kohlenstoffatomen, besonders bevorzugt Methyl-, Ethyl-, Propyl-, Isopropyl-, Butyl-, iso-Butyl-, Octyl-, Decyl-, Dodecyl-, Phenyl-, Toluyl-, Benzyl-, Isopropylphenyl- oder Stearylgruppe, besonders bevorzugt Methyl-, Ethyl-, Propyl-, Isopropyl-, Butyl-, Phenyl-, Toluyl-, Isopropylphenyl- oder Stearylgruppe, ganz besonders bevorzugt ist D^{D} ein Butylrest
- AP: sind unabhängig voneinander gleiche oder verschiedene Reste der allgemeinen Formel (IIIa), (IIIb) oder (IIIc)

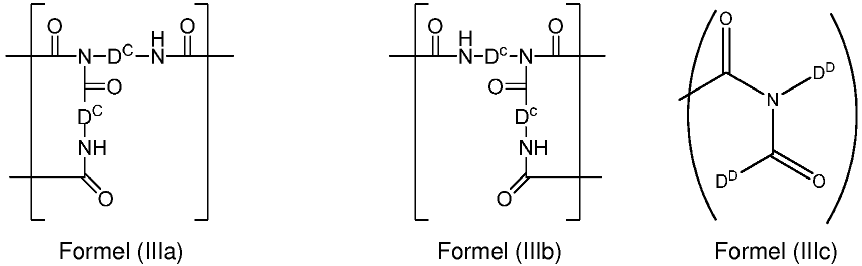

Das Fragment UR kann als Urethaneinheit bezeichnet werden. Das Fragment AP kann als Allophanateinheit bezeichnet werden.
Für den Fall, dass Polyisocyanate mit den Struktureinheiten D^{E} und/oder D^{F} eingesetzt werden, dann ergeben sich beliebig komplexe Strukturen analog Formel (IIIa) und/oder (IIIb), so dass auf eine bildliche Darstellung bewusst verzichtet wurde. Vielmehr kann sich der Fachmann anschaulich vorstellen, dass die drei Urethaneinheiten die an D^{E} bzw. die vier Urethaneinheiten die an D^{F} gebunden sind, alle oder teilweise zu Allophanat-Struktureinheiten weiter umgesetzt wurden, wie im oberen Teil der Formeln (IIIa) und (IIIb) dargestellt.

Der Rest R¹¹ kann weitere funktionelle Gruppen tragen wie z.B. (Meth)Acrylsäure bzw. Polymerisate der (Meth)Acrylsäure. Es können also gegebenenfalls vorhandene Hydroxygruppen mit Acrylsäure oder/und Methacrylsäure verestert sein. Die Doppelbindungen der (Meth)Acrylsäure sind polymerisierbar, z.B. radikalisch z.B. UV induziert.

Die Polymerisation der (Meth)Acrylgruppen kann nach der Herstellung des Polyethers geschehen. Sie kann auch mit den erfindungsgemäßen Alkoxylierungsprodukten, mit den Produkten des erfindungsgemäßen Verfahrens, wie auch nach der erfindungsgemäßen Verwendung durchgeführt werden.

Die erfindungsgemäßen Zusammensetzungen mit intrinsisch reduzierter Viskosität enthalten bevorzugt Alkoxylierungsprodukte (2), die die Strukturelemente der Formel (IIa) enthalten, wobei R²⁷ aus dem Starter (2) resultiert 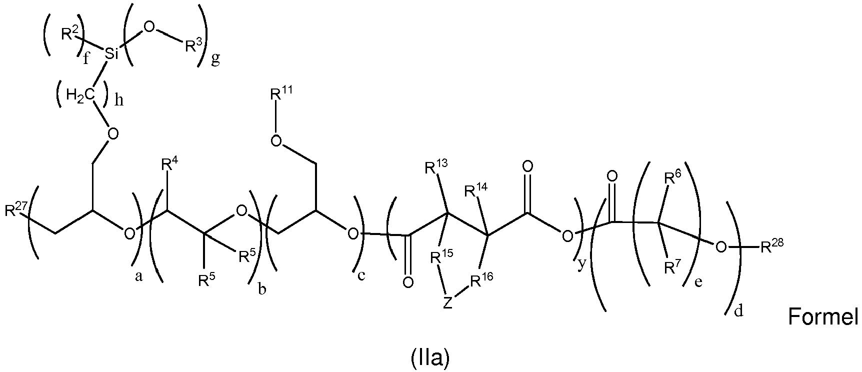 wobei
a = 0 bis 100, bevorzugt 1 bis 50, weiter bevorzugt größer 1 bis 10, insbesondere bevorzugt 1 bis 5
b = 0 bis 200, bevorzugt 1 bis 100, weiter bevorzugt größer 2 bis 50, insbesondere bevorzugt 3 bis 30
c = 0 bis 100, bevorzugt 1 bis 10, weiter bevorzugt größer 1 bis 8, insbesondere bevorzugt 0 bis 5
d = 0 bis 100, bevorzugt 1 bis 10, weiter bevorzugt größer 1 bis 8, insbesondere bevorzugt 0 bis 5
w = 0 bis 100, bevorzugt 1 bis 20, besonders bevorzugt größer 1 bis 10 und insbesondere 0 bis 7 ist,
y = 0 bis 50, bevorzugt 1 bis 30, besonders bevorzugt 2 bis 20 und insbesondere bevorzugt 0 bis 10 ist,
e = 1 bis 10,
f = 0 bis 2
g = 1 bis 3
mit der Maßgabe, dass g + f = 3
h = 0 bis 10, bevorzugt 1 bis 6, insbesondere bevorzugt 1, 2 oder 3
mit der Maßgabe, dass die Gruppen mit den Indices a, b, c, d und y frei permutierbar über die Molekülkette sind, wobei die Gruppe mit dem Index y jeweils nicht auf sich selbst folgen darf,
mit der Maßgabe, dass die Summe aller Indizes b der Formel (IIa) mindestens 1, bevorzugt mindestens 2, insbesondere bevorzugt mindestens 3 ergibt und die Summe aller Indizes a der Formel (IIa) gleich oder größer 1 sein muss.
und mit der Maßgabe, dass die verschiedenen Monomereinheiten sowohl der Fragmente mit den Indices a, b, c, d und y untereinander blockweise aufgebaut sein können, wobei einzelne Blöcke auch mehrfach vorkommen können und untereinander statistisch verteilt sein können, oder aber einer statistischen Verteilung unterliegen und zudem untereinander frei permutierbar, im Sinne von in beliebiger Reihenfolge anzuordnen sind, mit der Einschränkung, dass die Gruppe mit dem Index y jeweils nicht auf sich selbst folgen darf,
und wobei
   - R²⁷ =: unabhängig voneinander ein gesättigter oder ungesättigter, linearer oder verzweigter organischer Kohlenwasserstoffrest ist, der als Heteroatome O, S und / oder N enthalten kann, bevorzugt enthält der Kohlenwasserstoffrest 1 bis 50 Kohlenstoffatome, bevorzugt 2, 3 oder 4 bis 30 Kohlenstoffatome, bevorzugt resultieren die Reste R²⁷ aus monovalenten Alkoholen wie Methanol, Ethanol, Propanol, Isopropanol, Butanol, iso-Butanol, tert-Butanol, 2,2,4-Trimethyl-1,3-pentandiol monoisobutyrat (Texanol von Exxon), Octanol, 2-Ethylhexanol, 2-Propylheptanol, Decanol, Dodecanol, C₁₂/C₁₄-Fettalkohol, Phenol, alle Konstitutionsisomere des Kresols, Benzylalkohol, Stearylalkohol, besonders bevorzugt um Butanol, 2,2,4-Trimethyl-1,3-pentandiol monoisobutyrat (Texanol von Exxon), 2-Ethylhexanol, Allylalkohol, 1-Hexenol oder 2-Propylheptanol, insbesondere Butanol oder Allylalkohol,
   - R²⁸ =: unabhängig voneinander Wasserstoff oder ein über UR oder AP gebundenes Fragment der Formeln (II) oder (IIa) ist.
   - D^{X}: ist ein t-valenter funktioneller, organischer Kohlenwasserstoffrest. Die Funktionalität zeichnet sich dadurch aus, dass sie in der Lage ist, eine Polymerisation von Alkylenoxiden, von cyclischen Säureanhydriden und/oder von Säurelactonen unter Ringöffnung einzuleiten. Sie stellt in diesem Sinne eine Startverbindung für die Alkoxylierung zu den erfindungsgemäßen Produkten dar und charakterisiert darüber hinaus sowohl die OH-funktionellen Startverbindungen (1) wie auch die OH-funktionellen Startverbindungen (2).. Die Polymerisation kann gegebenenfalls katalytisch erfolgen. Als Katalysatoren können Säuren, Basen und Metallatom-haltige Komplexe dienen. Bevorzugt werden sogenannte DMC-Katalysatoren eingesetzt. Dabei gelten die dem Fachmann bekannten gängigen Additionsregeln, beispielsweise dass der Starter bevorzugt an der niedriger substituierten Seite der Alkylenoxide oder an dem Carbonyl-Kohlenstoff der Lactone reagiert. Dies entspricht im Fall der Formel (II) der linken Seite des jeweiligen Fragments der Formel.

Die OH-Funktionen der Alkoxylierungsprodukte (1) und (2) können, sofern angestrebt, mit Isocyanat-Funktionen zu Urethanen reagieren. Bei dieser Reaktion treten in der Regel eine Reihe von Nebenreaktionen (z.B. Addition einer IsocyanatGruppe an eine Urethan-Einheit zur Allophanat-Gruppe) ein, deren Ausmaß durch die Wahl der Reaktionsbedingungen gesteuert werden kann.

Bevorzugt sind erfindungsgemäße Zusammensetzungen mit intrinsisch reduzierter Viskosität enthaltend Alkoxylierungsprodukte (1) der Formel (I), in denen jeweils die Indices i und j unabhängig voneinander 1, 2, 3 oder 4 und u = (j - 1) bis (j + 1) betragen, sowie k und I null sind. Insbesondere bevorzugt sind erfindungsgemäße Alkoxylierungsprodukte mit intrinsisch reduzierter Viskosität der Formel (I), bei denen t (Starter (2)) < t (Starter (1) beträgt, da diese Alkoxylierungsprodukte eine besonders hervorragende Fließfähigkeit aufweisen und das Herstellungsverfahren in ganz besonders hohem Maße erleichtern, und/oder erfindungsgemäße Alkoxylierungsprodukte mit intrinsisch reduzierter Viskosität der Formel (I) in denen weitere der nachfolgend angeführten, bevorzugten Parameter erfüllt sind:
Bevorzugt sind Alkoxylierungsprodukte mit intrinsisch reduzierter Viskosität der Formel (I) wobei die Indices der Formel (I) k und I = 0, j = 0 bis 2, i = 2, u = j + 1 und v = 0, a in Summe größer gleich 2 und b in Summe 3 bis 300 ist.
Weiterhin bevorzugt sind Alkoxylierungsprodukte mit intrinsisch reduzierter Viskosität der Formel (I), wobei mindestens zwei Alkoxylierungsprodukte der Formel (I) mit jeweils unabhängig voneinander i, j, k oder I gleich 1 und v und u = 0 vorhanden sind. Zudem bevorzugt sind Alkoxylierungsprodukte mit intrinsisch reduzierter Viskosität der Formel (I), wobei die Indices der Formel (I) j= 2, k, l, u und v = 0 und i = 1 bis 4 sind. Die erfindungsgemäßen Alkoxylierungsprodukte (1) der Formel (I), und insbesondere, die vorab aufgezählten bevorzugten Ausführungsformen der Alkoxylierungsprodukte (1) zeichnen sich dadurch aus, dass sich die Viskosität von Mischungen des Alkoxylierungsproduktes (1) der Formel (I) mit Alkoxylierungsprodukt (2) um mindestens 10 %, bevorzugt um mindestens 15 %, weiter bevorzugt um mindestens 20 %, 30 %, 40%, 50%, 60% oder 70 %, erniedrigt gegenüber dem ansonsten gleichen Alkoxylierungsprodukt (1) ohne Zusatz von Starter (2) während der Alkoxylierung.
Besonders bevorzugt sind Alkoxylierungsprodukte/Polymerisate der Starter (1) (H-D^{A})ₜD^{X}, die mit t = 2 dihydroxyfunktionell sind und neben monohydroxy-funktionellen Polymerisaten von Startern (2) mit t = 1 im Produktgemisch vorliegen. Besonders bevorzugt sind Gemische aus divalenten Polyethern (H-D^{A})ₜD^{X} mit t = 2 und monovalenten Polymerisaten basierend auf Startern (2) mit t = 1, die aus Propylenoxid (PO) und 3-Glycidyloxypropyltriethoxysilan (GLYEO) und optional weiterhin Ethylenoxid (EO) und/oder Glycidylether hergestellt wurden. Insbesondere bevorzugt sind Alkoxylierungsprodukte bestehend aus monohydroxyfunktionellen Polyethern basierend auf dihydroxyfunktionellen Polyethern (H-D^{A})ₜD^{X} mit t = 2 und Startern (2) mit t = 1, die ausschließlich aus GLYEO und PO oder die ausschließlich aus GLYEO, PO und EO hergestellt wurden.

Das Fragment D^{x} des Starters (2) (H-D^{A})ₜD^{X} mit t = 1 ist bevorzugt unabhängig voneinander ein OH-funktioneller monovalenter linearer oder verzweigter, gesättigter oder ungesättigter Kohlenwasserstoffrest mit 1 bis 500 Kohlenstoffatomen, bevorzugt ausgewählt aus Alkyl-, Alkenyl-, Aryl- oder Alkarylresten, welcher gegebenenfalls durch Heteroatome wie O, N und / oder S unterbrochen und zudem weiter substituiert sein kann, z.B. mit Säureester-, Amid-, Alkyl-trialkoxysilan- oder Alkyl-alkyldialkoxysilan-Gruppen, wobei der Kohlenwasserstoffrest vorzugsweise von 1 bis 30, bevorzugt von 2 bis 18 und besonders bevorzugt von 3 bis 12 Kohlenstoffatome aufweist. Besonders bevorzugt handelt es sich um Methanol, Ethanol, Propanol, Isopropanol, Butanol, iso-Butanol, tert-Butanol, 2,2,4-Trimethyl-1,3-pentandiol monoisobutyrat (Texanol von Exxon), Octanol, 2-Ethylhexanol, 2-Propylheptanol, Allylalkohol, Decanol, Dodecanol, C₁₂/C₁₄-Fettalkohol, Phenol, alle Konstitutionsisomere des Kresols, Benzylalkohol, Stearylalkohol, insbesondere um Butanol, 2,2,4-Trimethyl-1,3-pentandiol monoisobutyrat (Texanol von Exxon), Allylalkohol, 2-Ethylhexanol oder 2-Propylheptanol.
In einer besonderen Ausführungsform der Erfindung enthält der OH-funktionelle Kohlenwasserstoffrest 7 bis 100 Kohlenstoffatome, wobei die Kohlenstoffkette des Kohlenwasserstoffrestes bevorzugt durch Sauerstoffatome unterbrochen ist, bevorzugt ist der von Sauerstoffatomen unterbrochene Kohlenwasserstoffrest ein Polyoxyalkylenrest, Polyetherrest und/oder Polyetheralkoxyrest, oder auch ein Polyester-, Polycarbonat-, Polyetheresterrest oder Mischungen aus den zuvor genannten Resten.
Bei den mono-hydroxy-funktionellen Verbindungen handelt es sich vorzugsweise um Verbindungen mit Molmassen von 32 bis 2.000 g/mol, besonders bevorzugt 50 bis 1000 g/mol, insbesondere 60 bis 200 g/mol eingesetzt. Diese Verbindungen können in beliebigen Mischungen miteinander oder als Reinsubstanz eingesetzt werden. Es können auch seitenständig mit Alkoxysilylgruppen enthaltende Substituenten oder direkt mit Alkoxysilylgruppen substituierte Hydroxylverbindungen, wie die in EP 2093244 beschriebenen Silylpolyether als Starter (2) werden.

Die bevorzugt monohydroxy-funktionellen Verbindungen des Starters (2) werden dem laufenden Alkoxylierungsprozeß zugesetzt und können so auch als Startmoleküle bezeichnet werden, da Sie durch das Vorhandensein der OH-Gruppe im Molekül als neuer Kettenstarter für den Aufbau eines Polymers/Polyethers fungieren können.
Das Fragment D^{x} des Starters (H-D^{A})ₜD^{X} mit t gleich 2 ist bevorzugt eine Verbindung ausgewählt aus niedermolekularen Verbindungen wie Ethylenglykol, Propylenglykol, Di-/Triethylenglykol, 1,2-Propylenglykol, Di-/Tripropylenglykol, Neopentylglykol, 1,4-Butandiol, 1,2-Hexandiol und 1,6-Hexandiol, Trimethylolpropan- oder Glycerinmonoether wie z. B. -monoallylether eingesetzt werden, sowie hochmolekularen Verbindungen wie Polyethylenoxiden, Polypropylenoxiden, Polyestern, Polycarbonaten, Polycarbonatpolyolen, Polyesterpolyolen, Polyetherestern, Polyetherolen, Polyethercarbonaten, Polyamiden, Polyurethanen und Zucker-basierten Alkoxylaten, die gegebenenfalls eine oder mehrere Alkoxysilylgruppen aufweisen können.

Das Fragment D^{x} des Starters (H-D^{A})ₜD^{X} mit t größer 2 ist bevorzugt eine Verbindung ausgewählt aus handelsüblichen Zuckeralkoholen wie Erythritol, Xylitol und insbesondere die 6-wertigen Reduktionsprodukte der Monosaccharide wie Mannitol und Sorbitol. Aber auch Verbindungen wie Trimethylolpropan, Di(trimethylol)ethan, Di(trimethylol)propan, Pentaerythrit, Di(pentaerythritol), Glycerin, Di(glycerin) oder Polyglycerin oder auch weitere auf Naturstoffen basierende, Hydroxylgruppen tragende Verbindungen, wie z. B. Cellulosezucker oder Lignin können eingesetzt werden.

Bevorzugt sind solche Verbindungen D^{x} mit mindestens einer OH-Gruppe und einem Schmelzpunkt von weniger als 150°C, besonders bevorzugt ist D^{x} OHterminiert und besitzt einen Schmelzpunkt von weniger als 100°C und eine Molmasse zwischen 500 - 8000 g/mol, insbesondere bevorzugt sind Starter D^{x}, die über 2 bis 6 OH-terminierte Enden verfügen, einen Schmelzpunkt von weniger als 90°C, sowie eine Molmasse von 500 - 4000 g/mol besitzen. Bevorzugte Starter D^{x} sind hydroxyl terminierte Polyether, die durch eine Reaktion von Ethylenoxid gegebenenfalls in Kombination mit Propylenoxid hergestellt wurden. Alle genannten Starter können auch in beliebigen Mischungen eingesetzt werden. Besonders bevorzugte Starter D^{x} sind hydroxylgruppenhaltige Polyester wie z. B. Desmophen® 1700 (Bayer), Polyesterpolyole, wie z. B. Stepanpol® PS-2002 (Stepan Company), Priplast 1838 (Croda) und Polycarbonate, beispielsweise Oxymer® M112 (Perstorp), Desmophen® C1200 (Bayer), Desmophen® C2200 (Bayer), sowie verschiedene dendritische OH-terminierte Polymere, wie beispielsweise Boltorn® H2004 (Perstorp). Insbesondere bevorzugte Starter sind Polypropylenglycole und Polytetrahydrofurane (erhältlich in diversen Molgewichten als Terathane® (Invista) und PolyTHF® (BASF) z.B. PolyTHF 2000)).

Weiterhin besonders bevorzugt sind erfindungsgemäße Alkoxylierungsprodukte, die bezogen auf das individuelle Molekül, im numerischen Mittel mehr als eine Alkoxysilylgruppe pro Gruppe UR aufweisen.
Weiterhin bevorzugt sind erfindungsgemäße Alkoxylierungsprodukte der Formel (I), in denen k, I, v = null sind. Weiterhin bevorzugt sind Alkoxylierungsprodukte, in denen der Index i gleich 2, der Index j gleich 1 bis 3 und der Index u gleich 2 bis 4 ist.

In einer ganz besonders bevorzugten Ausführungsform handelt es sich um erfindungsgemäße Alkoxylierungsprodukte (1) der Formel (I) mit
i = 2 bis 10, bevorzugt größer 2 bis 6, besonders bevorzugt 2
j = 0 bis 6, bevorzugt 1, 2, 3 oder 4
k = 0, 1 oder 2, bevorzugt 0
I = 0, 1 oder 2, bevorzugt 0
u = (1^{∗}j) + (2^{∗}k) + (3^{∗}l) + 1
v = 0
wobei M Formel (la) und/oder Formel (IIa) entspricht mit
a = 0 bis 50, bevorzugt 2 bis 20, weiter bevorzugt 1 bis 4,
b = 10 bis 500, weiter bevorzugt 12 bis 400
c = 0 bis 20, bevorzugt 0 bis 4
d = 0 bis 20, bevorzugt 0
w = 0 bis 20, bevorzugt 0
y = 0 bis 20, bevorzugt 0,
e = 1 bis 10,
f = 0 bis 2
g = 1 bis 3
mit der Maßgabe, dass g + f = 3
h = 1, 2 oder 3 und
- R¹ =: unabhängig voneinander ein gesättigter oder ungesättigter, linearer oder verzweigter organischer Kohlenwasserstoffrest ist, der als Heteroatome O, S und / oder N enthalten kann, bevorzugt enthält der Kohlenwasserstoffrest 1 bis 400 Kohlenstoffatome, bevorzugt 2, 3 oder 4 bis 200 Kohlenstoffatome, besonders bevorzugt ein Alkylrest mit 2 bis 12, bevorzugt mit 3 bis 6 Kohlenstoffatomen, besonders bevorzugt ein Butylrest,
- R²⁷ =: unabhängig voneinander ein gesättigter oder ungesättigter, linearer oder verzweigter organischer Kohlenwasserstoffrest ist, der als Heteroatome O, S und / oder N enthalten kann, bevorzugt enthält der Kohlenwasserstoffrest 1 bis 50 Kohlenstoffatome, bevorzugt 2, 3 oder 4 bis 30 Kohlenstoffatome, bevorzugt resultieren die Reste R²⁷ aus monovalenten Alkoholen wie Methanol, Ethanol, Propanol, Isopropanol, Butanol, iso-Butanol, tert-Butanol, 2,2,4-Trimethyl-1,3-pentandiol monoisobutyrat (Texanol von Exxon), Octanol, 2-Ethylhexanol, 2-Propylheptanol, Decanol, Dodecanol, C₁₂/C₁₄-Fettalkohol, Phenol, alle Konstitutionsisomere des Kresols, Benzylalkohol, Stearylalkohol, besonders bevorzugt um Butanol, 2,2,4-Trimethyl-1,3-pentandiol monoisobutyrat (Texanol von Exxon), 2-Ethylhexanol, Allylalkohol, 1-Hexenol oder 2-Propylheptanol, insbesondere Butanol oder Allylalkohol,
- R²⁸ =: unabhängig voneinander Wasserstoff oder ein über UR oder AP gebundenes Fragment der Formeln (II) oder (IIa) ist.
wobei für Formel (II) gilt
a = 1 bis 50, bevorzugt größer 1 bis 20, weiter bevorzugt 2 bis 10, insbesondere 0 bis 6,
b = 10 bis 700, weiter bevorzugt 12 bis 350,
c = 0 bis 20, bevorzugt 0
d = 0 bis 20, bevorzugt 0
w = 0 bis 20, bevorzugt 0
y = 0 bis 20, bevorzugt 0,
e = 1 bis 10,
f = 0 bis 2
g = 1 bis 3
mit der Maßgabe, dass g + f = 3
h = 1, 2 oder 3
und wobei für Formel (la), (II) und Formel (IIa) gilt (hier nicht explizit genannte Rest gelten wie vorab definiert)
- R² =: unabhängig voneinander eine Methyl- oder Ethyl-, Propyl-, oder Isopropylgruppe, bevorzugt eine Methyl- oder Ethylgruppe
- R³ =: unabhängig voneinander eine Methyl- oder Ethyl-, Propyl-, oder Isopropylgruppe, bevorzugt eine Methyl- oder Ethylgruppe
- R⁴ =: unabhängig voneinander Wasserstoff oder eine Methyl-, Ethyl-, Octyl-, Decyl-, Dodecyl-, Phenyl- oder Benzylgruppe, besonders bevorzugt Wasserstoff oder eine Methyl- oder Ethylgruppe,
- R⁵ =: unabhängig voneinander Wasserstoff, Methyl- oder Ethyl-, insbesondere bevorzugt Wasserstoff,
- R¹¹ =: unabhängig voneinander eine gegebenenfalls substituierte Alkylkette mit 4 bis 20 Kohlenstoffatomen, bevorzugt mit 5 bis 16 Kohlenstoffatomen, besonders bevorzugt mit 6 bis 12 Kohlenstoffatomen ist, bevorzugt ausgewählt aus Methyl-, Ethyl-, Propyl-, Butyl-, iso-Butyl-, tert-Butyl-, 2-Pentyl-, 3-Pentyl-, 2-Methylbutyl-, 3-Methylbutyl-, 2-Methyl-2-butyl-, 3-Methyl-2-butyl-, 2,2-Dimethylpropyl-, Hexyl-, Heptyl-, Octyl-, 2-Ethylhexyl-, 2-Propylheptyl-, 2-Butyloctanyl-, 2-Methylundecyl-, 2-Propylnonyl-, 2-Ethyldecyl-, 2-Pentylheptyl-, 2-Hexyldecyl-, 2-Butyltetradecyl-, 2-Dodecylhexadecyl-, 2-Tetradecyloctadecyl-, 3,5,5-Trimethylhexyl-, Isononanyl-, Isotridecyl-, Isomyristyl-, Isostearyl-, 2-Octyldodecyl- Triphenylmethyl-, C(O)-(CH₂)₅-C-(CH₃)₃- (Rest der Neodecansäure), C₁₂/C₁₄-Alkyl-, Phenyl-, Kresyl-, tert-Butylphenyl- oder Benzylgruppe, besonders bevorzugt eine 2-Ethylhexyl-, C(O)-(CH₂)₅-C-(CH₃)₃- (Rest der Neodecansäure), C₁₂/C₁₄-Alkyl-, Phenyl-, Kresyl-, tert-Butylphenylgruppe, ganz besonders bevorzugt eine tert-Butylphenyl- oder 2-Ethylhexylgruppe,
und wobei für UR gilt
- UR: sind unabhängig voneinander gleiche oder verschiedene divalente Reste der Form
-U-D^{C}-U-, mit D^{C} unabhängig voneinander ein divalenter substituierter oder unsubstituierter, linearer oder verzweigter, gesättigter oder ungesättigter Kohlenwasserstoffrest mit 1 bis 30 Kohlenstoffatomen, insbesondere bevorzugt ist D^{C} gleich ein Isophoronrest,
da Zusammensetzungen enhaltend diese Alkoxylierungsprodukte (1) in Kombination mit den Alkoxylierungsprodukten (2) eine besonders hervorragende Fließfähigkeit aufweisen und auch das Herstellungsverfahren in außergewöhnlich hohem Maße erleichtern.

In der EP 2 093 244 wird beschrieben, dass man Epoxidfunktionen tragende Alkoxysilane in vorteilhafter Weise in Gegenwart bekannter Doppelmetallcyanidkatalysatoren selektiv alkoxylieren kann. Mit dem dort offenbarten Verfahren erschließt sich die Möglichkeit, in reproduzierbarer Weise die ein- und/oder mehrfache Alkoxysilylgruppen-Modifizierung von Polyoxyalkylenverbindungen nicht nur terminal, sondern auch innerhalb der Sequenz von Oxyalkyleneinheiten vorzunehmen. Die Offenbarung der EP 2 093 244 ist vollumfänglich als Teil und Bestandteil dieser Beschreibung anzusehen.

Besonders bevorzugte erfindungsgemäße Zusammensetzungen sind herstellbar nach einem der nachfolgend genannten Verfahren.

Ein weiterer Gegenstand der vorliegenden Erfindung ist ein Verfahren zur Herstellung von Zusammensetzungen mit intrinsisch reduzierter Viskosität enthaltend Alkyoxylierungsprodukte (1) und (2) nach Maßgabe von Anspruch 9. Überraschenderweise wurde nun gefunden, dass das Verfahren zur Herstellung von Alkyoxylierungsprodukten (1) und (2) umfassend die Schritte
(a) Umsetzen mindestens eines Starters (1) mit mindestens einem Alkylenoxid und
(b) Umsetzen mindestens eines von Starter (1) verschiedenen Starters (2) mit mindestens einem Alkylenoxid,
wobei es sich bei Starter (1) und (2) um OH-funktionelle Verbindungen, bevorzugt wie zuvor definiert, handelt. Bevorzugt erfolgt der Schritt b) noch während der laufenden Alkoxylierung des Schrittes a).
Bevorzugt erfolgt die Zugabe des Starters (2) nachdem die Zugabe des Starters (1) vollständig abgeschlossen ist. Hohe Reduktionen der Viskosität werden insbesondere erzielt, wenn Starter (1) eine Molmasse von größer 400 g/mol aufweist und Starter (2) eine Molmasse von kleiner gleich 400 g/mol aufweist. Überraschenderweise hat sich gezeigt, dass eine besonders gute Reduktion der Viskosität erzielt werden kann, wenn die Molmasse von Starter (1) die Molmasse von Starter (2) um mindestens 200 g/mol, bevorzugt um mindestens 600 g/mol besonders bevorzugt um mindestens 1000 g/mol, übersteigt. Besonders bevorzugt ist die Molmasse von Starter (1) mindestens doppelt so groß wie die Molmasse von Starter (2). Verfahren, in denen solche Starter eingesetzt werden sind daher besonders bevorzugt.
Bevorzugt handelt es sich bei den Alkylenoxiden des Verfahrenschrittes (a) um Ethylenoxid und/oder Propylenoxid und mindestens ein Alkoxysilylgruppen tragendes Epoxid und bei den Alkylenoxiden des Verfahrenschrittes (b) um Ethylenoxid und/oder Propylenoxid und gegebenenfalls mindestens einem Alkoxysilylgruppen tragenden Epoxid und/oder weiteren Monomeren. Bevorzugt werden Monomeren zu folgenden Anteilen eingesetzt 10 bis 97 Gew.-%, bevorzugt 20 bis 95 Gew.-%, insbesondere bevorzugt 30 bis 90 Gew.-% Propylenoxid, 0 bis 60 Gew.-%, bevorzugt 3 bis 40 Gew.-%, insbesondere bevorzugt 5 bis 30 Gew.-% Ethylenoxid, 0 bis 25 Gew.-%, bevorzugt 0,5 bis 15 Gew.-%, insbesondere bevorzugt 1 bis 10 Gew.-% Alkoxysilylgruppen tragendes Epoxid und 0 bis 25 Gew.-%, bevorzugt 0,1 bis 20 Gew.-%, insbesondere bevorzugt 0 bis 10 Gew.-% weitere Monomere, bevorzugt ausgewählt aus von Propylenoxid und Ethylenoxid verschiedenen Alkylenoxiden, wie Butylenoxid, Isobutylenoxid, Styroloxid und/oder weiteren Comonomeren wie ε-Caprolacton, Phthalsäureanhydrid, Glycidylethern wie tert-Butylphenylglycidylether, C₁₂/C₁₄-Fettalkoholglycidylether und 2-Ethylhexylglycidylether bezogen auf das Gesamtgewicht der eingesetzten Monomere.

Bevorzugt ist ein Verfahren zur Herstellung von Alkyoxylierungsprodukten umfassend die Schritte
(a) Umsetzen mindestens eines Starters (1) mit 10 bis 97 Gew.-% Propylenoxid, 0 bis 60 Gew.-% Ethylenoxid, 0 bis 25 Gew.-% Alkoxysilylalkylglycidylether und 0 bis 25 Gew.-% weitere Monomere, bezogen auf das Gesamtgewicht der eingesetzten Monomere
(b) Umsetzen mindestens eines Starters (2) mit 10 bis 97 Gew.-% Propylenoxid, 0 bis 60 Gew.-% Ethylenoxid, 0 bis 25 Gew.-% Alkoxysilylalkylglycidylether und 0 bis 25 Gew.-% weitere Monomere, bezogen auf das Gesamtgewicht der eingesetzten Monomere.
Ein besonders bevorzugtes Verfahren, welches besonders vorteilhaft für die Reduktion der Viskosität der Verfahrensprodukte ist, ist ein Verfahren zur Herstellung von Alkyoxylierungsprodukten umfassend die Schritte
(a) Umsetzen mindestens eines Starters (1) mit mindestens einem Alkylenoxid und
(b) Umsetzen mindestens eines von Starter (1) verschiedenen Starters (2) mit mindestens einem Alkylenoxid,
wobei es sich bei Starter (1) und (2) um OH-funktionelle Verbindungen, bevorzugt wie zuvor definiert, handelt, indem der Starter (1) eine höhere OH-Funktionalität, also mehr OH-Gruppen, aufweist als der Starter (2), besonders bevorzugten weist der Starter (1) t OH-Gruppen auf und Starter (2) t - 1 OH-Gruppen auf, mit t = 2 bis 8, bevorzugt 2 bis 5, besonders bevorzugt 2, 3 oder 4 und insbesondere 2.

Bevorzugt sind die erfindungsgemäßen Produkte über ein Alkoxylierungsverfahren unter Verwendung von Doppelmetallcyanidkatalysatoren (DMC-Katalysatoren) und dihydroxyfunktionellen Verbindungen, wie z.B. Polyether (H-D^{A})ₜD^{X} mit t = 2 als Starter (1) sowie monohydroxyfunktionellen Verbindungen, wie z.B. niedermolekularen Alkoholen mit t = 1 als Starter (2) erhältlich.
Bevorzugt sind die erfindungsgemäßen Alkoxylierungsprodukte dadurch erhältlich, dass an derartige Starter mindestens ein Glycidylether der allgemeinen Formel (V) 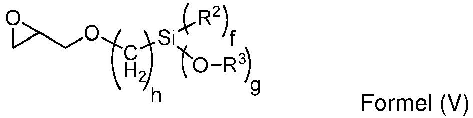 mit
f = 0 bis 2
g = 1 bis 3
mit der Maßgabe, dass g + f = 3 und g mindestens gleich 1 ist,
h = 0 bis 10 und
R² = unabhängig voneinander eine Alkylgruppe mit 1 bis 8 Kohlenstoffatomen,
R³ = unabhängig voneinander eine Alkylgruppe mit 1 bis 8 Kohlenstoffatomen,
und mindestens ein weiteres polymerisierbares Monomer, bevorzugt ausgewählt aus Alkylenoxiden, Glycidylethern, Lactonen, cyclischen Dicarbonsäureanhydriden und Mischungen daraus, insbesondere Alkylenoxide, besonders bevorzugt Monomere, die im fertigen Produkt zu Fragmenten mit dem Index b, c, d, w und/oder y, insbesondere bevorzugt Fragmenten mit dem Index b, der Formeln (la), (II) und (IIa) führen, dergestalt miteinander umgesetzt werden, dass der/die Starter (2) nicht gemeinsam mit Starter (1) zu Beginn der Reaktion vorliegen, sondern gemeinsam mit einem oder mehreren der zuvor genannten Monomeren während der laufenden Alkoxylierung zugegeben werden.
Einsetzbare Alkylenoxidverbindungen, die zu den in den Formeln (Ia), (II) und (IIa) angegebenen Fragmenten mit dem Index b führen, sind z.B. Ethylenoxid, 1,2-Epoxypropan (Propylenoxid), 1,2-Epoxy-2-methylpropan (Isobutylenoxid), Epichlorhydrin, 2,3-Epoxy-1-propanol, 1,2-Epoxybutan (Butylenoxid), 2,3-Epoxybutan, 2,3-Dimethyl-2,3-epoxybutan, 1,2-Epoxypentan, 1,2-Epoxy-3-methylpentan, 1,2-Epoxyhexan, 1,2-Epoxycyclohexan, 1,2-Epoxyheptan, 1,2-Epoxyoctan, 1,2-Epoxynonan, 1,2-Epoxydecan, 1,2-Epoxyundecan, 1,2-Epoxydodecan, Styroloxid, 1,2-Epoxycyclopentan, 1,2-Epoxycyclohexan, Vinylcyclohexenoxid, (2,3-Epoxypropyl)benzol, Vinyloxiran, 3-Phenoxy-1,2-epoxypropan, 2,3-Epoxymethylether, 2,3-Epoxyethylether, 2,3-Epoxylisopropylether, (3,4-Epoxybutyl)stearat, 4,5-Epoxypentylacetat, 2,3-Epoxylpropanmethacrylat, 2,3-Epoxylpropanacrylat, Gylcidylbutyrat, Methylglycidat, Ethyl-2,3-epoxybutanoat, 4-(Trimethylsilyl)butan-1,2-epoxid, 4-(Triethylsilyl)butan-1,2-epoxid, 3-(Perfluoromethyl)-1,2-epoxypropan, 3-(Perfluoroethyl)-1,2-epoxypropan, 3-(Perfluorobutyl) -1,2-epoxypropan, 3-(Perfluorohexyl)-1,2-epoxypropan, 4-(2,3-Epoxypropyl)morpholin, 1-(Oxiran-2-ylmethyl)pyrrolidin-2-on. Bevorzugt eingesetzt werden Ethylenoxid, Propylenoxid und Butylenoxid. Besonders bevorzugt werden Ethylenoxid und Propylenoxid eingesetzt.

Eine nicht abschließende Sammlung von Lactonen, welche durch Ringöffnung zu den in den Formeln (la), (II) und (IIa) angegebenen Fragmenten mit dem Index d führen, sind Valerolactone oder Caprolactone zu nennen, die beide unsubstituiert oder mit Alkylgruppen, bevorzugt Methylgruppen, substituiert sein können. Vorzugsweise werden ε-Caprolacton oder δ-Valerolacton eingesetzt, insbesondere ε -Caprolacton.

Als gesättigte, ungesättigte oder aromatische cyclische Dicarbonsäureanhydride, welche durch Einreaktion zu den Fragmenten mit dem Index y führen, werden bevorzugt Bernsteinsäureanhydrid, Oct(en)yl-, Dec(en)yl- und Dodec(en)ylbernsteinsäueanhydrid, Maleinsäureanhydrid, Itaconsäureanhydrid, Phthalsäureanhydrid, Hexahydro-, Tetrahydro-, Dihydro-, Methylhexahydro- und Methyltetrahydrophthalsäureanhydrid eingesetzt. Während des Alkoxylierungsprozesses können die jeweiligen Anhydridmonomere in beliebiger Reihenfolge und variabler Menge nacheinander oder zeitlich parallel zum Epoxidfeed unter Ringöffnung zu Polyetherestern copolymerisiert werden. Auch Mischungen der genannten Anhydride sind einsetzbar. Des Weiteren ist es möglich die Anhydride dem Starter D^{x} vor Reaktionsbeginn zuzusetzen und auf eine Zudosage wie zuvor beschrieben zu verzichten. Es ist aber auch möglich sowohl dem Starter D^{x} Anhydride zuzusetzen und im weiteren Reaktionsverlauf noch weiteres Anhydrid während der Alkoxylierung zuzudosieren.
Besonders bevorzugt werden Bernsteinsäureanhydrid, Maleinsäureanhydrid, Phthalsäureanhydrid, und Hexahydrophthalsäureanhydrid eingesetzt, insbesondere Maleinsäureanhydrid und Hexahydrophthalsäureanhydrid.

Als Glycidylether, welche zu den in den Formeln (la), (II) und (IIa) angegebenen Fragmenten mit dem Index c führen, entsprechen der allgemeinen Formel (IV). 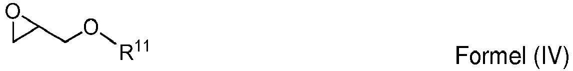 mit R¹¹ wie oben definiert.

Bevorzugt entspricht R¹¹ einer Methyl-, Ethyl-, iso-Butyl-, tert-Butyl-, Hexyl-, Octyl-, 2-Ethylhexyl-, -C(O)-(CH₂)₅-C-(CH₃)₃ (Rest aus der Neodecansäure, erhältlich z.B. als Cardura E 10 P bei Momentive), C₁₂/C₁₄-, Phenyl-, Kresyl-, oder tert-Butylphenylgruppe oder/und einer Allylgruppe, besonders bevorzugt handelt es sich um eine Allyl-, Kresyl-, 2-Ethylhexyl-, -C(O)-(CH₂)₅-C-(CH₃)₃ oder C₁₂/C₁₄-Gruppe. Insbesondere bevorzugt werden 2-Ethylhexyl- (erhältlich beispielsweise als Grilonit RV 1807, Grilonit RV 1807 4.1 bzw. IPOX RD 17) und C₁₂-C₁₄-Glycidylether (erhältlich beispielsweise als Ipox® RD 24) eingesetzt.
Als Glycidylether können auch polyfunktionelle Glycidylether wie 1,4-Butandioldiglycidylether, 1,6-Hexandioldiglycidylether, Cyclohexandimethanoldiglycidylether, Neopentylglykoldiglycidylether, Polyethylenglykoldiglycidylether, Polypropylenglykol-diglycidylether, Polyglycerin-3-Glycidether, Glycerintriglycidether, Trimethylolpropan-triglycidylether oder Pentraerythrittetraglycidylether eingesetzt werden, wodurch auch verzweigte Strukturelemente in das finale Alkoxylierungsprodukt der Formeln (I) gemäß der Formeln (la), (II) und (IIa) eingebracht werden können.
Je nach verwendetem epoxidfunktionellem Alkoxysilan und evtl. eingesetzten weiteren Monomeren, können modifizierte Alkoxylierungsprodukte gemäß Formel (I) hergestellt werden, sowie beliebig aufgebaute Gemische.

Einsetzbare Alkylenoxidverbindungen, die zu den in den Formeln (Ia), (II) und (IIa) angegebenen Fragmenten mit dem Index a führen, können der allgemeinen Formel (V) 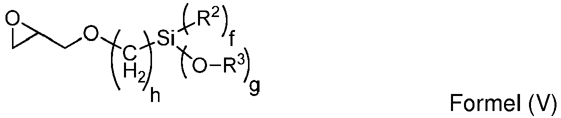 mit f, g, h, R² und R³ wie oben definiert, entsprechen.

Eine nicht abschließende Sammlung von Epoxidgruppen-substituierten Alkoxysilanen, gemäß Formel (V) umfasst zum Beispiel 3-Glycidyloxypropyltrimethoxysilan, 3-Glycidyloxypropyltriethoxysilan, 3-Glycidyloxypropyltripropoxysilan, 3-Glycidyloxypropyltriisopropoxysilan, Bis(3-Glycidyloxypropyl)dimethoxysilan, Bis(3-Glycidyloxypropyl)diethoxysilan, 3-Glycidyloxyhexyltrimethoxysilan, 3-Glycidyloxyhexyltriethoxysilan, 3-Glycidyloxypropyl-methyl-dimethoxysilan, 3-Glycidyloxypropyl-ethyl-diethoxysilan. Bevorzugt werden im erfindungsgemäßen Verfahren als Verbindungen der Formel (V) 3-Glycidyloxy-propyltrimethoxy- oder -triethoxysilan eingesetzt, die z.B. unter den Handelsnamen DYNASYLAN® GLYMO bzw. DYNASYLAN® GLYEO (Warenzeichen der Evonik Degussa GmbH) erhältlich sind. Besonders bevorzugt ist der Einsatz von Glycidyloxy-propyltriethoxysilan, da auf diese Weise bei der Anwendung als feuchtigkeitsvernetzende Komponenten Methanolemissionen vermieden werden können.

Unter den Verbindungen, die den Rest R¹ der Formel (la) liefern, werden im Rahmen der vorliegenden Erfindung Substanzen verstanden, welche die Endgruppe des finalen Alkoxylierungsproduktes mit intrinsisch reduzierter Viskosität sein können.
Der Rest R¹ entstammt vorzugsweise einer hydroxylgruppenhaltigen Verbindung der Formel (VI)

R¹-H Formel (VI)

mit R¹ = R^{x}-O- und R^{x} = organischer Rest, der weitere OH-Gruppen aufweisen kann und gegebenenfalls eine oder mehrere Alkoxysilylgruppen aufweisen kann, bei denen also der in Formel (VI) gezeigte Wasserstoff Teil der Hydroxygruppe ist. Es werden vorzugsweise Verbindungen mit Molmassen von 31 bis 10.000 g/mol, besonders bevorzugt 50 bis 2000 g/mol, insbesondere 60 bis 200 g/mol eingesetzt. Diese Verbindungen können in beliebigen Mischungen miteinander oder als Reinsubstanz eingesetzt werden. Es können auch seitenständig mit Alkoxysilylgruppen enthaltende Substituenten oder direkt mit Alkoxysilylgruppen substituierte Hydroxylverbindungen, wie die in EP 2093244 beschriebenen Silylpolyether als Startverbindungen eingesetzt werden.

In einer besonderen Ausführungsform der vorliegenden Erfindung kann es möglich sein die Verbindungen des Typs R¹-H als Starter (2) während der Alkoxylierung einzusetzen, so dass sich Alkoxylierungsprodukte, insbesondere der Formel (la), bilden, welche durch die erfindungsgemäße Anlagerung von epoxidfunktionellen Monomeren und evtl. weiteren Comonomeren erhalten wird.
Die in dem erfindungsgemäßen Verfahren eingesetzte Verbindung der Formel R¹-H ist vorzugsweise ausgewählt aus der Gruppe der Alkohole, Polyetherole oder Phenole. Bevorzugt wird als Startverbindung ein ein- oder mehrwertiger Polyetheralkohol oder Alkohol eingesetzt. Bevorzugt werden ein- bis vierwertige Polyetheralkohole oder Alkohole eingesetzt. Insbesondere bevorzugt werden einwertige Polyetheralkohole oder Alkohole eingesetzt. Vorteilhaft werden niedermolekulare Polyetherole mit Molmassen von 50 bis 2000 g/mol, die ihrerseits zuvor durch DMC-katalysierte Alkoxylierung hergestellt wurden, verwendet.

Neben Verbindungen mit aliphatischen und cycloaliphatischen OH-Gruppen eignen sich beliebige Verbindungen mit OH-Funktionen. Hierzu gehören beispielsweise Phenol, Alkyl- und Arylphenole.

Als 2 bis 4-fach-OH-funktionelle Starter (1) und (2), bevorzugt (H-D^{A})ₜD^{X} mit t = 2 bis 4, werden vorzugsweise Verbindungen mit Molmassen von 62 bis 10.000 g/mol, bevorzugt 92 bis 7000 g/mol, besonders bevorzugt 122 bis 5000 g/mol und für Starter (1) insbesondere bevorzugt 2000 bis 4000 g/mol, eingesetzt. Die Startverbindungen können in beliebigen Mischungen miteinander oder als Reinsubstanz eingesetzt werden. Es können auch seitenständig Alkoxysilylgruppen enthaltende Substituenten oder direkt mit Alkoxysilylgruppen substituierte Hydroxylverbindungen, wie die in EP 2093244 beschriebenen Silylpolyether als Startverbindungen eingesetzt werden. Vorteilhaft werden niedermolekulare Polyetherole mit Molmassen von 62 bis 4000 g/mol, die ihrerseits zuvor durch DMC-katalysierte Alkoxylierung hergestellt wurden, als Starterverbindungen verwendet.

Neben Verbindungen mit aliphatischen und cycloaliphatischen OH-Gruppen eignen sich beliebige Verbindungen mit OH-Funktionen. Hierzu gehören beispielsweise Phenol, Alkyl- und Arylphenole oder auch Kohlenhydrate wie z.B. Saccharide, insbesondere eignen sich Bisphenol A und Novolake als Startverbindungen.

Die mittleren Molmassen M_{w} der Alkoxylierungsprodukte der Einheit(en) D gemäß Formel (I) betragen vorzugsweise zwischen 4000 bis 50000 g/mol, bevorzugt zwischen 8000 und 20000 g/mol und besonders bevorzugt von 10000 bis 16000 g/mol. Vorzugsweise sind die Alkoxylierungsprodukte der Formel (I) bei Raumtemperatur flüssig.

Die Hydrophilie / Hydrophobie der Molekülteile M, D, T, Q der erfindungsgemäßen Alkoxylierungsprodukte kann durch die Wahl geeigneter Startermoleküle und/oder geeigneter Comonomere für die Alkoxylierung eingestellt werden.

Die erfindungsgemäßen Alkoxylierungsprodukte können auf verschiedene Arten und Weisen erhalten werden. Vorzugsweise erfolgt die Herstellung der erfindungsgemäßen Alkoxylierungsprodukte nach dem nachfolgend beschriebenen erfindungsgemäßen Verfahren.
Die Alkoxylierungsprodukte der Formel (I) zeichnen sich dadurch aus, dass sie hinsichtlich Strukturaufbau und Molmasse gezielt und reproduzierbar hergestellt werden können. Die Sequenz der Monomereinheiten kann in weiten Grenzen variabel gestaltet werden. Epoxidmonomere können beliebig blockartig aneinander gereiht oder statistisch in die Polymerkette eingebaut sein. Die durch die Reaktion unter Ringöffnung der Reaktionskomponenten in die entstehende Polymerkette eingefügten Fragmente sind in ihrer Sequenz untereinander frei permutierbar, im Sinne von in beliebiger Reihenfolge anzuordnen, mit der Einschränkung, dass cyclische Anhydride sowie Kohlendioxid statistisch insertiert, also nicht in homologen Blöcken, in der Polyetherstruktur vorliegen, sowie nicht in direkter Nachbarschaft zueinander.

Die in den hier angeführten Formeln wiedergegebenen Indexzahlen und die Wertbereiche der angegebenen Indizes verstehen sich daher als die Mittelwerte der möglichen statistischen Verteilung der tatsächlichen vorhandenen Strukturen und/oder deren Mischungen. Dies gilt auch für solche an sich exakt wiedergegebene Strukturformeln, wie beispielsweise für Formel (la) und/oder (II) und/oder (IIa).

Je nach verwendetem epoxidfunktionellem Alkoxysilan und evtl. eingesetzten weiteren Monomeren, sowie evtl. auch Kohlendioxid können ester- oder carbonatmodifizierte Alkoxysilylpolyether erhalten werden. Bevorzugt ist die Alkoxysilyleinheit in der Verbindung der Formeln (la), (II) und (IIa) eine Trialkoxysilyleinheit, insbesondere Triethoxysilyleinheit.

Wie ²⁹Si-NMR- und GPC-Untersuchungen ergeben, bedingt durch das verfahrensbedingte Vorhandensein von kettenendständigen OH-Gruppen die Möglichkeit zu Umesterungsreaktionen am Siliziumatom sowohl während der DMCkatalysierten Herstellung als auch z.B. in einem nachgeschalteten Prozessschritt. Dabei wird formal der über ein Sauerstoffatom an das Silizium gebundene Alkylrest R³ gegen einen langkettigen modifizierten Alkoxysilylpolymerrest ausgetauscht. Bimodale wie auch multimodale GPC- Kurven belegen, dass die Alkoxylierungsprodukte neben den nicht umgeesterten Spezies, wie sie in Formel (I) wiedergegeben sind, solche mit der doppelten, zum Teil dreifachen oder gar vielfachen Molmasse enthalten. Formel (I) gibt mithin die komplexe chemische Realität nur vereinfacht wieder.

Somit stellen die Alkoxylierungsprodukte Mischungen dar, die auch Verbindungen enthalten können, in denen die Summe der Indices f + g in den Formeln (la), (II) und (IIa) im statistischen Mittel kleiner als 3 ist, da ein Teil der OR-Gruppen durch Silylpolyethergruppen ersetzt werden kann. Die Zusammensetzungen enthalten somit Spezies, die am Siliziumatom unter Abspaltung von R³-OH und Kondensationsreaktion mit der reaktiven OH-Gruppe eines weiteren Moleküls der Formeln (la) und/oder (II) und/oder (IIa) ausgebildet werden. Diese Reaktion kann mehrfach ablaufen bis z.B. alle R³O-Gruppen am Silizium gegen weitere Moleküle der Formeln (la) und/oder (II) und/oder (IIa) ausgetauscht sind. Das Vorhandensein von mehr als einem Signal in typischen ²⁹Si-NMR-Spektren dieser Verbindungen untermauert das Auftreten von Silylgruppen mit unterschiedlichem Substitutionsmuster.
Die angegebenen Werte und Vorzugsbereiche für die Indizes a, b, c, d, e, f, g, h, i, j, k, l, m, n, o, p, q, r, s, t, u, v, w, x und y der Verbindungen der Formeln (I), (Ia), (II) und (IIa) sind somit als Mittelwerte über die verschiedenen, einzeln nicht fassbaren Spezies zu verstehen. Die Vielfalt an chemischen Strukturen und Molmassen spiegelt sich auch in den für Alkoxylierungsprodukte der Formel (I) typischen und für konventionelle DMC-basierende Polyether völlig ungewöhnlichen breiten Molmassenverteilungen von M_{w}/Mₙ von meist ≥ 1,5 wider.

Untrennbar mit dem in der EP 2 093 244 dargelegten Verfahren der Alkoxylierung von expoxyfunktionellen Alkoxysilanen verbunden, ist die Besonderheit, dass an dem Kettenterminus bzw. den Kettentermini immer eine OH-Funktionalität vorhanden ist, hervorgegangen aus der Epoxidringöffnung des jeweils letzten Epoxidmonomers unter Anknüpfung an das OH-funktionelle Ende der wachsenden Kette.

In EP 2415796 (US 2012/028022) und der noch unveröffentlichten Patentanmeldung DE 10 2012 203737 war es Ziel die Absenkung der Reaktivität der OH-Gruppe von hydroxylgruppenterminierten Alkoxylierungsprodukten der Formel (I), die nicht ausschließlich terminale Alkoxysilylgruppen tragen, zu ermöglichen. Dabei konnte gezeigt werden, dass sich durch die Reduzierung der Reaktivität der OH-Gruppen die Lagerstabilität und auch die Bruchdehnung des gehärteten/polymerisierten alkoxysilylierten Alkoxylierungsprodukts massiv verbessern lässt. Durch die Einführung einer Endverkappung der Hydroxylgruppe am Kettenende des Präpolymers konnte dies erreicht werden.

Die erfindungsgemäßen Produkte können auf unterschiedlichste Weise, insbesondere durch Verfahren, die sich an das in EP 2 093 244, EP 2415796 (US 2012/028022) oder EP 2415797 (US 2012/029090) beschriebene Verfahren anlehnen, hergestellt werden. Vorzugsweise werden die erfindungsgemäßen Alkoxylierungsprodukte durch das nachfolgend beschriebene erfindungsgemäße Verfahren hergestellt.

Ein erfindungsgemäß bevorzugtes Verfahren zur Herstellung eines erfindungsgemäßen Alkoxylierungsprodukts mit intrinsisch reduzierter Viskosität gemäß Formel (I) zeichnet sich dadurch aus, dass mindestens ein Startmolekül (H-D^{A})ₜD^{X} mit t größer gleich 2 mit mindestens einem Glycidylether der allgemeinen Formel (V) und gegebenenfalls mindestens einem Alkylenoxid dergestalt umgesetzt werden, daß im Verlaufe der Alkoxylierung temporär auch mindestens ein Starter (2) mit t größer gleich 1 zugesetzt wird.

Die bevorzugt mono-hydroxy-funktionellen Verbindungen Starter (2) werden dem laufenden Alkoxylierungsprozeß, umfassend Starter (1), bevorzugt in Anwesenheit eines Doppelmetallcyanid-Katalysators, zugesetzt und können so auch als Startmoleküle bezeichnet werden, da Sie durch das Vorhandensein der OH-Gruppe im Molekül als neuer Kettenstarter für den Aufbau eines Polymers/Polyethers fungieren können. Dadurch werden Alkoxylierungsprodukte mit deutlich reduzierter Viskosität erhalten. Dies ist umso erstaunlicher, als der Fachmann aufgrund des sogenannten "Catch-up" Verhaltens von DMC Katalysatoren keine Veränderung des Produktes erwarten konnte.

Das erfindungsgemäße Verfahren zur Herstellung eines erfindungsgemäßen Alkoxylierungsprodukts mit intrinsisch reduzierter Viskosität kann bevorzugt aus bis zu zwei Verfahrensschritten bestehen. Im Verfahrensschritt A wird bevorzugt eine Alkoxylierungsreaktion, welche in mehreren Stufen durchgeführt werden kann durchgeführt, woran sich gegebenenfalls ein Verfahrensschritt B, eine sogenannte Endverkappungsreaktione anschließt.

### Verfahrensschritt A:

Im Verfahrensschritt A wird eine DMC-katalysierte Alkoxylierung eines Starters (1) mit Epoxid-Gruppen aufweisenden Verbindungen (Alkylenoxiden und Glycidylethern) durchgeführt, bei der im Reaktionsverlauf auch Starter (2) zugesetzt werden.
Zum Starten der Alkoxylierungsreaktion nach erfindungsgemäßem Verfahren wird das Startgemisch, bestehend aus einem oder mehreren OH-funktionellen Starter (1) D^{X} und dem Doppelmetallcyanid-Katalysator, der gegebenenfalls zuvor in einem Suspendiermittel aufgeschlämmt wurde, im Reaktor vorgelegt.
Als Suspensionsmittel können entweder ein Polyether oder inerte Lösungsmittel benutzt werden oder vorteilhaft auch eine oder mehrere Startverbindungen, oder alternativ ein Gemisch aus beiden Komponenten.
Der vorgelegten Startmischung wird Propylenoxid oder zumindest eine andere Epoxidverbindungen zudosiert. Zum Starten der Alkoxylierungsreaktion und zur Aktivierung des Doppelmetallcyanid-Katalysators wird zunächst meist nur ein Teil der insgesamt zu dosierenden Menge an Epoxid zugefügt. Das molare Verhältnis von Epoxid zu den reaktiven Gruppen des Starters, insbesondere den OH-Gruppen im Startgemisch, liegt in der Startphase dabei vorzugsweise zwischen 0,1 zu 1 bis 10 zu 1, bevorzugt zwischen 0,2 zu 1 bis 5 zu 1, insbesondere zwischen 0,4 zu 1 bis 3 zu 1. Es kann vorteilhaft sein, wenn vor der Zugabe des Epoxids gegebenenfalls vorhandene, die Reaktion inhibierende Stoffe aus dem Reaktionsgemisch z.B. durch Destillation gegebenenfalls im Vakuum entfernt werden.
Das Starten der exothermen Reaktion kann z.B. durch eine Druck- und/oder Temperaturüberwachung detektiert werden. Ein plötzlicher Abfall des Drucks im Reaktor zeigt bei gasförmigen Alkylenoxiden an, dass das Alkylenoxid eingebaut wird, die Reaktion somit gestartet und das Ende der Startphase erreicht ist. Bei nicht gasförmigen Glycidylethern/-estern oder epoxidfunktionellen Alkoxysilanen wird das Anspringen der Reaktion durch die einsetzende Wärmetönung angezeigt.

Nach der Startphase, also nach Initialisierung der Reaktion, werden je nach angestrebter Molmasse entweder gleichzeitig einer oder mehrere Starter (2) und weiteres Alkylenoxid oder nur weiteres Alkylenoxid zudosiert. Alternativ kann auch ein beliebiges Gemisch von unterschiedlichen Alkylenoxidverbindungen und Verbindungen der Formeln (IV) und (V) addiert werden, wobei diese auch separat in beliebiger Reihenfolge nacheinander addiert werden können.
Die Umsetzung kann z.B. zwecks Viskositätserniedrigung des Reaktionsgemisches in einem inerten Lösemittel durchgeführt werden. Als inerte Lösungsmittel eignen sich Kohlenwasserstoffe, insbesondere Toluol, Xylol oder Cyclohexan. Dies ist jedoch weniger bevorzugt.

In den erfindungsgemäßen Produkten beträgt das molare Verhältnis der Summe der dosierten Epoxide, inklusive der bereits in der Startphase zugefügten Epoxide, bezogen auf die eingesetzte Startverbindung, insbesondere bezogen auf die Anzahl der OH-Gruppen der eingesetzten Startverbindung, dabei vorzugsweise 1 bis 10⁵ zu 1, insbesondere 1 bis 10⁴ zu 1.
Die Anlagerung der Alkylenoxidverbindungen geschieht vorzugsweise bei einer Temperatur von 60 bis 250 °C, besonders bevorzugt bei einer Temperatur von 90 bis 160 °C. Der Druck, bei dem die Alkoxylierung stattfindet, beträgt vorzugsweise 0,02 bar bis 100 bar, besonders bevorzugt 0,05 bis 20 bar und insbesondere von 0,2 bis 2 bar absolut. Durch die Durchführung der Alkoxylierung bei Unterdruck kann die Reaktion sehr sicher durchgeführt werden. Gegebenenfalls kann die Alkoxylierung in Gegenwart eines Inertgases (z.B. Stickstoff) oder - zur Herstellung von Polyethercarbonaten - in Gegenwart von Kohlendioxid auch bei einem Überdruck von dann vorzugsweise 1 bis 20 bar absolut durchgeführt werden.

Die für die Herstellung von estermodifizierten Polyethern einsetzbaren Lactone oder cyclischen Anhydride können sowohl bereits in der Startphase dem Gemisch aus Starter (1) und Katalysator zugefügt als auch zu einem späteren Zeitpunkt parallel zur Alkylenoxiddosierung zugeführt werden. Die genannten Comonomere können auch jeweils nacheinander alternierend mit Alkylenoxiden in den Reaktor dosiert werden.
Das molare Verhältnis der Alkylenoxidmonomere zu cyclischen Anhydriden ist dabei variabel. Üblicherweise werden mindestens äquimolare Mengen Alkylenoxidmonomere bezogen auf Anhydride eingesetzt. Bevorzugt ist die Verwendung der Alkylenoxide in einem molaren Überschuss, um die vollständige Anhydridumsetzung zu gewährleisten.
Lactone können während der Alkoxylierung wahlweise im stöchiometrischen Unterschuss oder Überschuss bezogen auf die Alkylenoxidmonomere zugefügt werden.

Die Zugabe von Startern (2) kann hierbei hinsichtlich Konzentration, Art und Anzahl der Verbindungen, sowie Art der Reaktionsführung in weiten Grenzen erfolgen, die dem Anwender eine hohe Flexibilität gestattet.
So kann die Zudosierung von Startern (2) einmalig zu einem bestimmten Zeitpunkt oder auch mehrmalig in Portionen zu mehreren Zeitpunkten erfolgen. Die Gesamtmenge an Starter (2) kann hierbei gleichmäßig auf die gewünschte Anzahl an Portionen aufgeteilt werden, es ist jedoch auch möglich die Gesamtmenge auf unterschiedlich große Portionen aufzuteilen.
Neben der zuvor beschriebenen diskontinuierlichen Zugabe von Startern (2) kann die Zugabe auch kontinuierlich erfolgen. Hierbei kann die kontinuierliche Zugabe einmalig während der Alkoxylierungsreaktion durchgeführt werden oder mehrmalig. Bevorzugt erfolgt die Zugabe von Startern (2) kontinuierlich. Insbesondere bevorzugt erfolgt die Zugabe von Startern (2) einmalig und dann in kontinuierlicher Art und Weise.

Des Weiteren ist es vorteilhaft, wenn die Dosage der Starter (2) beendet ist, bevor die Gesamtmenge an Alkylenoxiden oder Glycidylethern der Formel (IV) und/oder (V) dem Reaktionsgemisch zugeführt worden ist, da so eine quantitative Umsetzung der Starter (2) zu Verbindungen der Formel (IIa) gewährleistet werden kann.
Auch die Dosagegeschwindigkeit des Starters (2) kann je nach den entsprechenden Bedürfnissen im breiten Rahmen variiert werden, ohne die Eigenschaften der Produktgemische gemäß Formel (I) negativ zu beeinflussen.
Sollen mehrere unterschiedliche Starter (2) dem Reaktionsgemisch zugesetzt werden, so ist es möglich die Verbindungen vor der Dosage zu mischen und diese dann als Gemisch kontinuierlich oder diskontinuierlich zuzusetzen, es ist aber auch möglich alle Starter (2) separat kontinuierlich oder diskontinuierlich dem Reaktionsgemisch zuzuführen. Hierbei ist es überdies möglich zunächst den ersten Starter (2) zuzusetzen und anschließend in einer zweiten Portion einen andersartigen Starter (2). Falls weitere Zugabeschritte erwünscht sind so ist es im Folgenden möglich erneut den ersten Starter (2) zuzusetzen und so quasi - falls dann wieder die zweite Verbindung folgt - ein alternierendes Additionsprotokoll zu realisieren, es kann aber auch jedweder andere Starter (II) in einer oder mehreren Portionen zugesetzt werden.

Auch die Konzentration der zudosierten Starter (2) im Verhältnis zur Molmenge des eingesetzten Starters (1) ist in weiten Grenzen variierbar. So beträgt das Molverhältnis aller eingesetzten Startmoleküle (1) zu allen zugesetzten Startern (2) bevorzugt zwischen 1 : 0,001 und 0,001 : 1, weiter bevorzugt zwischen 1 : 0,01 und 0,01 : 1 und insbesondere bevorzugt zwischen 1 : 0,1 und 0,1 : 1.

Die Funktionalität der eingesetzten Starter (1) und (2), sprich der Wert von t der Starter (H-D^{A})ₜ-D^{X} ist in weiten Grenzen frei wählbar. Bevorzugt ist t (Starter (1)) >= t (Starter (2)). In einer besonders vorteilhaften Ausführungsform der Erfindung ist t (Starter (1)) > t (Starter (2)) Insbesondere bevorzugt ist, wenn t (Starter (1)) um den Wert 1 größer ist als t (Starter (2)).

Nach der Monomer-Addition und eventueller Nachreaktion zur Vervollständigung des Monomerumsatzes werden evtl. vorhandene Reste von nicht abreagiertem Monomer und eventuell weiteren leicht flüchtigen Bestandteilen, üblicherweise durch Vakuumdestillation, Gasstrippen oder andere Methoden der Desodorierung entfernt. Die Entfernung leichtflüchtiger Nebenkomponenten kann sowohl diskontinuierlich (batchweise) als auch kontinuierlich erfolgen. Beim erfindungsgemäßen Verfahren auf Basis der DMC-Katalyse kann im Normalfall auf eine Filtration verzichtet werden.

Die Verfahrensschritte können bei identischen oder verschiedenen Temperaturen ausgeführt werden. Die im Reaktor zum Reaktionsstart vorgelegte Mischung aus Startsubstanz, DMC-Katalysator und gegebenenfalls Suspensionsmittel kann vor Beginn der Monomerdosierung gemäß der Lehre von WO 98/52689 durch Strippen vorbehandelt werden. Dabei wird über die Reaktorzuführung ein Inertgas dem Reaktionsgemisch zugemischt und mit Hilfe einer an das Reaktorsystem angeschlossenen Vakuumanlage werden leichter flüchtige Komponenten durch Anlegen eines Unterdrucks aus dem Reaktionsgemisch entfernt. Auf diese einfache Weise können aus dem Reaktionsgemisch Stoffe, die den Katalysator inhibieren können, wie z. B. niedere Alkohole oder Wasser, entfernt werden. Die Zugabe von Inertgas und das gleichzeitige Entfernen der leichter flüchtigen Komponenten kann insbesondere beim Anfahren/Starten der Reaktion von Vorteil sein, da durch die Zugabe der Reaktanden oder durch Nebenreaktionen auch inhibierende Verbindungen in das Reaktionsgemisch gelangen können.

Als Doppelmetallcyanidkatalysatoren (DMC-Katalysatoren) werden im erfindungsgemäßen Verfahren vorzugsweise die in EP 2 093 244 beschriebenen, insbesondere die dort als bevorzugt bzw. besonders bevorzugt beschriebenen DMC-Katalysatoren eingesetzt.

Im Reaktionsgemisch liegt die Katalysatorkonzentration vorzugsweise bei > 0 bis 1.000 wppm (Massen-ppm), bevorzugt bei > 0 bis 500 wppm, besonders bevorzugt bei 0,1 bis 300 wppm und ganz besonders bevorzugt bei 1 bis 200 wppm.

Diese Konzentration ist dabei bezogen auf die Gesamtmasse der entstehenden Alkoxylierungsprodukte.
Vorzugsweise wird der Katalysator nur einmal in den Reaktor dosiert. Die Katalysatormenge ist so einzustellen, dass eine ausreichende katalytische Aktivität für das Verfahren gegeben ist. Der Katalysator kann als Feststoff oder in Form einer Katalysatorsuspension dosiert werden. Wird eine Suspension verwendet, so eignet sich insbesondere der Starter D^{X} als Suspensionsmittel. Bevorzugt wird aber auf eine Suspendierung verzichtet.

Es kann vorteilhaft sein, wenn der Verfahrensschritt A des erfindungsgemäßen Verfahrens so durchgeführt wird, dass die Alkoxylierung in zumindest drei Stufen durchgeführt wird. In Stufe 1 wird die Starter (1) mit einer kleinen Menge Propylenoxid in Gegenwart des DMC-Katalysators wie zuvor beschrieben zur Reaktion gebracht. Anschließend wird weiter Propylenoxid angelagert, wobei hierdurch bevorzugt maximal eine Molmasse von 500 bis 10 000 g/mol, besonders bevorzugt maximal 1000 bis 3 000 g/mol zusätzlich zum genutzten Starter aufgebaut wird.
In Stufe 2 erfolgt die Zugabe von weiterem Propylenoxid und/oder Ethylenoxid unter Zugabe mindestens eines Starters (2) und gegebenenfalls einem oder mehrerer der oben genannten Glycidylether der Formel (IV); in Stufe 3 erfolgt die Zugabe von einer oder mehrerer der Verbindungen der Formel (V) gegebenenfalls unter weiterer Zugabe von Propylenoxid und/oder Ethylenoxid; wobei die Stufen 2 und 3 auch zu einer Stufe zusammengefasst werden können.
In einer besonderen Ausführungsform des beanspruchten Verfahrens ist es aber auch möglich die zuvor beschriebenen Stufen 2 und 3 zusammenzufassen und gleichzeitig mindestens einen Starter (2) gemeinsam mit einer oder mehrerer der Verbindungen der Formel (V) gegebenenfalls unter weiterer Zugabe von Propylenoxid und/oder Ethylenoxid zu dosieren.
In einer weiteren bevorzugten Ausführungsform des beanspruchten Verfahrens ist es auch möglich vor der Stufe 3 noch eine Stufe 2b einzuführen, in der ausschließlich Alkylenoxide bevorzugt Propylenoxid und/oder Ethylenoxid gegebenenfalls zusammen mit Glycidylethern der Formel (IV) zudosiert werden. Durch die Anlagerung einer Mischung aus Verbindung der Formel (V) und Propylenoxid in Stufe 3 wird die Alkoxysilanfunktionalität statistisch über die Polymerketten/die Polymerblöcke eingebracht. Die Reihenfolge der Durchführung der Stufen 2 und 3 ist beliebig. Vorzugsweise wird nach Stufe 1 zuerst Stufe 2 durchgeführt bevor Stufe 3 durchgeführt wird. Die Stufen 2 und 3 können mehrfach nacheinander durchgeführt werden. Bei der mehrmaligen Durchführung der Stufen 2 und 3 können die eingesetzten Alkylenoxide sowie der Komponenten der Formeln (IV), (V) sowie der Starter (2) gleich oder verschieden sein. Die zuvor beschriebene detaillierte Verfahrensbeschreibung dient lediglich der besseren Veranschaulichung und repräsentiert eine bevorzugte Dosagereihenfolge der Reaktionsteilnehmer. Hieraus darf kein strickt blockweiser Aufbau der erfindungsgemäßen Alkoxylierungsprodukte mit reduzierter Viskosität abgeleitet werden.
Stufe 1 wird vorzugsweise bei einer Temperatur von 70 - 160 °C, bevorzugt bei 80 - 150 °C, besonders bevorzugt bei einer Temperatur von 100 - 145°C, insbesondere bevorzugt bei 110 - 130 °C durchgeführt. Stufe 2 wird vorzugsweise bei einer Temperatur von 70 - 160 °C, bevorzugt bei 80 - 150 °C, besonders bevorzugt bei einer Temperatur von 100 - 145°C, insbesondere bevorzugt bei 110 - 130 °C durchgeführt. Stufe 3 wird vorzugsweise bei einer Temperatur von 70 - 140 °C, bevorzugt bei 75 - 120 °C, besonders bevorzugt bei einer Temperatur von 80 - 110°C durchgeführt. Werden die Stufen 2 und 3 zusammengefasst so ist die Reaktionstemperatur, der unter Stufe 3 bevorzugten Temperatur anzupassen.

### Verfahrensschritt B:

Es kann vorteilhaft sein, wenn anschließend ein Verfahrensschritt B durchgeführt wird, bei dem die endständige(n) OH-Gruppe(n) des Alkoxylierungsproduktes so umgesetzt wird/werden, dass keine freie OH-Gruppe mehr vorhanden ist.

In einer bevorzugten Ausführungsform des Verfahrensschritts B kann die Umsetzung mit Silanol-Bildnern oder Monoisocyanaten, bevorzugt mit einem Monoisocyanat durchgeführt werden, wie in der Anmeldung EP 2415797 (US 2012/029090) beschrieben.
Als geeignete Monoisocyanate können im einfachsten Fall Alkyl-, Aryl-, Arylalkylisocyanate eingesetzt werden. Bevorzugt können Methyl-, Ethyl-, Butyl-, Hexyl-, Octyl-, Dodecyl- und Stearylisocyanat eingesetzt werden, insbesondere bevorzugt ist Butylisocyanat.
Besonders geeignete monofunktionelle Isocyanate sind auch solche, die ihrererseits vernetzbare Alkoxysilylgruppen im Molekül tragen. Hierzu gehören bevorzugt Isocyanatoalkyl-trialkoxysilane und Isocyanatoalkyl-alkyldialkoxysilane.

Als geeignete alkoxysilanfunktionelle Monoisocyanate können Isocyanatotrimethoxysilan, Isocyanatomethyltriethoxysilan, (Isocyanatomethyl)methyldimethoxysilan, (Isocyanatomethyl)methyldiethoxysilan, 3-Isocyanatopropyltrimethoxysilan, 3-Isocyanatopropyl-methyldimethoxysilan, 3-Isocyanatopropyltriethoxysilan und 3-Isocyanatopropylmethyl-diethoxysilan eingesetzt werden. Bevorzugt ist hier die Verwendung von 3-Isocyanatopropyltrimethoxysilan und -triethoxysilan.

In einer weiteren besonders bevorzugten Ausführungsform des Verfahrensschritts B zur Herstellung der erfindungsgemäßen Alkoxylierungsprodukte mit intrinsisch reduzierter Viskosität der Formel (I) zeichnet sich dadurch aus, dass in einem ersten Umsetzungsschritt (a) Polyether der Formel PE mit Diisocyanaten umgesetzt werden und in einem zweiten Umsetzungsschritt (b) das Produkt/Produktgemisch des ersten Umsetzungsschrittes (a) mit einem Moleküle der Formel H-M umgesetzt werden. Die Polyether der Formel PE sind oben beschrieben. Die Moleküle der Formel H-M sind Verbindungen enthaltend Wasserstoff gebunden an das Fragment M, welches oben beschrieben ist.

Bevorzugt werden im erfindungsgemäßen Verfahren die Diisocyanate im molaren Überschuss gegenüber den OH-Gruppen der Polyether resultierend aus t Starter (1) plus t (Starter 2) eingesetzt, d.h. t Starter (1) + t (Starter 2) < c(Diisocyanat).

In einer weiteren besonders bevorzugten Ausführungsform des Verfahrensschritts B zur Herstellung der erfindungsgemäßen Alkoxylierungsprodukte mit intrinsisch reduzierter Viskosität der Formel (I) können, wird eine quantitative Umsetzung sowohl der terminalen OH-Funktionen des Polyethers, als auch der Isocyanatgruppen der Polyisocyanate angestrebt.
Nach diesem Reaktionsprinzip können also über ein entsprechendes Polyisocyanat, je nach Anzahl der Isocyanatgruppen im Polyisocyanat Di-, Tri- oder Tetramere der Alkoxysilylpolyetherfragmente M aufgebaut werden.

Weiterhin werden in der besonders bevorzugten Ausführungsform des Umsetzungsschritts (b) des Verfahrensschritts B des erfindungsgemäßen Verfahrens die Alkoxylierungsprodukte (1) und (2) so gewählt, dass im Produkt mehr Alkoxysilylgruppen als Guppen UR enthalten sind.

Bevorzugt werden die beiden Umsetzungen (a) und (b) zeitlich voneinander getrennt durchgeführt. Dabei werden bevorzugt zunächst die Alkoxylierungsprodukte (1) und (2) mit den Diisocyanaten umgesetzt. In diesem Schritt bestimmen die stöchiometrischen Verhältnisse die Anzahl der UR-Fragmente im Produkt. Im zweiten Umsetzungsschritt (b) werden die nicht abreagierten Isocyanatgruppen bevorzugt mit dem Molekül H-M umgesetzt. Für den Fall, dass es sich bei Starter (2) um einen Starter mit nur einer OH-Gruppe handelt, kann H-M bevorzugt Alkoxylierungsprodukt (2) sein.
Die Umsetzung mit dem Molekül H-M entspricht einem Endcapping-Verfahren. Es wird mit diesem Umsetzungsschritt angestrebt, bevorzugt alle Isocyanatgruppen zur Abreaktion zu bringen.

Der Verfahrensschritt B des erfindungsgemäßen Verfahrens zur Herstellung von Alkoxysilylverbindungen gemäß Formel (I) wird bevorzugt mit Isophorondiisocyanat in Gegenwart eines Übergangsmetallkatalysators durchgeführt und detailliert in der noch unveröffentlichten Patentanmeldung DE 10 2012 203737 beschrieben. Prinzipiell eignen sich jedoch alle bekannten Isocyanate als isocyanatgruppenhaltige Verbindungen. Bevorzugt im Sinne der erfindungsgemäßen Lehre sind z.B. aromatische, aliphatische und cycloaliphatische Polyisocyanate mit einer zahlenmittleren Molmasse von unter 800 g/mol. So sind beispielsweise geeignet Diisocyanate aus der Reihe 2,4-/2,6-Toluoldiisocyanat (TDI), Methyldiphenyldiisocyanat (MDI), Triisocyanatononan (TIN), Naphthyldiisocyanat (NDI), 4,4'-Diisocyanatodicyclohexylmethan, 3-Isocyanatomethyl-3,3,5-trimethylcyclohexylisocyanat (Isophorondiisocyanat = IPDI), Tetramethylendiisocyanat, Hexamethylendiisocyanat (HDI), 2-Methylpentamethylendiisocyanat, 2,2,4-Trimethyl-hexamethylendiisocyanat (THDI), Dodecamethylendiisocyanat, 1,4-Diisocyanato-Cyclohexan, 4,4'-Diisocyanato-3,3'-dimethyl-dicyclohexylmethan, 4,4'-Diisocyanatodicyclohexylpropan-(2,2), 3-Isocyanatomethyl-1-methyl-1-isocyanatocyclohexan (MCI), 1,3-Diisooctylcyanato-4-methyl-cyclohexan, 1,3-Diisocyanato-2-methyl-cyclohexan und α,α,α',α'-Tetramethyl-m- oder -p-xylylen-diisocyanat (TMXDI), sowie aus diesen Verbindungen bestehende Gemische.
Als bevorzugte Diisocyanate für die Herstellung der Alkoxylierungsprodukte gemäß Formel (I) können Hexamethylendiisocyanat (HDI), Isophorondiisocyanat (IPDI) und/oder 4,4'-Diisocyanatodicyclohexylmethan eingesetzt werden, insbesondere kann bevorzugt Isophorondiisocyanat (IPDI) eingesetzt werden. Ebenfalls geeignet als isocyanathaltige Ausgangskomponenten sind Umsetzungsprodukte der zuvor erwähnten Isocyanate mit sich selbst oder untereinander zu Uretdionen oder Isocyanuraten. Beispielhaft seien genannt Desmodur® N3300, Desmodur® N3400 oder Desmodur® N3600 (alle BayerMaterialScience, Leverkusen,DE). Weiterhin geeignet sind auch Derivate von Isocyanaten, wie Allophanate oder Biurete. Beispielhaft genannt seien Desmodur® N100, Desmodur® N75MPA/BA oder Desmodur® VPLS2102 (alle BayerMaterialScience, Leverkusen,DE).

Die Schriften EP 2415797 (US 2012/029090), deren Offenbarung in Bezug auf die dort offenbarten Verfahren sind hiermit vollumfänglich als Bestandteil dieser Anmeldung zu sehen.

Es kann vorteilhaft sein, wenn der Verfahrensschritt B so durchgeführt wird, dass > 20 Gew.-%, bevorzugt > 50 Gew.-% und besonders bevorzugt > 75 Gew.-% der erhaltenen Alkoxylierungsprodukte keine freie OH-Gruppe mehr aufweist.

Die erfindungsgemäßen Alkoxylierungsprodukte können z. B. zur Herstellung von härtbaren Zusammensetzungen verwendet werden.

Erfindungsgemäße härtbare Zusammensetzungen zeichnen sich dadurch aus, dass sie eines oder mehrere der oben beschriebenen erfindungsgemäßen Alkoxylierungsprodukte der Formel (I) und zumindest einen Härtungskatalysator aufweisen.

Es kann vorteilhaft sein, wenn die erfindungsgemäße Zusammensetzung nur Alkoxylierungsprodukte der Formel (I) mit i = 2, j = 1 bis 4, k = 0, l = 0, u = (j + 1) und v = 0 bis 4 wie oben definiert und keine Alkoxylierungsprodukte der Formel (I) aufweist, bei denen i = 0, j = 1, k = 0, l = 0, u = 0 und v = 0 ist.

Es kann aber auch vorteilhaft sein, wenn die erfindungsgemäße Zusammensetzung neben Alkoxylierungsprodukten der Formel (I) mit i = 1 bis 2, j = 1 bis 4, k = 0, l = 0, u = (j + 1) und v = 0 bis 4 wie oben definiert auch solche Alkoxylierungsprodukte der Formel (I) aufweist, bei denen i = 0, j = 1, k = 0, l = 0, u = 0 und v = 0 ist. Liegen beide Arten von Alkoxylierungsprodukten in der erfindungsgemäßen Zusammensetzung vor, so beträgt das Massenverhältnis (Verhältnis der Massenteile) von Alkoxylierungsprodukten der Formel (I) mit i = 1 bis 2, j = 1 bis 4, k = 0, l = 0, u = (j + 1) und v = 0 bis 4 zu Alkoxylierungsprodukten der Formel (I), bei denen denen i = 0, j = 1, k = 0, l = 0, u = 0 und v = 0 ist, von 100:>0 bis 10:90, bevorzugt zwischen 95:5 und 15:85 und besonders bevorzugt zwischen 80:20 und 30:70. Vorzugsweise weisen auch die Alkoxylierungsprodukte der Formel (I), bei denen i = 0, j = 1, k = 0, l = 0, u = 0 und v = 0 ist, als Alkoxysilygruppen überwiegend oder ausschließlich, vorzugsweise ausschließlich Ethoxysilylgruppen, bevorzugt Triethoxysilylgruppen auf.

Es kann aber auch vorteilhaft sein, wenn die erfindungsgemäße Zusammensetzung neben Alkoxylierungsprodukten der Formel (I) mit i = 1 bis 4, j = 0, k = 0, l = 0, u = 1 und v = 0 bis 2 wie oben definiert auch solche Alkoxylierungsprodukte der Formel (I) aufweist, bei denen i = 1, j = 0, k = 0, l = 0, u = 0 und v = 0 ist. Liegen beide Arten von Alkoxylierungsprodukten in der erfindungsgemäßen Zusammensetzung vor, so beträgt das Massenverhältnis (Verhältnis der Massenteile) von Alkoxylierungsprodukten der Formel (I) mit i = 1 bis 2, j = 0, k = 0, l = 0, u = 1 und v = 0 bis 4 zu Alkoxylierungsprodukten der Formel (I), bei denen mit i = 1, j = 0, k = 0, l = 0, u = 0 und v = 0 und v = 0 ist, von 100:>0 bis 10:90, bevorzugt zwischen 95:5 und 15:85 und besonders bevorzugt zwischen 80:20 und 30:70. Vorzugsweise weisen auch die Alkoxylierungsprodukte der Formel (I), bei denen denen i = 0, j = 1, k = 0, l = 0, u = 0 und v = 0 ist, als Alkoxysilygruppen überwiegend oder ausschließlich, vorzugsweise ausschließlich Ethoxysilylgruppen, bevorzugt Triethoxysilylgruppen auf.

Der Anteil der erfindungsgemäßen Alkoxylierungsprodukte an der erfindungsgemäßen Zusammensetzung beträgt vorzugsweise von 10 bis kleiner 90 Gew.-%, bevorzugt von 15 bis 70 Gew.-%, und besonders bevorzugt von 20 Gew.-% bis 65 Gew.-%.

Als Härtungs-Katalysatoren (für die Vernetzung oder Polymerisation der erfindungsgemäßen Zusammensetzung oder deren chemische Fixierung auf Partikel- oder makroskopischen Oberflächen) können die üblicherweise zur Hydrolyse und Kondensation von Alkoxysilanen eingesetzten Katalysatoren eingesetzt werden. Vorzugsweise werden als Härtungs-Katalysatoren organischen Zinnverbindungen, wie z.B. Dibutylzinndilaurat, Dibutylzinndiacetylacetonat, Dibutylzinndiacetat, Dibutylzinndioctoat, oder Dioctylzinndilaurat, Dioctylzinndiacetylacetonat, Dioctylzinndiketanoat, Dioctylstannoxan, Dioctylzinndicarboxylat, Dioxtylzinnoxid, bevorzugt Dioctylzinndiacetylacetonat, Dioctylzinndilaurat, Dioctylzinndiketanoat, Dioctylstannoxan, Dioctylzinndicarboxylat, Dioctylzinnoxid, besonders bevorzugt Dioctylzinndiacetylacetonat und Dioctylzinndilaurat eingesetzt. Des Weiteren können auch Zinksalze, wie Zinkoctoat, Zinkacetylacetonat und Zink-2-ethylcaproat, oder Tetraalkylammoniumverbindungen, wie N,N,N-Trimethyl-N-2-hydroxypropylammoniumhydroxid, N,N,N-Trimethyl-N-2-hydroxypropylammonium-2-ethylhexanoat oder Cholin-2-ethylhexanoat verwendet werden. Bevorzugt ist die Verwendung von Zinkoctoat (Zink-2-ethylhexanoat) und der Tetraalkylammoniumverbindungen, besonders bevorzugt diejenige von Zinkoctoat. Des Weiteren können auch Wismutkatalysatoren, z.B. Borchi®-Katalysatoren, Titanate, z.B. Titan(IV)isopropylat, Eisen(III)-Verbindungen, z.B. Eisen(III)-acetylacetonat, Aluminiumverbindungen, wie Aluminiumtriisopropylat, Aluminiumtrisec-butylat und andere Alkoholate sowie Aluminiumacetylacetonat, Calciumverbindungen, wie Calciumdinatriumethylendiamintetraacetat oder Calciumdiacetylacetonat, oder auch Amine, z.B. Triethylamin, Tributylamin, 1,4-Diazabicyclo[2,2,2]octan, 1,8-Diazabicyclo[5.4.0]undec-7-en, 1,5-Diazabicyclo[4.3.0]non-5-en, N,N-Bis-(N,N-dimethyl-2-aminoethyl)-methylamin, N,N-Dimethylcyclohexylamin, N,N-Dimethylphenylamin, N-Ethylmorpholin etc., eingesetzt werden. Auch organische oder anorganische Brönstedsäuren wie Essigsäure, Trifluoressigsäure, Methansulfonsäure, p-Toluolsulfonsäure oder Benzoylchlorid, Salzsäure, Phoshorsäure deren Mono- und/oder Diester, wie z.B. Butylphosphat, (Iso-)Propylphosphat, Dibutylphosphat etc., sind als Katalysatoren geeignet. Selbstverständlich können auch Kombinationen mehrerer Katalysatoren eingesetzt werden.

Der Anteil der Härtungs-Katalysatoren an der erfindungsgemäßen Zusammensetzung beträgt vorzugsweise von 0,1 Gew.-% bis 5 Gew.-%, bevorzugt von 0,15 bis 2 Gew.-% und besonders bevorzugt von 0,2 bis 0,75 Gew.-%, bezogen auf die Gesamtzusammensetzung.

Die erfindungsgemäße Zusammensetzung kann weitere Zusatzstoffe ausgewählt aus der Gruppe der Weichmacher, Füllstoffe, Lösungsmittel, Haftvermittler, Additive zur Anpassung des Fließverhaltens, sogenannten Rheologieadditiven und Trocknungsmittel, insbesondere chemische Feuchtigkeits-Trocknungsmittel enthalten.

Vorzugsweise enthält die erfindungsgemäße Zusammensetzung einen oder mehrere Haftvermittler und/oder ein oder mehrere Trocknungsmittel, insbesondere chemische Feuchtigkeits-Trocknungsmittel.

Als Haftvermittler können die aus dem Stand der Technik bekannten Haftvermittler, insbesondere Aminosilane in der erfindungsgemäßen Zusammensetzung enthalten sein. Als Haftvermittler können vorzugsweise Alkoxysilyl-Gruppen tragende Verbindungen die zusätzlich über primäre oder sekundäre Amingruppen, Vinylgruppen, Thiolgruppen, Arylgruppen oder alternativ Oxirangruppen verfügen, wie 3-Aminopropyltrimethoxysilan (Dynasylan® AMMO (Evonik), N-(2-Aminoethyl)-3-aminopropyltrimethoxysilan (Dynasylan® DAMO (Evonik)), N-(n-Butyl)aminopropyltrimethoxysilan (Dynasylan® 1189 (Evonik)), 3-Mercaptopropyltrimethoxysilan (Dynasylan® MTMO, Evonik), 3-Glycidyloxypropyltriethoxysilan (Dynasylan® GLYEO, Evonik) 3-Glycidyloxypropyltrimethoxysilan (Dynasylan® GLYMO, Evonik), Phenyltrimethoxysilan (Dynasylan® 9165 oder Dynasylan® 9265, Evonik) oder oligomere Amino/Alkyl-Alkoxysilane wie z.B. Dynasylan® 1146 (Evonik), jeweils alleine oder in Mischung eingesetzt werden. Bevorzugte vorhandene Haftvermittler sind z. B. 3-Aminopropyltriethoxysilan (Geniosil® GF 93 (Wacker), Dynasylan® AMEO (Evonik®)) und/oder (3-Aminopropy)methyldiethoxysilan (Dynasylan® 1505 (Evonik®)), 3-Aminopropyltrimethoxysilan (Dynasylan® AMMO (Evonik), N-(2-Aminoethyl)-3-aminopropyltrimethoxysilan (Dynasylan® DAMO (Evonik)), Dynasylan® 1146 (Evonik), besonders bevorzugt 3-Aminopropyltriethoxysilan, 3-Aminopropyltrimethoxysilan, N-(2-Aminoethyl)-3-aminopropyltrimethoxysilan, Dynasylan® 1146, und insbesondere bevorzugt sind 3-Aminopropyltrimethoxysilan, 3-Aminopropyltriethoxysilan, N-(2-Aminoethyl)-3-aminopropyltrimethoxysilan und Dynasylan® 1146.
Der Anteil der Haftvermittler an der erfindungsgemäßen Zusammensetzung beträgt vorzugsweise von größer 0 bis 5 Gew.-%, bevorzugt von 0,5 bis 4 Gew.-% und besonders bevorzugt von 1 bis 2,5 Gew.-% bezogen auf die Gesamtzusammensetzung.

Es kann vorteilhaft sein, wenn die erfindungsgemäße Zusammensetzung ein Trocknungsmittel aufweist, z. B. zum Binden von durch Formulierungskomponenten eingetragenen, oder nachträglich durch den Abfüllprozess oder die Lagerung eingebrachten Wassers oder Feuchtigkeit. Als Trocknungsmittel können in den erfindungsgemäßen Zusammensetzungen prinzipiell alle aus dem Stand der Technik bekannten Trocknungsmittel eingesetzt werden. Als chemische Trocknungsmittel kann z.B. Vinyltrimethoxysilan (Dynasylan® VTMO , Evonik oder Geniosil® XL 10, Wacker AG), Vinyltriethoxysilan (Dynasylan® VTEO, Evonik oder Geniosil® GF 56, Wacker), Vinyltriacetoxysilan (Geniosil® GF 62, Wacker), N-Trimethoxysilylmethyl-O-methyl-carbamat (Geniosil® XL 63, Wacker), N-Dimethoxy(methyl)silylmethyl-O-methyl-carbamat, N-Methyl[3-(Trimethoxysilyl)-propyl]carbamat (Geniosil® GF 60, Wacker), Vinyldimethoxymethylsilan (Geniosil® XL 12, Wacker), Vinyltris(2-methoxyethoxy)silan (Geniosil® GF 58, Wacker) Bis(3-triethoxysilylpropyl)amin (Dynasylan® 1122, Evonik), Bis(3-trimethoxysilylpropyl)amin (Dynasylan® 1124), N-Dimethoxy(methyl)silylmethyl-O-methyl-carbamat (Geniosil® XL 65, Wacker) oder oligomere Vinylsilane wie beispielsweise Dynasylan® 6490 und Dynasylan® 6498 (beide zu beziehen von Evonik) alleine oder in Mischung verwandt werden. Vorzugsweise werden Vinyltrimethoxysilan (Dynasylan® VTMO , Evonik oder Geniosil® XL 10, Wacker AG), Vinyltriethoxysilan (Dynasylan® VTEO, Evonik oder Geniosil® GF 56, Wacker) als Trocknungsmittel eingesetzt. Als chemisches Feuchtigkeits-Trocknungsmittel enthält die erfindungsgemäße Zusammensetzung bevorzugt Vinyltrimethoxysilan (Dynasylan® VTMO , Evonik oder Geniosil® XL 10, Wacker AG). Ferner kann zusätzlich oder alternativ zur chemischen Trocknung ein physikalisches Trocknungsmittel, wie z.B. Zeolithe, Molsiebe, wasserfreies Natriumsulfat oder wasserfreies Magnesiumsulfat verwendet werden.

Der Anteil der Trocknungsmittel an der erfindungsgemäßen Zusammensetzung beträgt vorzugsweise von größer 0 bis 5 Gew.-%, bevorzugt von 0,2 bis 3 Gew.-% bezogen auf die Gesamtzusammensetzung.

Die erfindungsgemäße Zusammensetzung kann einen oder mehrere Zusatzstoffe ausgewählt aus der Gruppe der Weichmacher, Füllstoffe, Lösungsmittel und Additive zur Anpassung des Fließverhaltens (Rheologieadditive) enthalten.

Die Weichmacher können z. B. ausgewählt werden aus der Gruppe der Phthalate, der Polyester, Alkylsulfonsäureester des Phenols, Cyclohexandicarbonsäureester oder auch der Polyether. Als Weichmacher werden nur solche Verbindungen eingesetzt, die von den erfindungsgemäßen Alkoxylierungsprodukten der Formel (I) verschieden sind.

Wenn Weichmacher in der erfindungsgemäßen Zusammensetzung vorhanden sind, beträgt der Anteil der Weichmacher an der erfindungsgemäßen Zusammensetzung vorzugsweise von größer 0 Gew.-% bis 90 Gew.-%, bevorzugt 2 Gew.-% bis 70 Gew.-%, besonders bevorzugt 5 Gew.-% bis 50 Gew.-% bezogen auf die Gesamtzusammensetzung.

Als Füllstoffe können z. B. gefällte oder gemahlene Kreide, anorganische Carbonate im allgemeinen, gefällte oder gemahlene Silikate, gefällte oder pyrogene Kieselsäuren, Glaspulvern, Glashohlkugeln (sog. Bubbles), Metalloxiden, wie z.B. TiO₂, Al₂O₃, natürliche oder gefällte Bariumsulfate verstärkende Fasern, wie Glasfasern oder Kohlefasern, lang oder kurzfaserige Wollastonite, Kork, Ruß oder Graphit eingesetzt werden. Vorteilhaft können hydrophobierte Füllstoffe eingesetzt werden, da diese Produkte einen geringeren Wassereintrag aufweisen und die Lagerstabilität der Formulierungen verbessern.

Wenn Füllstoffe in der erfindungsgemäßen Zusammensetzung vorhanden sind, beträgt der Anteil der Füllstoffe an der erfindungsgemäßen Zusammensetzung vorzugsweise von 1 bis 70 Gew.-% bezogen auf die Gesamtzusammensetzung, wobei für die hier genannten Füllstoffe mit Ausnahme der pyrogenen Kieselsäuren Konzentrationen von 30 bis 65 Gew.-% besonders bevorzugt sind. Werden pyrogene Kieselsäuren verwendet ist ein Anteil der pyrogenen Kieselsäuren von 2 bis 20 Gew.-% besonders bevorzugt.

Als Rheologieadditive, vorzugsweise zusätzlich zum Füllstoff enthalten, können aus der Gruppe der Amidwachse, zu beziehen z.B. von Cray Valley unter dem Markennamen Crayvallac®, gehärtete Pflanzenöle und Fette, pyrogene Kieselsäuren, wie z.B. Aerosil® R202 oder R805 (beide zu beziehen von Evonik) oder Cab-O-Sil® TS 720 oder TS 620 oder TS 630 (vertrieben von Cabot) ausgewählt werden. Werden pyrogene Kieselsäuren bereits als Füllstoff verwendet, kann die Zugabe eines Rheologieadditivs entfallen.

Wenn Rheologieadditive in der erfindungsgemäßen Zusammensetzung vorhanden sind, beträgt der Anteil der Rheologieadditive an der erfindungsgemäßen Zusammensetzung je nach gewünschtem Fließverhalten vorzugsweise von größer 0 Gew.-% bis 10 Gew.-%, bevorzugt von 2 Gew.-% bis 6 Gew.-% bezogen auf die Gesamtzusammensetzung.

Die erfindungsgemäßen Zusammensetzungen können Lösungsmittel enthalten. Die Lösungsmittel können dabei beispielsweise der Erniedrigung der Viskosität der unvernetzten Mischungen dienen oder das Aufziehen auf die Oberfläche begünstigen. Als Lösungsmittel kommen prinzipiell sämtliche Lösungsmittel sowie Lösemittelmischungen in Betracht. Bevorzugte Beispiele für solche Lösungsmittel sind Ether wie z.B. t-Butyl-methylether, Ester, wie z.B. Ethylacetat oder Butylacetat oder Diethylcarbonat sowie Alkohole, wie z.B. Methanol, Ethanol sowie die verschiedenen Regioisomere des Propanols und Butanols oder auch anwendungsspezifisch ausgewählte Glykoltypen. Weiterhin können aromatische und/oder aliphatische Lösemittel wie auch halogenierte Lösemittel, wie z.B. Dichlormethan, Chloroform, Tetrachlormethan, Fluorkohlenwasserstoffe (FREON) u.a.m zum Einsatz kommen, aber auch anorganische Lösemittel wie beispielsweise Wasser, CS₂, überkritisches CO₂ u.a.m..

Bei Bedarf können die erfindungsgemäßen Zusammensetzungen außerdem eine oder mehrere Substanzen, ausgewählt aus der Gruppe umfassend Co-Vernetzer, Flammschutzmittel, Entlüfter, antimikrobielle und konservierende Stoffe, Farbstoffe, Färbemittel und Pigmente, Frostschutzmittel, Fungizide und/oder Reaktivverdünner sowie Komplexbildner, Sprühhilfsmittel, Netzmittel, Duftstoffe, Lichtschutzmittel, Radikalfänger, UV-Absorber und Stabilisatoren, insbesondere Stabilisatoren gegen thermische und/oder chemische Belastungen und/oder Belastungen durch ultraviolettes und sichtbares Licht, enthalten.

Als UV-Stabilisatoren können z. B. bekannte Produkte auf Basis gehinderter Phenolischer Systeme eingesetzt werden. Als Licht-Stabilisatoren können z. B. sogenannte HALS-Amine eingesetzt werden. Als Stabilisatoren können z. B. die dem Fachmann bekannten Produkte oder Produktkombinationen aus z.B. Tinuvin®-Stabilisatoren (Ciba), wie z. B. Tinuvin®-Stabilisatoren (Ciba), beispielsweise Tinuvin® 1130, Tinuvin® 292 oder auch Tinuvin® 400, bevorzugt Tinuvin® 1130 in Kombination mit Tinuvin® 292 eingesetzt werden. Ihre Einsatzmenge richtet sich nach dem Grad der erforderlichen Stabilisierung.

Zusätzlich können den härtbaren Zusammensetzungen Covernetzer zur Steigerung von mechanischer Härte und Reduktion der Fließneigung beigemischt werden. Solche Covernetzer sind typischerweise Substanzen die in der Lage sind 3, 4 oder mehr vernetzungsfähige Gruppen zur Verfügung zu stellen. Beispiele im Kontext dieser Erfindung sind 3-Aminopropyltriethoxysilan, Tetramethoxysilan oder Tetraethoxysilan.

Bevorzugte erfindungsgemäße Zusammensetzungen weisen zumindest ein Alkoxylierungsprodukt der Formel (I) und einen Weichmacher, einen Füllstoff, einen Haftvermittler, ein Trocknungsmittel oder einen (Härtungs-)katalysator auf.

Besonders bevorzugte erfindungsgemäße Zusammensetzungen weisen von 10 bis 90 Gew.-% oder kleiner 80 Gew.-% bezogen auf die Gesamtzusammensetzung an Alkoyxlierungsprodukt der Formel (I), das vorzugsweise im Mittel zwischen 2,0 und 8,0, Ethoxysilyl-Funktionen pro Alkoyxlierungsprodukt der Formel (I) aufweist, von 0,3 Gew.-% bis 5,0 Gew.-%, bevorzugt von 0,5 Gew.-% bis 4,0 Gew.-%, und besonders bevorzugt von 1,0 Gew.-% bis 2,5 Gew.-% bezogen auf die Gesamtzusammensetzung an Haftvermittler, weniger als 30 Gew.-% bezogen auf die Gesamtzusammensetzung an Weichmacher, wobei besonders bevorzugt das Massenverhältnis von Alkoxylierungsprodukt der Formel (I) und Weichmacher weniger als das 1,1-fache des Alkoxylierungsprodukts der Formel (I) beträgt, von 1 bis 70 Gew.-% bezogen auf die Gesamtzusammensetzung an Füllstoffen, von 0,2 bis 3,0 Gew.-% bezogen auf die Gesamtzusammensetzung an chemischen Feuchtigkeits-Trocknungsmitteln und von 0,1 Gew.-% bis 5,00 Gew.-%, bevorzugt 0,2 bis 3,00 Gew.-% und insbesondere 0,1 bis 5 Gew.-% bezogen auf die Gesamtzusammensetzung an Härtungs-Katalysatoren, auf. Bei ganz besonders bevorzugten Zusammensetzungen sind die genannten Anteile der Formulierungsbestandteile so gewählt, dass sich die Gesamtsumme der Anteile auf 100 Gew.-% summiert.
Die erfindungsgemäßen Zusammensetzungen können z. B. Dicht- oder Klebstoff sein oder zur Herstellung eines Dicht- oder Klebstoffs verwendet werden.

Die erfindungsgemäße Zusammensetzung, insbesondere die so erhaltenen erfindungsgemäßen Zusammensetzung härtet in, zu bisher kommerziell verfügbaren und technisch eingesetzten Produkten vergleichbaren Zeiträumen aus, und vernetzt, so sie in dickeren Schichten appliziert wurde, auch sehr gut in die Tiefe. Die Flankenhaftung und Anbindung an verschiedene Substrate, wie beispielsweise Stahl, Aluminium, verschiedene Kunststoffe und mineralische Untergründe wie beispielsweise Stein, Beton und Mörtel, ist besonders gut.

Die erfindungsgemäßen Zusammensetzungen können insbesondere zur Verstärkung, Nivellierung, Modifikation, Verklebung, Abdichtung und/oder Beschichtung von Substraten verwendet werden. Geeignete Substrate sind z. B. partikuläre oder flächige Substrate, in der Bauindustrie oder im Fahrzeugbau, Konstruktionselemente, Bauteile, Metalle, insbesondere Konstruktionswerkstoffe wie Eisen, Stahl, Edelstahl und Gusseisen, keramische Materialien, insbesondere basierend auf festen Metall- oder Nichtmetalloxiden oder Carbiden, Aluminiumoxid, Magnesiumoxid oder Calciumoxid, mineralische oder organische Substrate, insbesondere Kork und/oder Holz, mineralische Untergründe, Span- und Faserplatten aus Holz oder Kork, Verbundwerkstoffe wie beispielsweise Holzverbundstoffe wie MDF-Platten (mitteldichte Faserplatten), WPC-Artikel (Wood Plastic Composites), Spanplatten, Korkartikel, laminierte Artikel, Keramiken, aber auch Naturfasern und Kunstfasern (aufweisende Substrate) oder Mischungen unterschiedlicher Substrate. Besonders bevorzugt werden die erfindungsgemäßen Zusammensetzungen zur Abdichtung und/oder Beschichtung von partikulären oder flächigen Substraten, in der Bauindustrie oder im Fahrzeugbau, zur Abdichtung und Verklebung von Konstruktionselementen und Bauteilen, sowie zur Beschichtung von porösen oder nicht-porösen, partikulären oder flächigen Substraten, zur Beschichtung und Modifikation von Oberflächen und zur Anwendungen auf Metallen, insbesondere auf Konstruktionswerkstoffe wie Eisen, Stahl, Edelstahl und Gusseisen, zur Anwendung auf keramischen Materialien, insbesondere basierend auf festen Metall- oder Nichtmetalloxiden oder Carbiden, Aluminiumoxid, Magnesiumoxid oder Calciumoxid, auf mineralischen Substraten oder organische Substraten, insbesondere auf Kork und/oder Holz, zur Bindung, Verstärkung und Nivellierung von unebenen, porösen oder brüchigen Substraten, wie z.B. mineralischen Untergründen, Span- und Faserplatten aus Holz oder Kork, Verbundwerkstoffe wie beispielsweise Holzverbundstoffe wie MDF-Platten (mitteldichte Faserplatten), WPC-Artikel (Wood Plastic Composites), Spanplatten, Korkartikel, laminierte Artikel, Keramiken, aber auch Naturfasern und Kunstfasern, oder Mischungen unterschiedlicher Substrate, verwendet.

Durch dieses breite Haftungsspektrum sind sie auch für die Verklebung von Materialkombinationen aus den genannten Substraten geeignet. Hierbei ist es nicht ausschlaggebend, ob die Oberflächen glatt oder angeraut oder porös sind. Angeraute oder poröse Oberflächen sind aufgrund der größeren Kontaktfläche zum Klebstoff zu bevorzugen.

Die erfindungsgemäßen Zusammensetzungen werden bevorzugt in einem Temperaturbereich von 10°C-40°C appliziert und härten auch unter diesen Bedingungen gut aus. Aufgrund des feuchtigkeitsabhängigen Härtungsmechanismus ist eine relative Luftfeuchtigkeit von min. 35% bis max. 75% für eine gute Härtung besonders bevorzugt. Die ausgehärtete Verklebung (Zusammensetzung) ist in einem Temperaturbereich von -10°C bis 80°C einsetzbar. Die mit den erfindungsgemäßen Zusammensetzungen hergestellten Verklebungen sind beständig gegen Wasser bei T<60°C und gegen nicht quellende Lösungsmittel. Nicht beständig ist die Verklebung gegen die Formulierung quellende Lösungsmittel, wie beispielsweise Methanol, Ethanol, Toluol, Tetrahydrofuran, Aceton, Isopropanol.

Die Quellbarkeit durch Ethanol, welches bei der Vernetzungsreaktion der Alkoxylierungsprodukte entsteht, ist eine grundlegende Voraussetzung, da das entstehende Ethanol auch innerhalb großer Flächenverklebungen die Härtung nicht behindert. Es wird zu den Rändern hin abtransportiert und dampft dort ab. Somit wird eine zügige Härtung der Flächenverklebung mit den erfindungsgemäßen Formulierungen gewährleistet.

In den nachfolgend aufgeführten Beispielen wird die vorliegende Erfindung beispielhaft beschrieben, ohne dass die Erfindung, deren Anwendungsbreite sich aus der gesamten Beschreibung und den Ansprüchen ergibt, auf die in den Beispielen genannten Ausführungsformen beschränkt sein soll.

### Beispiele:

### Allgemeines:

Die Viskosität wurde Scherraten-abhängig bei 25°C mit dem Rheometer MCR301 von Anton Paar in einer Platte-Platte-Anordnung mit einer Spaltbreite von 1 mm bestimmt. Der Durchmesser der oberen Platte betrug 40 mm. Die Viskosität bei einer Scherrate von 10 s⁻¹ wurde abgelesen und ist in den Tabellen 2 und 3 aufgeführt.

### Beispiel 1:

### Synthese eines PPG-basierten alkoxysilyl-funktionellen Polyethers - Eingesetzt für nicht erfindungsgemäße Formulierungen (Vergleichsbeispiel):

In einem 5 Liter Autoklaven wurden 353 g PPG 2000 vorgelegt und mit 150 ppm (bezogen auf den Gesamtansatz) eines Zinkhexacyanocobaltat-Doppelmetallcyanid-Katalysators versetzt. Zum Inertisieren wurde der Reaktor bis 3 bar mit Stickstoff beaufschlagt und anschließend auf Normaldruck entspannt. Der Vorgang wurde noch zweimal wiederholt. Unter Rühren wurde der Reaktorinhalt auf 130 °C erhitzt und auf ca. 20 mbar evakuiert, um leichtflüchtige Komponenten zu entfernen. Nach 30 min wurden zur Aktivierung des Katalysators 80 g Propylenoxid in den evakuierten Reaktor dosiert. Der Innendruck stieg zunächst auf ca. 0,8 bar an. Nach ca. 6 min sprang die Reaktion an, was sich durch einen Abfall im Reaktordruck bemerkbar machte. Nun wurden innerhalb von ca. 50 Minuten kontinuierlich 1218 g Propylenoxid zudosiert. Es schloß sich eine einstündige Nachreaktion an, während derer die Temperatur auf 95°C abgesenkt wurde. Bei dieser Temperatur wurde ein Gemisch aus 196 g Dynasylan® GLYEO (Firma Evonik) und 1233 g Propylenoxid kontinuierlich so zudosiert, dass die Temperatur konstant blieb. Nach einer erneuten einstündigen Nachreaktion wurde durch Anlegen eines Drucks (P < 100 mbar) desodoriert, um Reste an nicht umgesetztem Alkylenoxid zu entfernen. Anschließend wurden 500 ppm Irganox® 1135 (Firma BASF) für 15 Minuten eingerührt. Es wurde ein farbloses, hochviskoses Produkt erhalten. Die jeweiligen Molverhältnisse der eingesetzten Reaktanden bezogen auf 1 mol Starter sind Tabelle 2 zu entnehmen.

### Beispiel 2-15, 18 und 19:

### Synthese alkoxysilyl-funktioneller Polyether mit intrinsisch reduzierter Viskosität (Beispiele 2-7, 11 und 13-15 erfindungsgemäß, Beispiele 8-10, 12, 18 und 19 Vergleichsbeispiele):

Die Synthesen wurden analog Beispiel 1 durchgeführt, wobei das Zielprodukt durch Anlagerung von drei Blöcken an das jeweilige Startmolekül aufgebaut wurde. Nach der Anlagerung des ersten Blocks, der aus PO als Alkylenoxid aufgebaut wurde, folgte nach einer 30-minütigen Nachreaktion ein zweiter Block, in dem ein Gemisch aus PO und dem jeweiligen Starter (2) zudosiert wurde. Nach erfolgter Dosage schloß sich eine einstündige Nachreaktion an.
Im abschließenden dritten Block erfolgte die Addition eines Gemisches aus Dynasylan® GLYEO und PO gefolgt von einer einstündigen Nachreaktionszeit. Die beiden ersten Blöcke wurden bei 130°C angelagert, der dritte Block bei 95°C. Abschließend wurde das Reaktionsgemisch bei 95°C für 15 Minuten entgast und 500 ppm Antioxidanz (Irganox® 1135) eingerührt. Die Molverhältnisse der eingesetzten Reaktanden bezogen auf 1 mol Starter sind Tabelle 2 zu entnehmen.

### Beispiel 16 und 17:

### Synthese alkoxysilyl-funktioneller Polyether (nicht erfindungsgemäß):

Die Synthesen wurden analog Beispiel 1 durchgeführt, wobei der Starter und die Einsatzmengen entsprechend angepasst wurden, um den in Tabelle 1 dokumentierten Aufbau zu gewährleisten.

**Tabelle 1: Aufbau der Silylpolyether der Beispiele 16 und 17**

| Bsp. | Starter (1) | 1. | 2. | 3. | |
|---|---|---|---|---|---|
| | | n_{PO} | n_{PO} | n_{GLYEO} | n_{PO} |
| | | [mol] | [mol] | [mol] | [mol] |
| 16 | PPG 2000* | 18 | 46 | 2,67 | 68,67 |
| 17 | BPG 400** | 0 | 17,5 | 1,33 | 34,33 |

| | | | | | |
|---|---|---|---|---|---|
| * Polypropylenglykol-Polyether mit einem mittleren Molekulargewicht von 2000 g/mol ** Butanol-gestartetes Polypropylenglykol mit einer mittleren Molmasse von 400 g/mol | | | | | |

### Beispiel 20:

### Herstellung einer Polymermischung aus Silylpolyethern der Beispiele 16 + 17, um einen Silylpolyether analog zu Beispiel 2 herzustellen (Vergleichsbeispiel)

Aus den Silylpolyethern der Beispiele 16 und 17 wird eine Mischung im Molverhältnis 2:1 hergestellt. Hierzu werden in einem 4 L Glaskolben 2524 g Polyether aus Beispiel 16 mit 438 g Polyether aus Beispiel 17 versetzt und durch 30 minütiges Rühren bei Raumtemperatur homogenisiert und anschließend die Viskosität bestimmt. Diese betrug bei 25°C 4,6 Pa · s.

**Tabelle 2:**

| Aufbau und Viskosität der Alkoxysilylpolyether der Beispiele 1-15 und 18-20 | | | | | | | | |
|---|---|---|---|---|---|---|---|---|
| Bsp. | Starter (1) | Starter (2) | 1. | 2. | | 3. | | Viskosität |
| | | | n_{PO} | n_{PO} | n_{Starter (2)} | n_{GLYEO} | n_{PO} | [Pa · s] |
| | | | [mol] | [mol] | [mol] | [mol] | [mol] | (bei 25°C) |
| 1 | PPG 2000* | - | 87 | 0 | 0 | 4 | 103 | 12,1 |
| 2 | PPG 2000* | 1-Butanol | 18 | 69 | 0,5 | 4 | 103 | 4,2 |
| 3 | PPG 2000* | Texanol | 18 | 69 | 0,5 | 4 | 103 | 4,3 |
| 4 | PPG 2000* | 2-Propyl-1-heptanol | 18 | 69 | 0,5 | 4 | 103 | 4,2 |
| 5 | PPG 2000* | 2-Propyl-1-heptanol | 37 | 50 | 0,5 | 4 | 103 | 3,9 |
| 6 | PPG 2000* | 2-Ethyl-1-hexanol | 18 | 69 | 0,25 | 4 | 103 | 5,1 |
| 7 | PPG 2000* | 2-Ethyl-1-hexanol | 18 | 69 | 0,8 | 4 | 103 | 3,0 |
| 8 | PPG 2000* | Dipropylenglykol | 18 | 69 | 0,25 | 4 | 103 | 8,6 |
| 9 | PPG 2000* | Dipropylenglykol | 18 | 69 | 0,5 | 4 | 103 | 7,3 |
| 10 | PPG 2000* | Glycerin | 18 | 69 | 0,5 | 4 | 103 | 7,0 |
| 11 | PPG 2000* | BPG 400** | 18 | 69 | 0,5 | 4 | 103 | 4,1 |
| 12 | PPG 2000* | PPG 2000* | 18 | 69 | 0,25 | 4 | 103 | 8,4 |
| 18 | Desmophen C 2200⁺ | - | 106 | 0 | 0 | 4 | 84 | 79,1 |
| 13^{#} | Desmophen C 2200⁺ | 1-Butanol | 18 | 0 | 0,5 | 4 | 120 | 46,7 |
| 14 | Desmophen C 2200⁺ | 1-Butanol | 18 | 69 | 0,5 | 4 | 103 | 37,5 |
| 19 | Baycoll AD 2055⁺⁺ | - | 121 | 0 | 0 | 4 | 84 | 29,8 |
| 15 | Baycoll AD 2055⁺⁺ | 1-Butanol | 18 | 69 | 0,5 | 4 | 119 | 11,9 |
| 20 | 2:1-Mischung der Beispiele 16 + 17 | | | | | | | 4,6 |

| | | | | | | | | |
|---|---|---|---|---|---|---|---|---|
| * Polypropylenglykol-Polyether mit einem mittleren Molekulargewicht von 2000 g/mol ** Butanol-gestartetes Polypropylenglykol mit einer mittleren Molmasse von 400 g/mol ⁺ terminal dihydroxyfunktionelles Polycarboant mit einem mittleren Molekulargewicht von 2000 g/mol (erhältlich bei Bayer Material Science) ⁺⁺ terminal dihydroxyfunktioneller Polyester mit einem mittleren Molekulargewicht von 2000 g/mol (erhältlich bei Bayer Material Science) ^{#} In Beispiel 13 wurden nach dem 1. Block zunächst in Block 2a 0,5 mol 1-Butanol alleine zudosiert und in einem anschließenden Block 2 b ein Gemisch aus 30,6 mol EO und 27,7 mol PO. Abschließend wurde der in Tabelle 2 dokumentierte Block 3 entsprechend angelagert. | | | | | | | | |

### Endverkappung (Verfahren nach DE 102012203737):

Die in den Beispielen 1-12 und 20 hergestellten Alkoxylierungsprodukte wurden im Anschluß mittels IPDI nach dem Verfahren A umgesetzt.
Die in den Beispielen 1, 13-15, 18 und 19 hergestellten Alkoxylierungsprodukte wurden im Anschluß mittels IPDI nach dem Verfahren B umgesetzt.

### Beispiele gemäß Verfahren A:

### Beispiel 21:

706,8 g Silylpolyether aus Beispiel 1 wurden vorgelegt und auf 60 °C erhitzt. Anschließend wurden 26,68 g IPDI zugesetzt, fünf Minuten gerührt und 0,8 g TIB Kat 722 zugesetzt. Es wurde 45 min lang gerührt, auf 80 °C aufgeheizt und 53,5 g eines Polyethers der allgemeinen Formel C₄H₉O[CH₂CH(CH₃)O]_{5,6}H zugesetzt. Anschließend wurde weitere 3 h lang gerührt.

### Beispiel 22:

2541 g Silylpolyether aus Beispiel 2 wurden vorgelegt und auf 60 °C erhitzt. Anschließend wurden 96 g IPDI zugesetzt, fünf Minuten gerührt und 2,83 g TIB Kat 722 (Bismutcarboxylat) zugesetzt. Es wurde 30 min lang gerührt, auf 80 °C erhitzt und 192 g eines Polyethers der allgemeinen Formel C₄H₉O[CH₂CH(CH₃)O]_{5,6}H zugesetzt. Anschließend wurde weitere 5 h lang gerührt.

### Beispiel 23:

2544 g Silylpolyether aus Beispiel 3 wurden vorgelegt und auf 60 °C erhitzt.

Anschließend wurden 95 g IPDI zugesetzt, fünf Minuten gerührt und 2,83 g TIB Kat 722 (Bismutcarboxylat) zugesetzt. Es wurde 45 min lang gerührt, auf 80 °C erhitzt und 191 g eines Polyethers der allgemeinen Formel C₄H₉O[CH₂CH(CH₃)O]_{5,6}H zugesetzt. Anschließend wurde weitere 3 h lang gerührt.

### Beispiel 24:

2556 g Silylpolyether aus Beispiel 4 wurden vorgelegt und auf 60 °C erhitzt. Anschließend wurden 96 g IPDI zugesetzt, fünf Minuten gerührt und 2,84 g TIB Kat 722 (Bismutcarboxylat) zugesetzt. Es wurde 45 min lang gerührt, auf 80 °C erhitzt und 192 g eines Polyethers der allgemeinen Formel C₄H₉O[CH₂CH(CH₃)O]_{5,6}H zugesetzt. Anschließend wurde weitere 3 h lang gerührt.

### Beispiel 25:

2550 g Silylpolyether aus Beispiel 5 wurden vorgelegt und auf 60 °C erhitzt. Anschließend wurden 96 g IPDI zugesetzt, fünf Minuten gerührt und 2,83 g TIB Kat 722 (Bismutcarboxylat) zugesetzt. Es wurde 45 min lang gerührt, auf 80 °C erhitzt und 191 g eines Polyethers der allgemeinen Formel C₄H₉O[CH₂CH(CH₃)O]_{5,6}H zugesetzt. Anschließend wurde weitere 3 h lang gerührt.

### Beispiel 26:

2497 g Silylpolyether aus Beispiel 6 wurden vorgelegt und auf 60 °C erhitzt. Anschließend wurden 94 g IPDI zugesetzt, fünf Minuten gerührt und 2,78 g TIB Kat 722 (Bismutcarboxylat) zugesetzt. Es wurde 45 min lang gerührt, auf 80 °C erhitzt und 189 g eines Polyethers der allgemeinen Formel C₄H₉O[CH₂CH(CH₃)O]_{5,6}H zugesetzt. Anschließend wurde weitere 3 h lang gerührt.

### Beispiel 27:

2538 g Silylpolyether aus Beispiel 7 wurden vorgelegt und auf 60 °C erhitzt. Anschließend wurden 95 g IPDI zugesetzt, fünf Minuten gerührt und 2,82 g TIB Kat 722 (Bismutcarboxylat) zugesetzt. Es wurde 45 min lang gerührt, auf 80 °C erhitzt und 190 g eines Polyethers der allgemeinen Formel C₄H₉O[CH₂CH(CH₃)O]_{5,6}H zugesetzt. Anschließend wurde weitere 3 h lang gerührt.

### Beispiel 28:

890 g Silylpolyether aus Beispiel 9 wurden vorgelegt und auf 60 °C erhitzt. Anschließend wurden 50 g IPDI zugesetzt, fünf Minuten gerührt und 1,04 g TIB Kat 722 (Bismutcarboxylat) zugesetzt. Es wurde 45 min lang gerührt, auf 80 °C erhitzt und 101 g eines Polyethers der allgemeinen Formel C₄H₉O[CH₂CH(CH₃)O]_{5,6}H zugesetzt. Anschließend wurde weitere 3 h lang gerührt.

### Beispiel 29:

1349 g Silylpolyether aus Beispiel 11 wurden vorgelegt und auf 60 °C erhitzt. Anschließend wurden 50 g IPDI zugesetzt, fünf Minuten gerührt und 1,5 g TIB Kat 722 (Bismutcarboxylat) zugesetzt. Es wurde 45 min lang gerührt, auf 80 °C erhitzt und 101 g eines Polyethers der allgemeinen Formel C₄H₉O[CH₂CH(CH₃)O]_{5,6}H zugesetzt. Anschließend wurde weitere 3 h lang gerührt.

### Beispiel 30:

1414 g Silylpolyether aus Beispiel 11 wurden vorgelegt und auf 60 °C erhitzt. Anschließend wurden 66 g IPDI zugesetzt, fünf Minuten gerührt und 1,6 g TIB Kat 722 (Bismutcarboxylat) zugesetzt. Es wurde 45 min lang gerührt, auf 80 °C erhitzt und 132 g eines Polyethers der allgemeinen Formel C₄H₉O[CH₂CH(CH₃)O]_{5,6}H zugesetzt. Anschließend wurde weitere 3 h lang gerührt.

### Beispiel 31:

1499 g Silylpolyether aus Beispiel 12 wurden vorgelegt und auf 60 °C erhitzt. Anschließend wurden 55 g IPDI zugesetzt, fünf Minuten gerührt und 1,7 g TIB Kat 722 (Bismutcarboxylat) zugesetzt. Es wurde 45 min lang gerührt, auf 80 °C erhitzt und 110 g eines Polyethers der allgemeinen Formel C₄H₉O[CH₂CH(CH₃)O]_{5,6}H zugesetzt. Anschließend wurde weitere 3 h lang gerührt.

### Beispiel 32:

1302 g Silylpolyether aus Beispiel 12 wurden vorgelegt und auf 60 °C erhitzt. Anschließend wurden 59 g IPDI zugesetzt, fünf Minuten gerührt und 1,5 g TIB Kat 722 (Bismutcarboxylat) zugesetzt. Es wurde 45 min lang gerührt, auf 80 °C erhitzt und 119 g eines Polyethers der allgemeinen Formel C₄H₉O[CH₂CH(CH₃)O]_{5,6}H zugesetzt. Anschließend wurde weitere 3 h lang gerührt.

### Beispiel 33:

2863 g Silylpolyether aus Beispiel 20 wurden vorgelegt und auf 60 °C erhitzt. Anschließend wurden 108 g IPDI zugesetzt, fünf Minuten gerührt und 0,32 g TIB Kat 722 (Bismutcarboxylat) zugesetzt. Es wurde 45 min lang gerührt, auf 80 °C erhitzt und 216 g eines Polyethers der allgemeinen Formel C₄H₉O[CH₂CH(CH₃)O]_{5,6}H zugesetzt. Anschließend wurde weitere 3 h lang gerührt.

### Beispiele gemäß Verfahren B

### Beispiel 34:

2969 g Silylpolyether aus Beispiel 2 wurden vorgelegt und auf 70 °C erhitzt. Anschließend wurden 101 g IPDI zugesetzt, fünf Minuten gerührt und 0,2 g TIB Kat 216 (Dioctylzinndilaurat) zugesetzt. Es wurde 45 min lang gerührt und 202 g eines Polyethers der allgemeinen Formel C₄H₉O[CH₂CH(CH₃)O]_{5,6}H zugesetzt. Anschließend wurde weitere 5 h lang bei 70 °C gerührt.

### Beispiel 35:

2925 g Silylpolyether aus Beispiel 13 wurden vorgelegt und auf 70 °C erhitzt. Anschließend wurden 100 g IPDI zugesetzt, fünf Minuten gerührt und 0,2 g TIB Kat 216 (Dioctylzinndilaurat) zugesetzt. Es wurde 45 min lang gerührt und 201 g eines Polyethers der allgemeinen Formel C₄H₉O[CH₂CH(CH₃)O]_{5,6}H zugesetzt. Anschließend wurde weitere 5 h lang bei 70 °C gerührt.

### Beispiel 36:

2617 g Silylpolyether aus Beispiel 14 wurden vorgelegt und auf 70 °C erhitzt. Anschließend wurden 100 g IPDI zugesetzt, fünf Minuten gerührt und 0,2 g TIB Kat 216 (Dioctylzinndilaurat) zugesetzt. Es wurde 45 min lang gerührt und 200 g eines Polyethers der allgemeinen Formel C₄H₉O[CH₂CH(CH₃)O]_{5,6}H zugesetzt. Anschließend wurde weitere 5 h lang bei 70 °C gerührt.

### Beispiel 37:

2684 g Silylpolyether aus Beispiel 15 wurden vorgelegt und auf 70 °C erhitzt. Anschließend wurden 95 g IPDI zugesetzt, fünf Minuten gerührt und 0,2 g TIB Kat 216 (Dioctylzinndilaurat) zugesetzt. Es wurde 45 min lang gerührt und 191 g eines Polyethers der allgemeinen Formel C₄H₉O[CH₂CH(CH₃)O]_{5,6}H zugesetzt. Anschließend wurde weitere 5 h lang bei 70 °C gerührt.

### Beispiel 38:

2679 g Silylpolyether aus Beispiel 18 wurden vorgelegt und auf 70 °C erhitzt. Anschließend wurden 95 g IPDI zugesetzt, fünf Minuten gerührt und 0,2 g TIB Kat 216 (Dioctylzinndilaurat) zugesetzt. Es wurde 45 min lang gerührt und 191 g eines Polyethers der allgemeinen Formel C₄H₉O[CH₂CH(CH₃)O]_{5,6}H zugesetzt. Anschließend wurde weitere 5 h lang bei 70 °C gerührt.

### Beispiel 39:

2690 g Silylpolyether aus Beispiel 19 wurden vorgelegt und auf 70 °C erhitzt. Anschließend wurden 96 g IPDI zugesetzt, fünf Minuten gerührt und 0,2 g TIB Kat 216 (Dioctylzinndilaurat) zugesetzt. Es wurde 45 min lang gerührt und 192 g eines Polyethers der allgemeinen Formel C₄H₉O[CH₂CH(CH₃)O]_{5,6}H zugesetzt. Anschließend wurde weitere 5 h lang bei 70 °C gerührt.

### Beispiel 40:

703,1 g Silylpolyether aus Beispiel 1 wurden vorgelegt und auf 70 °C erhitzt. Anschließend wurden 26,5 g IPDI zugesetzt, fünf Minuten gerührt und 0,05 g TIB Kat 216 (Dioctylzinndilaurat) zugesetzt. Es wurde 30 min lang gerührt und 53,2 g eines Polyethers der allgemeinen Formel C₄H₉O[CH₂CH(CH₃)O]_{5,6}H zugesetzt. Anschließend wurde weitere 5 h lang gerührt.

Bei den endverkappten Beispielen aus Tabelle 3 handelt es sich bei den Beispielen 21, 28, 31 bis 33, 38, 39 und 40 um Vergleichsbeispiele, die restlichen Beispiele sind erfindungsgemäß.

**Tabelle 3: Viskositäten der endverkappten Silylpolyether aus den Beispielen 21-40**

| Beispiel | Umsetzung von Alkoxylierungsprodukt aus Beispiel | Verfahren | Viskosität (25°C) [Pa · s] |
|---|---|---|---|
| **21** | **1** | **A** | **72,0** |
| **22** | **2** | **A** | **23,6** |
| **23** | **3** | **A** | **22,8** |
| **24** | **4** | **A** | **22,4** |
| **25** | **5** | **A** | **24,0** |
| **26** | **6** | **A** | **26,3** |
| **27** | **7** | **A** | **20,6** |
| **28** | **9** | **A** | **35,3** |
| **29** | **11** | **A** | **25,9** |
| **30** | **11** | **A** | **16,9** |
| **31** | **12** | **A** | **55,2** |
| **32** | **12** | **A** | **41,2** |
| **33** | **20** | **A** | **41,0** |
| **40** | **1** | **B** | **34,5** |
| **34** | **2** | **B** | **20,5** |
| **38** | **18** | **B** | **186** |
| **35** | **13** | **B** | **152** |
| **36** | **14** | **B** | **125** |
| **39** | **19** | **B** | **85,6** |
| **37** | **15** | **B** | **34,5** |

### Ansetzen der raumtemperaturapplizierbaren Kleb-/Dichtstoff-Formulierungen:

25,9 Gew.-% des Alkoxylierungsprodukt nach den jeweiligen Beispielen wurde mit 18,1 Gew.-% von Diisoundecylphthalat, 51,1 Gew.-% einer gefällten Kreide (Socal® U1S2, Solvay), 0,5 Gew.-% Titandioxid (Kronos® 2360, Kronos), 1,4 Gew.-% Haftvermittler (Dynasylan® AMMO, Evonik), 1,1 Gew.-% Trocknungsmittel (Dynasylan® VTMO, Evonik), 1,5 Gew.-% Teile eines Antioxidans-Stabilisator-Gemisches (Verhältnis Irganox® 1135:Tinuvin® 1130:Tinuvin® 292 = Verhältnis 1:2:2 und 0,4 Gew.-% des Härtungskatalysators (TIB® KAT 223, TIB) im Mischer (Speedmixer® FVS 600, Hausschild) intensiv vermischt. Die fertige Formulierung wurde in PE-Kartuschen überführt und vor der Applikation mindestens 24h bei Raumtemperatur gelagert. Da die Formulierungen der Alkoxylierungsprodukte in den oben genannten Beispielen in allen Fällen identisch waren, wurde die Ergebnisdiskussion anhand der Benennung des als Basis der Formulierung genutzten Alkoxylierungsproduktes durchgeführt.

### Bestimmung von Bruchspannung und Bruchdehnung in Anlehnung an DIN 53504:

Die Formulierung wurde mit einer Schichtdicke von 2 mm auf einer PE-Oberfläche aufgerakelt. Die Filme wurden 7 Tage bei 23 °C und 50% relativer Luftfeuchte gelagert. Anschließend wurden aus den Filmen mit Hilfe einer Schneidform und einer Kniehebelpresse S2-Schulterstäbe ausgestanzt.
Die so hergestellten Schulterstäbe wurden zur Prüfung in eine Universalprüfmaschine (Fa. Shimadzu) eingespannt, und es wurden die Bruchkraft und die Bruchdehnung beim Dehnen der Probekörper mit konstanter Geschwindigkeit (200 mm/min) ermittelt.

### Bestimmung der Zugscherfestigkeit von Überlappungsklebungen in Anlehung an DIN EN 1465

Mit der angefertigten Formulierung wurden Überlappungsverklebungen erstellt. Hierbei wurden zwei Edelstahl Substrate (V2A, 1.4301) eingesetzt. Der Bereich der Überlappungsverklebung betrug 500 mm². Die Aushärtung der Verklebungen erfolgte bei 23°C und 50% relativer Luftfeuchte. Nach 21 Tagen wurden die Verklebungen in eine Universalprüfmaschine (Fa. Shimadzu) eingespannt, und es wurde mit konstanter Geschwindigkeit (10 mm/min) eine Kraft auf die Verklebung ausgeübt, bis ein Bruch der Verklebung eintrat. Die Bruchspannung wurde ermittelt.

**Tabelle 4:**

| Mechanische Kennwerte der ausgehärteten Formulierung am S2-Schulterstab und an einer Überlappungsverklebung zweier V2A-Bleche: | | | |
|---|---|---|---|
| Polymer nach Beispiel | S2-Schulterstab | | Verklebung |
| | Bruchdehnung [%] | Bruchspannung [N/mm²] | Bruchspannung [N/mm²] |
| **21** | **212** | **1,73** | **1,34** |
| **22** | **203** | **1,54** | **1,44** |
| **23** | **216** | **1,61** | **1,49** |
| **24** | **194** | **1,60** | **1,47** |
| **25** | **168** | **1,51** | **1,57** |
| **26** | **121** | **1,52** | **1,47** |
| **27** | **185** | **1,45** | **1,54** |
| **28** | **182** | **1,23** | **1,07** |
| **29** | **204** | **1,41** | **1,49** |
| **30** | **221** | **1,35** | **1,33** |
| **31** | **154** | **1,48** | **1,69** |
| **32** | **151** | **1,25** | **1,32** |
| **33** | **188** | **1,52** | **1,71** |
| **40** | **189** | **1,60** | **1,34** |
| **34** | **152** | **1,52** | **1,63** |
| **38** | **165** | **1,31** | **1,16** |
| **35** | **126** | **1,49** | **1,49** |
| **36** | **112** | **1,70** | **1,74** |
| **39** | **206** | **1,38** | **1,09** |
| **37** | **163** | **1,44** | **1,27** |

Aus den in den Tabellen 2 und 3 gezeigten Viskositäten geht eindeutig hervor, dass die Viskosität der erfindungsgemäßen Alkoxylierungsprodukte, hergestellt nach dem erfindungsgemäßen Verfahren durch den Einsatz von Startern (2) während der Alkoxylierung zu einer signifikanten Reduktion der Viskosität führt. Nicht erfindungsgemäße Zusammensetzungen weisen eine Viskosität auf, die um mindestens 10% höher liegt als die Viskosität der erfindungsgemäßen Zusammensetzungen.

Gemäß Tabelle 2 ist bei den erfindungsgemäßen Alkoxylierungsprodukten mit terminalen OH-Gruppen aus den Beispielen 2-7 und 11, bei denen ein Polyether (PPG 2000) als Starter eingesetzt worden ist, eine Reduktion der Viskosität um mindestens 50 % zu verzeichnen, gegenüber dem Vergleichsbeispiel 1, wo kein Starter (2) eingesetzt wird. Ist die Funktionalität von Starter (2) identisch zu Starter (1) oder höher, so ist immer noch eine merkliche Reduktion der Viskosität im Vergleich zu Beispiel 1 zu beobachten, um ca. 30% (Beispiele 8, 9, 12). Dieser geringere Viskositätsreduktionseffekt ist ein klarer Beleg, dass es besonders vorteilhaft ist Starter (2) mit einer um 1 reduzierten Funktionalität gegenüber Starter (1) einzusetzen.
Wie Beispiel 14 (mit Starter (2)) im Vergleich zu Beispiel 18 (ohne Starter (2)) sowie Beispiel 15 (mit Starter (2)) im Vergleich zu Beispiel 19 (ohne Starter (2)) zeigen, lässt sich der Effekt der Viskositätserniedrigung auch auf chemisch andersartige, (nicht Polyether-) Starter übertragen. Es wurden ein Polycarbonat (Desmophen C 2200 in Beispiel 14 bzw. 18) sowie ein Polyester (Baycoll AD 2055 in Beispiel 15 bzw. 19) im erfindungsgemäßen Verfahren eingesetzt und in beiden Fällen konnte durch den Zusatz von 1-Butanol als Starter (2) eine Viskositätsreduktion von mindestens 40% zu den Vergleichsbeispielen beobachtet werden.

Dieser Trend ist auch in Tabelle 3 bei den mit Isocyanaten umgesetzten Alkoxylierungsprodukten abzulesen. Bei den nach Verfahren A endverkappten Alkoxylierungsprodukten ist eine Reduktion der Viskosität um mindestens 60% zu verzeichnen, für den Fall, dass die Alkoxylierungsprodukte zuvor mit Startern (2) hergestellt wurden die eine geringere OH-Funktionalität aufweisen als der Starter (1). Für den Fall das die OH-Funktionalität der beiden Starter identisch ist, ist eine geringere Viskosität festzustellen im Vergleich zu Beispiel 21, wo ausschließlich nur ein Starter (1) eingesetzt wurde. Die Reduktion bewegt sich im Rahmen von 20-50%. Dieser Trend setzt sich auch fort bei den nach Verfahren B endverkappten Alkoxylierungsprodukten. Hier ist jedoch eine geringere absolute Reduktion der Viskosität zu verzeichnen. In Beispiel 34 im Vergleich zu Beispiel 40 ist die Viskosität um 40% reduziert, wohingegen für die analogen Produkte verkappt nach Verfahren A, beim Vergleich von Beispiel 21 mit Beispiel 22 eine Reduktion um etwa 65% zu verzeichnen ist.
Im Fall, dass die Alkoxylierungsprodukte zuvor mit Startern (2) hergestellt wurden die eine geringere OH-Funktionalität aufweisen als der Starter (1) ist eine besonders gute Reduktion der Viskosität zu verzeichnen. Im ähnlichen Bereich liegen auch die Viskositätsreduktionen für die erfindungsgemäßen Produkte basierend auf Polycarbonaten (Reduktion der Viskosität um etwa 30%, siehe Beispiel 38 zu 36) oder Polyestern (Reduktion der Viskosität um etwa 60%, siehe Beispiel 39 zu 37) als Starter.

Darüber hinaus kann man aus den Ergebnissen der Tabellen 2 und 3 ableiten, dass es für eine signifikante Viskositätserniedrigung unerheblich ist, welche Art von Starter (2) eingesetzt wird, was insbesondere deutlich wird für die erfindungsgemäßen Beispiele wo Starter (1) höher OH-funktionell ist als Starter (2).
Aus den Ergebnissen aus Tabelle 2 kann des Weiteren abgelesen werden, dass die Viskositätsreduktion durch die Menge des zugesetzten Starters (2) beeinflusst werden kann. Je mehr Starter (2) eingesetzt wird, umso größer ist der Effekt der Viskositätsreduktion ausgeprägt. Dieser Effekt ist für die endverkappten Verbindungen aus Tabelle 3 etwas abgeschwächt jedoch auch eindeutig zu verzeichnen.
Anhand der Beispiele 24, 25 und 35 kann man zudem erkennen, dass auch das Ausmaß der Viskositätsreduktion durch den Zeitpunkt der Zugabe des Starters (2) gesteuert werden kann.

Die mechanischen Kennwerte der erfindungsgemäßen Alkoxylierungsprodukte mit intrinsisch reduzierter Viskosität sind in Tabelle 4 zusammengefasst und zeigen für Alkoxylierungsprodukte endverkappt nach dem Verfahren A überraschenderweise keine signifikanten Abweichungen zu den mechanischen Kennwerten des Vergleichsbeispiels 21 mit erhöhter Viskosität. Im Gegensatz dazu zeigt sich bei den mechanischen Kennwerten der Alkoxylierungsprodukte endverkappt nach dem Verfahren A insgesamt sogar ein positiver Einfluss. Zwar werden die Bruchdehnungen der erfindungsgemäßen Beispiele 34 bis 37 im Vergleich zu den Vergleichsbeispielen 38 bis 40 leicht reduziert, dieser Effekt aber durch eine signifikante Verbesserung der Bruchspannung in der Verklebung überkompensiert.

Separat und etwas ausführlicher soll noch auf die bisher außer Acht gelassenen Vergleichsbeispiele 20 bzw. 33 eingegangen werden. Bei diesen Polyethern handelt es sich um Silylpolyether, die strukturell den erfindungsgemäßen Beispielen 2 bzw. 22 entsprechen, im Gegensatz zu diesen jedoch nicht nach dem erfindungsgemäßen Verfahren hergestellt wurden. Um die Struktur von Beispiel 2 zu kopieren wurden in zwei separaten Ansätzen die Starter (1) und (2) umgesetzt und an diese die Mole der Monomere der Blöcke 2 + 3 gemäß Tabelle 2 im Mengenverhältnis der Berücksichtigung der OH-Guppen des Starters angelagert. Im Beispiel 16 wurden also 2/3 der Monomere der Blöcke 2 und 3 analog Beispiel 2 an PPG 2000 angelagert. Analog wurde in Beispiel 17 1/3 der jeweiligen Monomere angelagert. Der Einfachheit halber wurde in Beispiel 17 nicht direkt aus Butanol gestartet, sondern aus einem Addukt von Butanol + 5,5 PO. Diese wurden in der Rezeptur entsprechend berücksichtigt.

Anschließend wurden diese Polymere in Beispiel 20 gemischt und in Beispiel 33 mit IPDI umgesetzt. Anhand der Viskosität von Beispiel 20 wird deutlich, dass auch dieses Mischen unterschiedlich funktioneller Silylpolyether zu einer vergleichbaren Viskositätsreduktion führt, die im Bereich der erfindungsgemäßen Beispiele 2-7 und 11 liegt, jedoch ist dieser Effekt nicht nachhaltig in der angestrebten Folgeumsetzung. Das endverkappte Folgeprodukt gemäß Beispiel 33 weist zwar im Vergleich zum Vergleichsbeispiel 21 immer noch eine um fast 60% reduzierte Viskosität auf, jedoch ist der Viskositätsreduktionseffekt im Referenzbeispiel 2 noch weit größer, sprich beinahe doppelt so groß. Anhand der Anwendungseigenschaften des Vergleichsbeispiel 33 dargestellt in Tabelle 4 lässt sich auch kein merklicher Effekt feststellen. Sowohl Bruchspannung als auch -dehnung sind vergleichbar zum Referenzbeispiel 21.

Es ist somit überraschend festzustellen, dass die Änderung der Zusammensetzungen der erfindungsgemäßen Alkoxylierungsprodukte durch den Einsatz von Startern (2) keine merklichen Einflüsse auf die wesentlichen Anwendungseigenschaften der Formulierungen, die auf den erfindungsgemäßen Alkoxylierungsprodukten, die nach dem erfindungsgemäßen Verfahren hergestellt wurden, beruhen, zeigt und trotzdem anwendungstechnisch vergleichbare Produkte mit merklich reduzierter Viskosität erhalten werden können. Umso mehr überraschend ist, dass die Bruchspannung bei der Verklebung sogar verbessert werden konnte.

## Patentansprüche

1. Zusammensetzung enthaltend Alkyoxylierungsproduktgemische mit intrinsisch reduzierter Viskosität erhältlich durch Alkoxylierung von Epoxyfunktionellen Verbindungen in Gegenwart von mindestens zwei unterschiedlichen OH-funktionellen Startern Starter (1) und Starter (2) **dadurch gekennzeichnet, dass** Starter (1) eine Molmasse von größer 400 g/mol, wobei es sich im Fall von Mittelwerten um das Zahlenmittel handelt, aufweist, und Starter (2) eine Molmasse von kleiner gleich 400 g/mol aufweist,
wobei die Alkoxylierungsprodukte (1) aus Starter (1) aufgebaut sind aus Alkylenoxid, mindestens einem Alkoxysilylgruppen tragenden Epoxid und gegebenenfalls weiteren Monomeren und die Alkoxylierungsprodukte (2) aus Starter (2) aufgebaut sind aus Alkylenoxid und gegebenenfalls mindestens einem Alkoxysilylgruppen tragenden Epoxid und/oder weiteren Monomeren.

2. Zusammensetzung nach Anspruch 1 **dadurch gekennzeichnet, dass** die Molmasse von Starter (1) die Molmasse von Starter (2) um mindestens 200 g/mol übersteigt.

3. Zusammensetzung nach einem der Ansprüche 1 oder 2 **dadurch gekennzeichnet, dass** die Molmasse von Starter (1) die Molmasse von Starter (2) um mindestens 600 g/mol, bevorzugt um mindestens 1000 g/mol, übersteigt.

4. Zusammensetzung nach einem der Ansprüche 1 bis 3 **dadurch gekennzeichnet, dass** der Starter (1) t OH-Gruppen und Starter (2) t - 1 OH-Gruppen aufweist, mit t = 2 bis 8, bevorzugt 2 bis 5.

5. Zusammensetzung nach einem der Ansprüche 1 bis 4 **dadurch gekennzeichnet, dass** Alkoxylierungsprodukte (1) aus Starter (1) aufgebaut sind aus bevorzugt Ethylenoxid und/oder Propylenoxid, mindestens einem Alkoxysilylalkylglycidylether und gegebenenfalls weiteren Monomeren und die Alkoxylierungsprodukte (2) aus Starter (2) aufgebaut sind aus Ethylenoxid und/oder Propylenoxid und mindestens einem Alkoxysilylalkylglycidylether und/oder weiteren Monomeren.

6. Zusammensetzung nach einem der Ansprüche 1 bis 5 **dadurch gekennzeichnet, dass** Alkoxylierungsprodukte (1) aufgebaut sind aus folgenden Monomerenanteilen 10 bis 97 Gew.-% Propylenoxid, 0 bis 60 Gew.-% Ethylenoxid, 0 bis 25 Gew.-% Alkoxysilylalkylglycidylether und 0 bis 25 Gew.-% weitere Monomere; bezogen auf das Gesamtgewicht der Alkoxylierungsprodukte (1); und Alkoxylierungsprodukte (2) aufgebaut sind aus folgenden Monomerenanteilen 10 bis 97 Gew.-% Propylenoxid, 0 bis 60 Gew.-% Ethylenoxid, 0 bis 25 Gew.-% Alkoxysilylalkylglycidylether und 0 bis 25 Gew.-% weitere Monomere, bezogen auf das Gesamtgewicht der Alkoxylierungsprodukte (2).

7. Zusammensetzung nach einem der Ansprüche 1 bis 6 **dadurch gekennzeichnet, dass** Starter (1) ausgewählt ist aus Polyetherolen, Polycarbonatpolyolen und Polyethercarbonaten und Starter (2) bevorzugt ausgewählt ist aus Butanol, Ethanol oder Ethylhexanol.

8. Zusammensetzung nach einem der Ansprüche 1 bis 7 **dadurch gekennzeichnet, dass** die Zusammensetzung mindestens Alkoxylierungsprodukt (1) und Alkoxylierungsprodukt (2) umfasst, wobei Alkoxylierungsprodukt (1) erhältlich aus Starter (1) der Formel (I) entspricht und Alkoxylierungsprodukt (2) erhältlich aus Starter (2) der Formel (IIa) entspricht:
Mᵢ Dⱼ Tₖ Qₗ URᵤ APᵥ Formel (I)
wobei die Fragmente M, D, T, Q nicht untereinander, sondern über die Gruppen UR und/oder AP miteinander verknüpft sind, und die Gruppen UR und AP nicht untereinander verknüpft sind, sondern dementsprechend über die Fragmente M, D, T oder Q miteinander verknüpft sind
i = 0 bis 16,
j = 0 bis 10,
k = 0 bis 6,
l = 0 bis 4,
u = 0 bis 17,
v = 0 bis 6,
mit der Maßgabe, dass i + j + k + l > = 1 ist
M ist unabhängig voneinander ein Sauerstoffradikal tragender Kohlenwasserstoffrest mit einer minimalen numerischen Molmasse von 32 g/mol, welcher gegebenenfalls durch Heteroatome unterbrochen sein kann,
oder ein Rest der Formel (la) oder der Formel (Ib) oder der Formel (Ic) mit 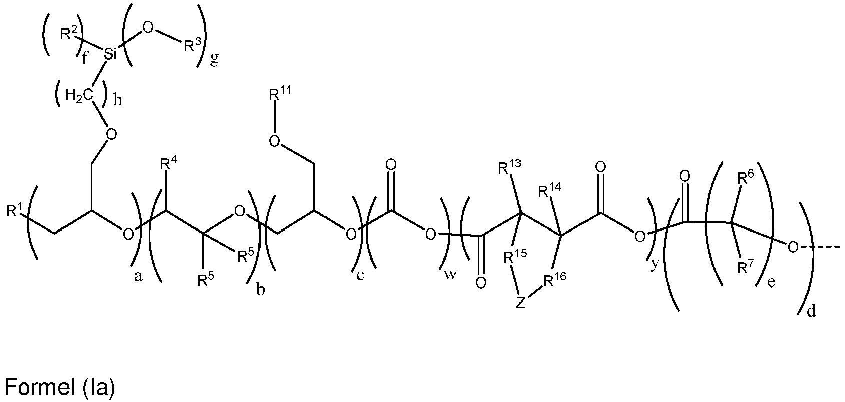 wobei
a = 0 bis 100 ist,
b = 1 bis 1000,
c = 0 bis 200,
d = 0 bis 200,
w = eine ganze Zahl von 0 bis 200
y = eine ganze Zahl von 0 bis 500,
e = 1 bis 10,
f = 0 bis 2
g = 1 bis 3
mit der Maßgabe, dass g + f = 3 und g mindestens gleich 1 ist,
h = 0 bis 10
und mit der Maßgabe, dass die verschiedenen Monomereinheiten der Fragmente mit den Indices a, b, c, d, w und y untereinander blockweise aufgebaut sein können oder
aber einer statistischen Verteilung unterliegen und zudem untereinander frei permutierbar sind, wobei die Gruppen mit den Indices w und y jeweils nicht auf sich selbst oder auf die jeweils andere Gruppe folgen dürfen
und wobei
R¹ = unabhängig voneinander ein gesättigter oder ungesättigter, linearer oder verzweigter organischer Kohlenwasserstoffrest ist, der als Heteroatome O, S und / oder N enthalten kann,
R² = unabhängig voneinander eine Alkylgruppe mit 1 bis 8 Kohlenstoffatomen,
R³ = unabhängig voneinander eine Alkylgruppe mit 1 bis 8 Kohlenstoffatomen,
R⁴ = unabhängig voneinander ein Wasserstoffradikal, eine Alkylgruppe mit 1 bis 20 Kohlenstoffatomen, eine Aryl- oder Alkarylgruppe,
oder R⁴ und einer der Reste R⁵ können gemeinsam einen Ring bilden, der die Atome, an die R⁴ und R⁵ gebunden sind, einschließt, bevorzugt enthält dieser Ring 5 bis 8 Kohlenstoffatome,
R⁵ = unabhängig voneinander ein Wasserstoffradikal oder eine Alkylgruppe mit 1 bis 8 Kohlenstoffatomen,
R⁶, R⁷ = unabhängig voneinander ein Wasserstoffradikal, eine Alkylgruppe mit 1 bis 20 Kohlenstoffatomen, eine Aryl- oder Alkarylgruppe, und/oder Alkoxygruppe
R¹¹ = unabhängig voneinander ein gesättigter oder ungesättigter, aliphatischer oder aromatischer Kohlenwasserstoffrest mit 2 bis 30 C-Atomen, insbesondere bis 24 C-Atomen, der gegebenenfalls substituiert ist, bevorzugt handelt es sich um eine Alkylgruppe mit 1 bis 16 Kohlenstoffatomen, besonders bevorzugt mit 6 bis 12 Kohlenstoffatomen, deren Kette durch Sauerstoff unterbrochen sein kann und weiter funktionelle Gruppen tragen kann,
R¹³, R¹⁴ = unabhängig voneinander Wasserstoff und/oder ein organischer Rest, bevorzugt Alkyl-, Alkenyl-, Alkyliden, Alkoxy-, Aryl- und/oder Aralkylgruppen, oder gegebenenfalls können R¹³ und/oder R¹⁴ auch nicht vorhanden sein, wobei wenn R¹³ und R¹⁴ nicht vorhanden sind, statt der Reste R¹³ und R¹⁴ eine C=C Doppelbindung vorhanden ist,
das überbrückende Fragment Z kann vorhanden oder nicht vorhanden sein
Ist das überbrückende Fragment Z nicht vorhanden so sind
R¹⁵, R¹⁶ = unabhängig voneinander Wasserstoff und/oder ein organischer Rest, bevorzugt Alkyl-, Alkenyl-, Alkyliden, Alkoxy-, Aryl- und/oder Aralkylgruppen wobei für den Fall, dass einer der Reste R¹³ oder R¹⁴ nicht vorhanden ist, der jeweilige geminale Rest (also R¹⁵ wenn R¹³ nicht vorhanden ist und R¹⁶ wenn R¹⁴ nicht vorhanden ist) ein Alkylidenrest, bevorzugt Methyliden (=CH2),ist.
Ist das überbrückende Fragment Z vorhanden, so sind R¹⁵ und R¹⁶ = Kohlenwasserstoffreste , die cycloaliphatisch oder aromatisch über das Fragment Z verbrückt sind, wobei Z einen divalenten Alkylen- oder Alkenylenrest darstellt, der weiter substituiert sein kann, 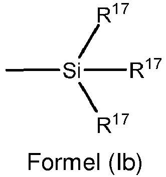 wobei
R¹⁷ = unabhängig voneinander eine lineare oder verzweigte, gesättigte oder ungesättigte, gegebenenfalls weiter substituierte Alkylgruppe mit 1 bis 30 Kohlenstoffatomen, eine Aryl- oder Alkarylgruppe ist, 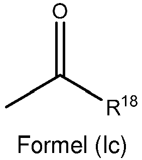
wobei
R¹⁸ = unabhängig voneinander eine zweibindige lineare oder cyclische, gesättigte oder ungesättigte Alkyl- oder Arylgruppe ist, die substituiert sein kann
und wobei für die Fragmente D, T und Q gilt:
D ist ein Polyetherrest -(D^{A})ₜ-D^{X} mit t gleich 2,
T ist ein Polyetherrest -(D^{A})ₜ-D^{X} mit t gleich 3 und
Q ist ein Polyetherrest -(D^{A})ₜ-D^{X} mit t gleich 4,
mit
D^{X} ein t-valenter funktioneller, gesättigter oder ungesättigter, linearer oder verzweigter organischer Kohlenwasserstoffrest ist, der als Heteroatome O, S, Si und / oder N enthalten kann, wobei jeder der Reste D^{A} kovalent an den Rest D^{X} gebunden ist,
und wobei D^{A} ein Fragment der Formel (II) 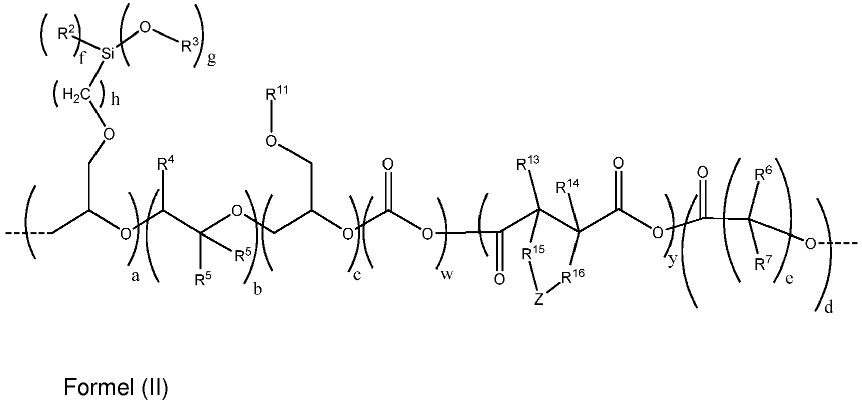 ist, mit a bis h, w, x und y und R² bis R¹⁶ unabhängig voneinander definiert wie in Formal (la),
mit der Maßgabe, die Summe aller Indizes a aus Formal (la) und Formel (II) gleich oder größer 1 sein muss,
UR sind unabhängig voneinander gleiche oder verschiedene divalente Reste der Formel
-U-D^{C}-U-,
oder ein monovalenter Rest der Form D^{D}-U-,
oder ein trivalenter Rest der Form D^{E}U₃,
oder ein tetravalenter Rest der Form D^{F}U₄,
wobei
U eine -C(O)-NH-Gruppe ist, die über den Stickstoff an D^{C}, D^{E}, D^{F} bzw. D^{D} gebunden ist, und
D^{C} unabhängig voneinander ein divalenter substituierter oder unsubstituierter, linearer oder verzweigter, gesättigter oder ungesättigter Kohlenwasserstoffrest mit 1 bis 30 Kohlenstoffatomen ist, ausgewählt aus Alkyl-, Alkenyl-, Aryl- oder Alkarylresten, welcher gegebenenfalls durch Heteroatome wie O, N und / oder S unterbrochen sein kann, und
D^{D} unabhängig voneinander ein ein monovalenter linearer oder verzweigter, gesättigter oder ungesättigter Kohlenwasserstoffrest mit 1 bis 30 Kohlenstoffatomen, ausgewählt aus Alkyl-, Alkenyl-, Aryl- oder Alkarylresten, welcher durch Heteroatome wie O, N und / oder S unterbrochen sein kann und/oder weitere funktionelle Gruppen tragen kann, und D^{E} unabhängig voneinander ein trivalenter substituierter oder unsubstituierter, linearer oder verzweigter, gesättigter oder ungesättigter Kohlenwasserstoffrest mit 1 bis 30 Kohlenstoffatomen ist, ausgewählt aus Alkyl-, Alkenyl-, Aryl- oder Alkarylresten, welcher durch Heteroatome wie O, N und / oder S unterbrochen sein kann und/oder weitere funktionelle Gruppen tragen kann, und
D^{F} unabhängig voneinander ein tetravalenter substituierter oder unsubstituierter, linearer oder verzweigter, gesättigter oder ungesättigter Kohlenwasserstoffrest mit 1 bis 30 Kohlenstoffatomen ist, ausgewählt aus Alkyl-, Alkenyl-, Aryl- oder Alkarylresten, welcher durch Heteroatome wie O, N und / oder S unterbrochen sein kann und/oder weitere funktionelle Gruppen tragen kann, und
AP sind unabhängig voneinander gleiche oder verschiedene Reste der allgemeinen Formel (IIIa), (IIIb) oder (IIIc) 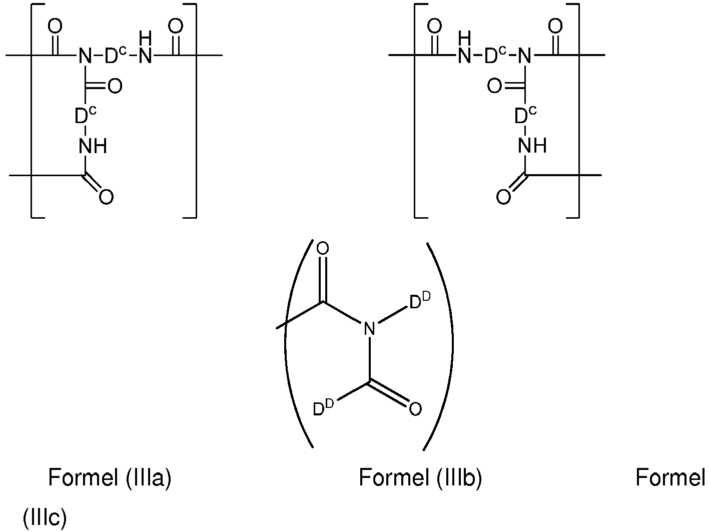
oder für den Fall, dass Polyisocyanate mit den Struktureinheiten D^{E} und/oder D^{F} eingesetzt werden, zusätzlich Strukturelemente analog Formel (IIIa) und/oder (IIIb), wobei die drei Urethaneinheiten die an D^{E} bzw. die vier Urethaneinhaeiten die an D^{F} gebunden sind, unabhängig voneinander, alle oder teilweise zu Allophanat-Struktureinheiten weiter umgesetzt wurden, wie im oberen Teil der Formeln (IIIa) und (IIIb) dargestellt
und mit Alkoxylierungsprodukt (2) der Formel (IIa) 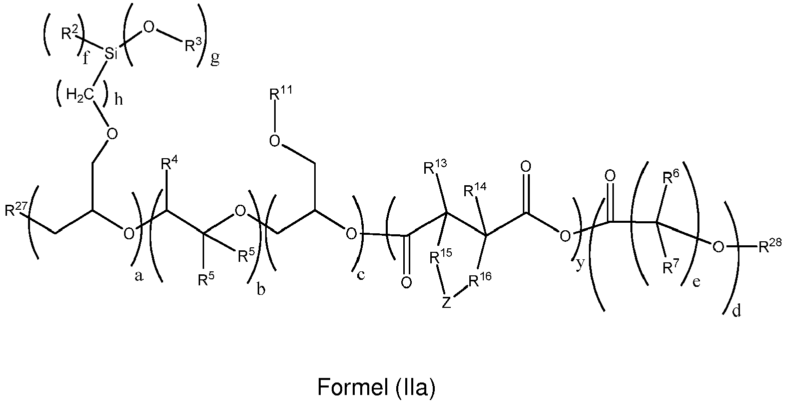 wobei
a = 1 bis 100,
b = 1 bis 200,
c = 0 bis 100,
d = 0 bis 100,
w = 0 bis 100
y = 0 bis 50,
e = 1 bis 10,
f = 0 bis 2
g = 1 bis 3
mit der Maßgabe, dass g + f = 3
h = 0 bis 10,
mit der Maßgabe, dass die Gruppen mit den Indices a, b, c, d, und y frei permutierbar über die Molekülkette sind, wobei Gruppen mit dem Index y jeweils nicht auf sich selbst folgen dürfen und
mit der Maßgabe, dass die verschiedenen Monomereinheiten sowohl der Fragmente mit den Indices a, b, c, d und y untereinander blockweise aufgebaut sein können, wobei einzelne Blöcke auch mehrfach vorkommen können und untereinander statistisch verteilt sein können, oder aber einer statistischen Verteilung unterliegen und zudem untereinander frei permutierbar, im Sinne von in beliebiger Reihenfolge anzuordnen sind, mit der Einschränkung, dass die Gruppen mit den Indices w und y jeweils nicht auf sich selbst oder auf die jeweils andere Gruppe folgen dürfen,
mit den Resten R², R³, R⁴, R⁵, R⁶, R⁷, R¹¹, R¹³, R¹⁴, R¹⁵ und R¹⁶ wie in Formel (la) definiert
und wobei
R²⁷ = unabhängig voneinander ein gesättigter oder ungesättigter, linearer oder verzweigter organischer Kohlenwasserstoffrest ist, der als Heteroatome O, S und / oder N enthalten kann, bevorzugt enthält der Kohlenwasserstoffrest 1 bis 50 Kohlenstoffatome, bevorzugt 2, 3 oder 4 bis 30 Kohlenstoffatome,
bevorzugt resultieren die Reste R¹⁷ aus monovalenten Alkoholen wie Methanol, Ethanol, Propanol, Isopropanol, Butanol, iso-Butanol, tert-Butanol, 2,2,4-Trimethyl-1,3-pentandiol monoisobutyrat (Texanol von Exxon), Octanol, 2-Ethylhexanol, 2-Propylheptanol, Decanol, Dodecanol, C₁₂/C₁₄-Fettalkohol, Phenol, alle Konstitutionsisomere des Kresols, Benzylalkohol, Stearylalkohol, besonders bevorzugt um Butanol, 2,2,4-Trimethyl-1,3-pentandiol monoisobutyrat (Texanol von Exxon), 2-Ethylhexanol, Allylalkohol, 1-Hexenol oder 2-Propylheptanol, insbesondere Butanol oder Allylalkohol,
R²⁸ = unabhängig voneinander Wasserstoff oder ein über UR oder AP gebundenes Fragment der Formeln (II) oder (IIa) ist.

9. Verfahren zur Herstellung von Zusammensetzungen enthaltend Alkyoxylierungsprodukte (1) und (2) umfassend die Schritte
a. Umsetzen mindestens eines Starters (1) mit mindestens einem Alkylenoxid und
b. Umsetzen mindestens eines Starters (2) mit mindestens einem Alkylenoxid,
wobei es sich bei Starter (1) und (2) um OH-funktionelle Verbindungen, handelt, und Starter (1) eine Molmasse von größer 400 g/mol, wobei es sich im Fall von Mittelwerten um das Zahlenmittel handelt, aufweist und Starter (2) eine Molmasse von kleiner gleich 400 g/mol aufweist,
wobei die Alkoxylierungsprodukte (1) aus Starter (1) aufgebaut sind aus Alkylenoxid, mindestens einem Alkoxysilylgruppen tragenden Epoxid und gegebenenfalls weiteren Monomeren und die Alkoxylierungsprodukte (2) aus Starter (2) aufgebaut sind aus Alkylenoxid und gegebenenfalls mindestens einem Alkoxysilylgruppen tragenden Epoxid und/oder weiteren Monomeren.

10. Verfahren nach Anspruch 9 **dadurch gekennzeichnet, dass** der Schritt b) während der laufenden Alkoxylierung des Schrittes a) erfolgt.

11. Verfahren nach einem der Ansprüche 9 oder 10 **dadurch gekennzeichnet, dass** die Molmasse von Starter (1) die Molmasse von Starter (2) um mindestens 600 g/mol, bevorzugt um mindestens 1000 g/mol, übersteigt.

12. Verfahren nach einem der Ansprüche 9 bis 11 **dadurch gekennzeichnet, dass** der Starter (1) t OH-Gruppen und Starter (2) t - 1 OH-Gruppen aufweist, mit t = 2 bis 8, bevorzugt 2 bis 5.

13. Verfahren nach einem der Ansprüche 9 bis 12 umfassend die Schritte
c. Umsetzen mindestens eines Starters (1) mit 10 bis 97 Gew.-% Propylenoxid, 0 bis 60 Gew.-% Ethylenoxid, 0 bis 25 Gew.-% Alkoxysilylalkylglycidylether und 0 bis 25 Gew.-% weitere Monomere, bezogen auf das Gesamtgewicht der eingesetzten Monomere
d. Umsetzen mindestens eines Starters (2) mit 10 bis 97 Gew.-% Propylenoxid, 0 bis 60 Gew.-% Ethylenoxid, 0 bis 25 Gew.-% Alkoxysilylalkylglycidylether und 0 bis 25 Gew.-% weitere Monomere, bezogen auf das Gesamtgewicht der eingesetzten Monomere.

14. Verfahren nach einem der Ansprüche 9 bis 13 zur Herstellung von Alkoxylierungsprodukten gemäß Formel (I) oder Formel (IIa) gemäß Anspruch 10 **dadurch gekennzeichnet, dass** mindestens eine Verbindung der allgemeinen Formel (V) 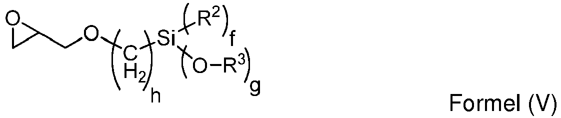 mit f, g, h, R² und R³ gemäß Formel (la) und (IIa) und gegebenenfalls mindestens einem Alkylenoxid umgesetzt werden.

15. Härtbare Zusammensetzung, enthaltend zumindest eine Zusammensetzung nach einem der Ansprüche 1 bis 8 und zumindest einen Härtungskatalysator.

## Claims

1. Composition comprising alkoxylation product mixtures with intrinsically reduced viscosity, obtainable by alkoxylation of epoxy-functional compounds in the presence of at least two different OH-functional starters, starter (1) and starter (2), **characterized in that** the starter (1) has a molar mass of greater than 400 g/mol, wherein in the case of average values the number average is given, and starter (2) has a molar mass of less than or equal to 400 g/mol, wherein the alkoxylation products (1) from starter (1) are constructed from alkylene oxide, from at least one epoxide carrying alkoxysilyl groups, and optionally from further monomers, and the alkoxylation products (2) from starter (2) are constructed from alkylene oxide and optionally from at least one epoxide carrying alkoxysilyl groups, and/or from further monomers.

2. Composition according to Claim 1, **characterized in that** the molar mass of starter (1) exceeds the molar mass of starter (2) by at least 200 g/mol.

3. Composition according to either of Claims 1 and 2, **characterized in that** the molar mass of starter (1) exceeds the molar mass of starter (2) by at least 600 g/mol, preferably by at least 1000 g/mol.

4. Composition according to any of Claims 1 to 3, **characterized in that** the starter (1) has t OH groups and starter (2) has t - 1 OH groups, where t = 2 to 8, preferably 2 to 5.

5. Composition according to any of Claims 1 to 4, **characterized in that** alkoxylation products (1) from starter (1) are constructed from preferably ethylene oxide and/or propylene oxide, from at least one alkoxysilylalkyl glycidyl ether and optionally from further monomers, and the alkoxylation products (2) from starter (2) are constructed from ethylene oxide and/or propylene oxide and from at least one alkoxysilylalkyl glycidyl ether and/or from further monomers.

6. Composition according to any of Claims 1 to 5, **characterized in that** alkoxylation products (1) are constructed from the following monomer fractions: 10 to 97 wt% of propylene oxide, 0 to 60 wt% of ethylene oxide, 0 to 25 wt% of alkoxysilylalkyl glycidyl ethers and 0 to 25 wt% of further monomers, based on the total weight of the alkoxylation products (1); and alkoxylation products (2) are constructed from the following monomer fractions: 10 to 97 wt% of propylene oxide, 0 to 60 wt% of ethylene oxide, 0 to 25 wt% of alkoxysilylalkyl glycidyl ethers and 0 to 25 wt% of further monomers, based on the total weight of the alkoxylation products (2).

7. Composition according to any of Claims 1 to 6, **characterized in that** starter (1) is selected from polyetherols, polycarbonate polyols and polyethercarbonates and starter (2) is preferably selected from butanol, ethanol or ethylhexanol.

8. Composition according to any of Claims 1 to 7, **characterized in that** the composition comprises at least alkoxylation product (1) and alkoxylation product (2), where alkoxylation product (1) obtainable from starter (1) conforms to the formula (I) and alkoxylation product (2) obtainable from starter (2) conforms to the formula (IIa):
Mᵢ Dⱼ Tₖ Qₗ URᵤ APᵥ formula (I)
where the fragments M, D, T and Q are linked not to one another but instead with one another via the groups UR and/or AP, and the groups UR and AP are not linked to one another but instead, accordingly, are linked with one another via the fragments M, D, T or Q,
i = 0 to 16,
j = 0 to 10,
k = 0 to 6,
1 = 0 to 4,
u = 0 to 17,
v = 0 to 6,
with the proviso that i + j + k + 1 > = 1,
M independently at each occurrence is an oxygen-radical-carrying hydrocarbon radical having a minimum numerical molar mass of 32 g/mol, which may optionally be interrupted by heteroatoms,
or is a radical of the formula (Ia) or of the formula (Ib) or of the formula (Ic) with 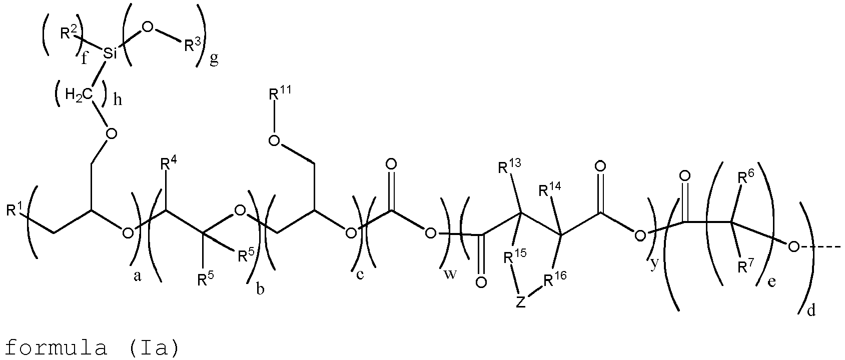 where
a = 0 to 100,
b = 1 to 1000,
c = 0 to 200,
d = 0 to 200,
m is an integer from 0 to 200.
n is an integer from 0 to 500,
e = 1 to 10,
f = 0 to 2
g = 1 to 3
with the proviso that g + f = 3 and g is at least 1,
h = 0 to 10
and with the proviso that the various monomer units of the fragments with the indices a, b, c, d, w and y may be constructed blockwise among one another or else are subject to a statistical distribution and, moreover, are freely permutable among one another, it being disallowed for each of the groups with the indices w and y to follow itself or the other respective group,
and where
R¹ = independently at each occurrence a saturated or unsaturated, linear or branched organic hydrocarbon radical which may contain O, S and/or N as heteroatoms,
R² = independently at each occurrence an alkyl group having 1 to 8 carbon atoms,
R³ = independently at each occurrence an alkyl group having 1 to 8 carbon atoms,
R⁴ = independently at each occurrence a hydrogen radical, an alkyl group having 1 to 20 carbon atoms, or an aryl or alkaryl group,
or R⁴ and one of the radicals R⁵ may together form a ring which includes the atoms to which R⁴ and R⁵ are bonded, this ring preferably containing 5 to 8 carbon atoms,
R⁵ = independently at each occurrence a hydrogen radical or an alkyl group having 1 to 8 carbon atoms,
R⁶, R⁷ = independently at each occurrence a hydrogen radical, an alkyl group having 1 to 20 carbon atoms, or an aryl or alkaryl group, and/or alkoxy group,
R¹¹ = independently at each occurrence a saturated or unsaturated, aliphatic or aromatic hydrocarbon radical having 2 to 30 C atoms, more particularly up to 24 C atoms, which is optionally substituted,
being preferably an alkyl group having 1 to 16 carbon atoms, more preferably having 6 to 12 carbon atoms, with a chain which may be interrupted by oxygen and may further carry functional groups,
R¹³, R¹⁴ = independently at each occurrence hydrogen and/or an organic radical, preferably alkyl, alkenyl, alkylidene, alkoxy, aryl and/or aralkyl groups, or else optionally R¹³ and/or R¹⁴ may be absent, and, if R¹³ and R¹⁴ are absent, there is a C=C double bond in place of the radicals R¹³ and R¹⁴ the bridging fragment Z may be present or absent;
if the bridging fragment Z is absent, then
R¹⁵, R¹⁶ = independently at each occurrence hydrogen and/or an organic radical, preferably alkyl, alkenyl, alkylidene, alkoxy, aryl and/or aralkyl groups, and, if one of the radicals R¹³ or R¹⁴ is absent, the respective geminal radical (i.e. R¹⁵ if R¹³ is absent and R¹⁶ if R¹⁴ is absent) is an alkylidene radical, preferably methylidene (= CH₂);
if the bridging fragment Z is present, then R¹⁵ and R¹⁶ = hydrocarbon radicals which are bridged cycloaliphatically or aromatically via the fragment Z, Z representing a divalent alkylene or alkenylene radical which may be further substituted, 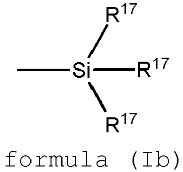 where
R¹⁷ = independently at each occurrence a linear or branched, saturated or unsaturated, optionally further-substituted alkyl group having 1 to 30 carbon atoms, or an aryl or alkaryl group, 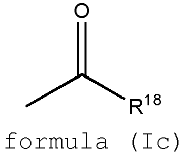
where
R¹⁸ = independently at each occurrence a divalent linear or cyclic, saturated or unsaturated alkyl or aryl group, which may be substituted,
and where, for the fragments D, T and Q:
D is a polyether radical -(D^{A})ₜD^{X} where t is 2,
T is a polyether radical -(D^{A})ₜD^{X} where t is 3 and
Q is a polyether radical -(D^{A})ₜD^{X} where t is 4,
where
D^{X} is a t-valent functional, saturated or unsaturated, linear or branched organic hydrocarbon radical, which may contain O, S, Si and/or N as heteroatoms, with each of the radicals D^{A} being covalently bonded to the radical D^{X},
and where D^{A} is a fragment of the formula (II) 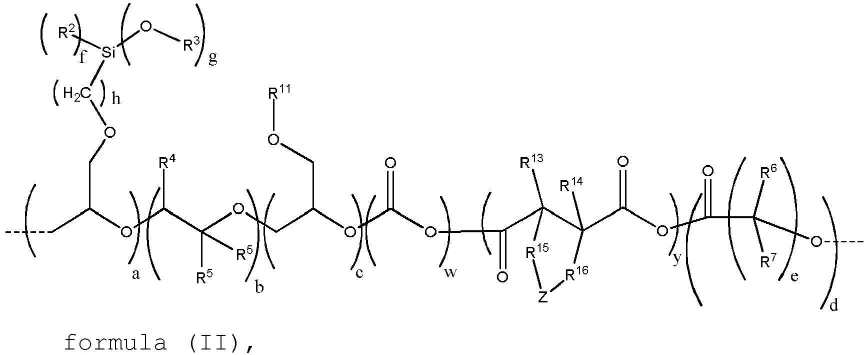 where a to h, w, x and y and R² to R¹⁶ independently at each occurrence are defined as in formula (Ia), with the proviso that the sum of all the indices a from formula (Ia) and formula (II) must be greater than or equal to 1,
UR independently at each occurrence are identical or different divalent radicals of the formula
-U-D^{C}-U-,
or a monovalent radical of the form D^{D}-U-, or a trivalent radical of the form D^{E}U₃, or a tetravalent radical of the form D^{F}U₄, where
U is a -C(O)-NH- group which is bonded via the nitrogen to D^{C}, D^{E}, D^{F} or D^{D}, and
D^{C} independently at each occurrence is a divalent substituted or unsubstituted, linear or branched, saturated or unsaturated hydrocarbon radical having 1 to 30 carbon atoms, selected from alkyl, alkenyl, aryl or alkaryl radicals, which may optionally be interrupted by heteroatoms such as O, N and/or S, and
D^{D} independently at each occurrence is a monovalent linear or branched, saturated or unsaturated hydrocarbon radical having 1 to 30 carbon atoms, selected from alkyl, alkenyl, aryl or alkaryl radicals, which may be interrupted by heteroatoms such as O, N and/or S and/or may carry further functional groups, and D^{E} independently at each occurrence is a trivalent substituted or unsubstituted, linear or branched, saturated or unsaturated hydrocarbon radical having 1 to 30 carbon atoms, selected from alkyl, alkenyl, aryl or alkaryl radicals, which may be interrupted by heteroatoms such as O, N and/or S and/or may carry further functional groups, and
D^{F} independently at each occurrence is a tetravalent substituted or unsubstituted, linear or branched, saturated or unsaturated hydrocarbon radical having 1 to 30 carbon atoms, selected from alkyl, alkenyl, aryl or alkaryl radicals, which may be interrupted by heteroatoms such as O, N and/or S and/or may carry further functional groups, and
AP independently at each occurrence are identical or different radicals of the general formula (IIIa), (IIIb) or (IIIc) 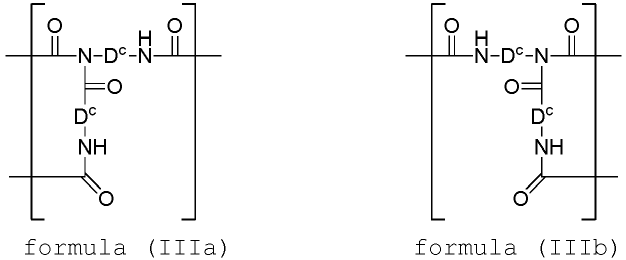 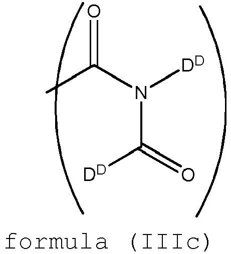
or if polyisocyanates with the structural units D^{E} and/or D^{F} are used, additionally structural elements analogous to formula (IIIa) and/or (IIIb), where the three urethane units bonded to D^{E} and/or the four urethane units bonded to D^{F}, independently at each occurrence, have all or in part been further reacted to give allophanate structural units, as shown in the top part of the formulae (IIIa) and (IIIb),
and with alkoxylation product (2) of the formula (IIa) 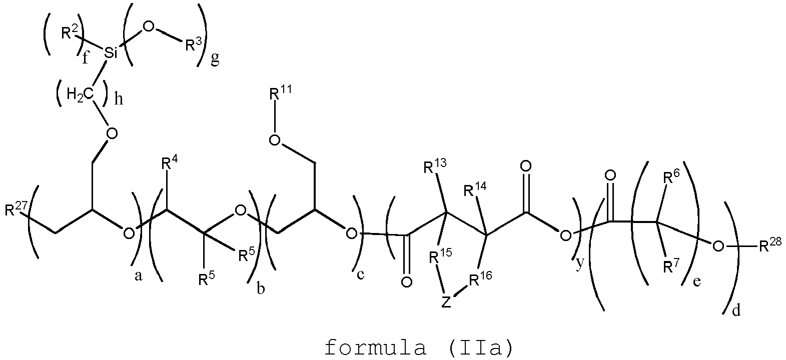 where
a = 1 to 100,
b = 1 to 200,
c = 0 to 100,
d = 0 to 100,
w = 0 to 100,
y = 0 to 50,
e = 1 to 10,
f = 0 to 2
g = 1 to 3
with the proviso that g + f = 3
h = 0 to 10,
with the proviso that the groups with the indices a, b, c, d and y are freely permutable over the molecule chain, it being disallowed for each of the groups having the index y to follow themselves, and with the proviso that the different monomer units and the fragments with the indices a, b, c, d and y may be constructed blockwise among one another, in which case individual blocks may also occur multiply and may be distributed statistically among one another, or else are subject to a statistical distribution and, moreover, are freely permutable among one another, in the sense of being for arrangement in any desired sequence, subject to the restriction that each of the groups with the indices w and y is not allowed to follow itself or the other respective group,
with the radicals R², R³, R⁴, R⁵, R⁶, R⁷, R¹¹, R¹³, R¹⁴, R¹⁵ and R¹⁶ being as defined in formula (Ia),
and where
R²⁷ = independently at each occurrence a saturated or unsaturated, linear or branched organic hydrocarbon radical which may contain O, S and/or N as heteroatoms, the hydrocarbon radical containing preferably 1 to 50 carbon atoms, preferably 2, 3 or 4 to 30 carbon atoms;
the radicals R²⁷ preferably result from monovalent alcohols such as methanol, ethanol, propanol, isopropanol, butanol, isobutanol, tert-butanol, 2,2,4-trimethyl-1,3-pentanediol monoisobutyrate (Texanol from Exxon), octanol, 2-ethylhexanol, 2-propylheptanol, decanol, dodecanol, C₁₂/C₁₄ fatty alcohol, phenol, all constitutional isomers of cresol, benzyl alcohol, stearyl alcohol, more preferably being butanol, 2,2,4-trimethyl-1,3-pentanediol monoisobutyrate (Texanol from Exxon), 2-ethylhexanol, allyl alcohol, 1-hexenol or 2-propylheptanol, more particularly butanol or allyl alcohol,
R²⁸ = independently at each occurrence hydrogen or a fragment, bonded via UR or AP, of the formulae (II) or (IIa).

9. Process for preparing compositions comprising alkoxylation products (1) and (2), comprising the steps of
a. reacting at least one starter (1) with at least one alkylene oxide and
b. reacting at least one starter (2) with at least one alkylene oxide,
where starters (1) and (2) are OH-functional compounds, and starter (1) has a molar mass of greater than 400 g/mol, wherein in the case of average values the number average is given, and starter (2) has a molar mass of less than or equal to 400 g/mol,
wherein the alkoxylation products (1) from starter (1) are constructed from alkylene oxide, from at least one epoxide carrying alkoxysilyl groups, and optionally from further monomers, and the alkoxylation products (2) from starter (2) are constructed from alkylene oxide and optionally from at least one epoxide carrying alkoxysilyl groups, and/or from further monomers.

10. Process according to Claim 9, **characterized in that** step b) takes place during the ongoing alkoxylation of step a) .

11. Process according to either of Claims 9 and 10, **characterized in that** the molar mass of starter (1) exceeds the molar mass of starter (2) by at least 600 g/mol, preferably by at least 1000 g/mol.

12. Process according to any of Claims 9 to 11, **characterized in that** the starter (1) has t OH groups and starter (2) has t - 1 OH groups, where t = 2 to 8, preferably 2 to 5.

13. Process according to any of Claims 9 to 12, comprising the steps of
c. reacting at least one starter (1) with 10 to 97 wt% of propylene oxide, 0 to 60 wt% of ethylene oxide, 0 to 25 wt% of alkoxysilylalkyl glycidyl ethers and 0 to 25 wt% of further monomers, based on the total weight of the monomers used,
d. reacting at least one starter (2) with 10 to 97 wt% of propylene oxide, 0 to 60 wt% of ethylene oxide, 0 to 25 wt% of alkoxysilylalkyl glycidyl ethers and 0 to 25 wt% of further monomers, based on the total weight of the monomers used.

14. Process according to any of Claims 9 to 13 for preparing alkoxylation products of formula (I) or formula (IIa) according to Claim 10, **characterized in that** at least one compound of the general formula (V) 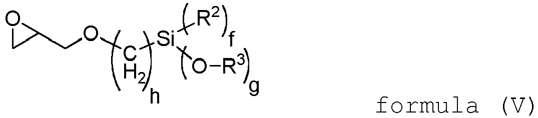
where f, g, h, R² and R³ are as per formula (Ia) and (IIa)
and optionally at least one alkylene oxide are reacted.

15. Curable composition comprising at least one composition according to any of Claims 1 to 8 and at least one curing catalyst.

## Revendications

1. Composition contenant des mélanges de produits d'alcoxylation présentant une viscosité réduite de manière intrinsèque, obtenus par alcoxylation de composés à fonctionnalité époxy en présence d'au moins deux initiateurs à fonctionnalité OH différents, l'initiateur (1) et l'initiateur (2), **caractérisée en ce que** l'initiateur (1) présente une masse molaire supérieure à 400 g/mole, où il s'agit, dans le cas de valeurs moyennes, de la moyenne en nombre, et l'initiateur (2) présente une masse molaire inférieure à 400 g/mole,
les produits d'alcoxylation (1) issus de l'initiateur (1) étant formés à partir d'oxyde d'alkylène, d'au moins un époxyde portant des groupes alcoxysilyle et le cas échéant d'autres monomères et les produits d'alcoxylation (2) issus de l'initiateur (2) étant formés à partir d'oxyde d'alkylène et le cas échéant d'au moins un époxyde portant des groupes alcoxysilyle et/ou d'autres monomères.

2. Composition selon la revendication 1, **caractérisée en ce que** la masse molaire de l'initiateur (1) est supérieure d'au moins 200 g/mole à la masse molaire de l'initiateur (2).

3. Composition selon l'une quelconque des revendications 1 ou 2, **caractérisée en ce que** la masse molaire de l'initiateur (1) est supérieure d'au moins 600 g/mole, de préférence d'au moins 1000 g/mole, à la masse molaire de l'initiateur (2).

4. Composition selon l'une quelconque des revendications 1 à 3, **caractérisée en ce que** l'initiateur (1) porte t groupes OH et l'initiateur (2) porte t-1 groupes OH, où t = 2 à 8, de préférence 2 à 5.

5. Composition selon l'une quelconque des revendications 1 à 4, **caractérisée en ce que** les produits d'alcoxylation (1) issus de l'initiateur (1) sont formés de préférence à partir d'oxyde d'éthylène et/ou d'oxyde de propylène, d'au moins un alcoxysilylalkylglycidyléther et le cas échéant d'autres monomères et les produits d'alcoxylation (2) issus de l'initiateur (2) sont formés à partir d'oxyde d'éthylène et/ou d'oxyde de propylène et d'au moins un alcoxysilylalkylglycidyléther et/ou d'autres monomères.

6. Composition selon l'une quelconque des revendications 1 à 5, **caractérisée en ce que** les produits d'alcoxylation (1) sont formés à partir des proportions monomères suivantes 10 à 97% en poids d'oxyde de propylène, 0 à 60% en poids d'oxyde d'éthylène, 0 à 25% en poids d'alcoxysilylalkylglycidyléther et 0 à 25% en poids d'autres monomères, par rapport au poids total des produits d'alcoxylation (1) ; et les produits d'alcoxylation (2) sont formés à partir des proportions monomères suivantes 10 à 97% en poids d'oxyde de propylène, 0 à 60% en poids d'oxyde d'éthylène, 0 à 25% en poids d'alcoxysilylalkylglycidyléther et 0 à 25% en poids d'autres monomères, par rapport au poids total des produits d'alcoxylation (2).

7. Composition selon l'une quelconque des revendications 1 à 6, **caractérisée en ce que** l'initiateur (1) est choisi parmi les polyétherols, les polycarbonatepolyols et les polyéthercarbonates et l'initiateur (2) est de préférence choisi parmi le butanol, l'éthanol ou l'éthylhexanol.

8. Composition selon l'une quelconque des revendications 1 à 7, **caractérisée en ce que** la composition comprend au moins le produit d'alcoxylation (1) et le produit d'alcoxylation (2), le produit d'alcoxylation (1) pouvant être obtenu à partir de l'initiateur (1) correspondant à la formule (I) et le produit d'alcoxylation (2) pouvant être obtenu à partir de l'initiateur (2) correspondant à la formule (IIa) :
Mᵢ Dⱼ Tₖ Qᵢ URᵤ APᵥ Formule (I)
dans laquelle les fragments M, D, T, Q ne sont pas liés les uns aux autres, mais reliés via les groupes UR et/ou AP et les groupes UR et AP ne sont pas liés l'un à l'autre mais donc reliés via les fragments M, D, T ou Q
i = 0 à 16,
j = 0 à 10,
k = 0 à 6,
l = 0 à 4,
u = 0 à 17,
v = 0 à 6,
étant entendu que i + j + k + l ≥ 1
M représente, indépendamment les uns des autres, un radical hydrocarboné portant un radical oxygène présentant une masse molaire numérique minimale de 32 g/mole qui peut le cas échéant être interrompu par des hétéroatomes, ou un radical de formule (Ia) ou de formule (Ib) ou de formule (Ic) 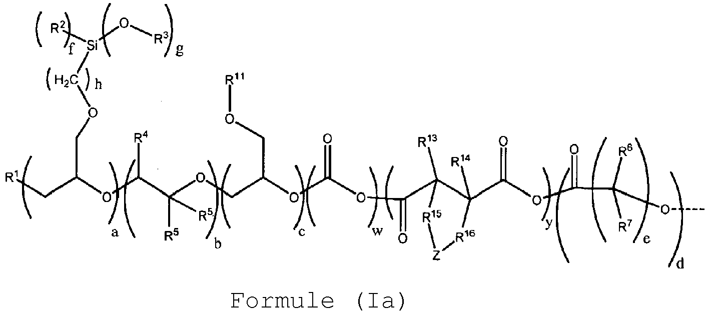 dans laquelle
a = 0 à 100,
b = 1 à 1000,
c = 0 à 200,
d = 0 à 200,
w = un nombre entier de 0 à 200,
y = un nombre entier de 0 à 500,
e = 1 à 10,
f = 0 à 2
g = 1 à 3
étant entendu que g + f = 3 et g vaut au moins 1,
h = 0 à 10
et étant entendu que les différents motifs monomères des fragments portant les indices a, b, c, d, w et y peuvent être formés sous forme de blocs entre eux ou alors sont soumis à une répartition statistique et sont en outre librement permutables entre eux, les groupes portant les indices w et y ne pouvant pas se succéder à eux-mêmes ou succéder à l'autre groupe respectif et dans laquelle
R¹ = indépendamment les uns des autres, un radical hydrocarboné organique saturé ou insaturé, linéaire ou ramifié, qui peut contenir O, S et/ou N comme hétéroatomes,
R² = indépendamment les uns des autres, un groupe alkyle comprenant 1 à 8 atomes de carbone,
R³ = indépendamment les uns des autres, un groupe alkyle comprenant 1 à 8 atomes de carbone,
R⁴ = indépendamment les uns des autres, un radical hydrogène, un groupe alkyle comprenant 1 à 20 atomes de carbone, un groupe aryle ou un groupe alkaryle,
ou R⁴ et un des radicaux R⁵ peuvent former, conjointement, un cycle qui comprend les atomes auxquels R⁴ et R⁵ sont liés, de préférence, ce cycle contient 5 à 8 atomes de carbone,
R⁵ = indépendamment les uns des autres, un radical hydrogène ou un groupe alkyle comprenant 1 à 8 atomes de carbone,
R⁶, R⁷ = indépendamment les uns des autres, un radical hydrogène, un groupe alkyle comprenant 1 à 20 atomes de carbone, un groupe aryle ou un groupe alkaryle et/ou un groupe alcoxy,
R¹¹ = indépendamment les uns des autres, un radical hydrocarboné saturé ou insaturé, aliphatique ou aromatique, comprenant 2 à 30 atomes de carbone, en particulier jusqu'à 24 atomes de carbone, qui est le cas échéant substitué, il s'agit de préférence d'un groupe alkyle comprenant 1 à 16 atomes de carbone, de manière particulièrement préférée 6 à 12 atomes de carbone, dont la chaîne peut être interrompue par de l'oxygène et peut porter d'autres groupes fonctionnels,
R¹³, R¹⁴ = indépendamment les uns des autres, hydrogène et/ou un radical organique, de préférence des groupes alkyle, alcényle, alkylidène, alcoxy, aryle et/ou aralkyle, ou R¹³ et/ou R¹⁴ peuvent le cas échéant également ne pas être présents, où, lorsque R¹³ et R¹⁴ ne sont pas présents, il existe une double liaison C=C à la place des radicaux R¹³ et R¹⁴, le fragment formant un pont Z peut être présent ou non,
si le fragment Z formant un pont n'est pas présent, alors
R¹⁵, R¹⁶ = indépendamment les uns des autres, hydrogène et/ou un radical organique, de préférence des groupes alkyle, alcényle, alkylidène, alcoxy, aryle et/ou aralkyle, où pour le cas où l'un des radicaux R¹³ ou R¹⁴ n'est pas présent, l'autre radical géminal respectif (donc R¹⁵ lorsque R¹³ n'est pas présent et R¹⁶ lorsque R¹⁴ n'est pas présent), représente un radical alkylidène, de préférence méthylidène (=CH₂),
si le fragment Z formant un pont est présent, alors
R¹⁵ et R¹⁶ = des radicaux hydrocarbonés qui forment un pont cycloaliphatique ou aromatique via le fragment Z, Z représentant un radical alkylène ou alcénylène divalent, qui peut être substitué davantage, 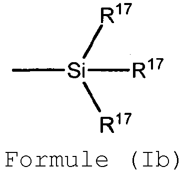
dans laquelle
R¹⁷ = indépendamment les uns des autres, un groupe alkyle linéaire ou ramifié, saturé ou insaturé, le cas échéant substitué davantage, comprenant 1 à 30 atomes de carbone, un groupe aryle ou alkaryle, 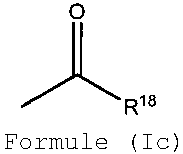
dans laquelle
R¹⁸ = indépendamment les uns des autres, un groupe divalent alkyle linéaire ou cyclique, saturé ou insaturé ou aryle, qui peut être substitué, et pour les fragments D, T et Q :
D représente un radical polyéther -(D^{A})ₜ-D^{x} où t = 2,
T représente un radical polyéther -(D^{A})ₜ-D^{x} où t = 3,
Q représente un radical polyéther -(D^{A})ₜ-D^{x} où t = 4, où
D^{x} représente un radical hydrocarboné organique t-valent, fonctionnel, saturé ou insaturé, linéaire ou ramifié, qui peut contenir O, S, Si et/ou N comme hétéroatomes, chaque radical D^{A} étant lié par covalence au radical D^{x},
et D^{A} représente un fragment de formule (II) 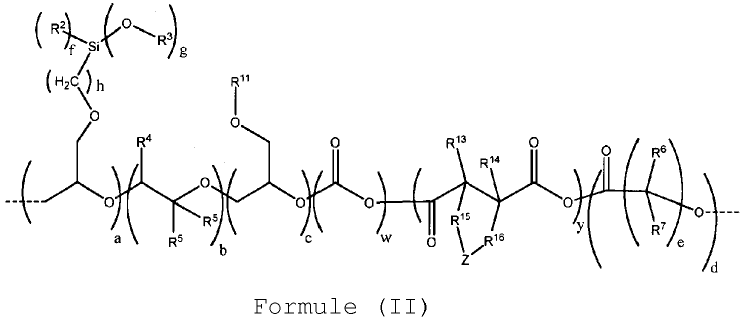
où a à h, w, x et y et R² à R¹⁶ sont définis, indépendamment les uns des autres, comme dans la formule (Ia),
étant entendu que la somme de tous les indices a de la formule (Ia) et de la formule (II) doit être égale ou supérieure à 1,
UR représente, indépendamment les uns des autres, des radicaux divalents identiques ou différents de formule
-U-D^{C}-U-,
ou un radical monovalent de formule D^{D}-U-,
ou un radical trivalent de formule D^{E}U₃,
ou un radical tétravalent de formule D^{F}U₄,
où
U représente -C(O)-NH-, qui est lié via l'azote à D^{C}, D^{E}, D^{F} ou D^{D} et
D^{C} représente, indépendamment les uns des autres, un radical hydrocarboné divalent, substitué ou non substitué, linéaire ou ramifié, saturé ou insaturé comprenant 1 à 30 atomes de carbone, choisi parmi les radicaux alkyle, alcényle, aryle ou alkaryle, qui peut le cas échéant être interrompu par des hétéroatomes tels que O, N et/ou S et
D^{D} représente, indépendamment les uns des autres, un radical hydrocarboné monovalent, linéaire ou ramifié, saturé ou insaturé comprenant 1 à 30 atomes de carbone, choisi parmi les radicaux alkyle, alcényle, aryle ou alkaryle, qui peut le cas échéant être interrompu par des hétéroatomes tels que O, N et/ou S et/ou qui peut porter d'autres groupes fonctionnels et D^{E} représente, indépendamment les uns des autres, un radical hydrocarboné trivalent, substitué ou non substitué, linéaire ou ramifié, saturé ou insaturé comprenant 1 à 30 atomes de carbone, choisi parmi les radicaux alkyle, alcényle, aryle ou alkaryle, qui peut être interrompu par des hétéroatomes tels que O, N et/ou S et/ou qui peut porter d'autres groupes fonctionnels et
D^{F} représente, indépendamment les uns des autres, un radical hydrocarboné tétravalent, substitué ou non substitué, linéaire ou ramifié, saturé ou insaturé comprenant 1 à 30 atomes de carbone, choisi parmi les radicaux alkyle, alcényle, aryle ou alkaryle, qui peut le cas échéant être interrompu par des hétéroatomes tels que O, N et/ou S et/ou qui peut porter d'autres groupes fonctionnels et
AP représente, indépendamment les uns des autres, des radicaux identiques ou différents des formules générales (IIIa), (IIIb) ou (IIIc) 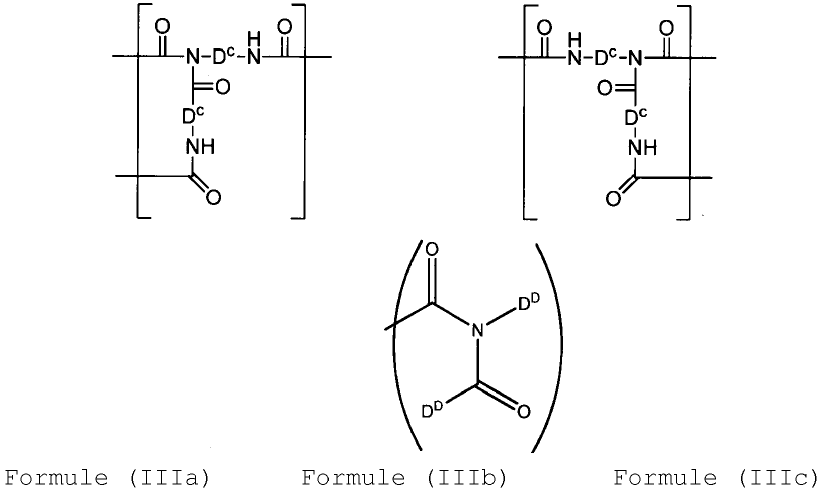
ou, pour le cas où des polyisocyanates présentant les motifs structuraux D^{E} et/ou D^{F} sont utilisés, en plus des éléments structuraux selon la formule (IIIa) et/ou (IIIb), les trois motifs uréthane qui sont liés à D^{E} ou les quatre motifs uréthane qui sont liés à D^{F} étant en outre transformés, indépendamment les uns des autres, tous ou en partie, en motifs structuraux allophanate, comme représenté dans la partie supérieure des formules (IIIa) et (IIIb)
et le produit d'alcoxylation (2) de formule (IIa) 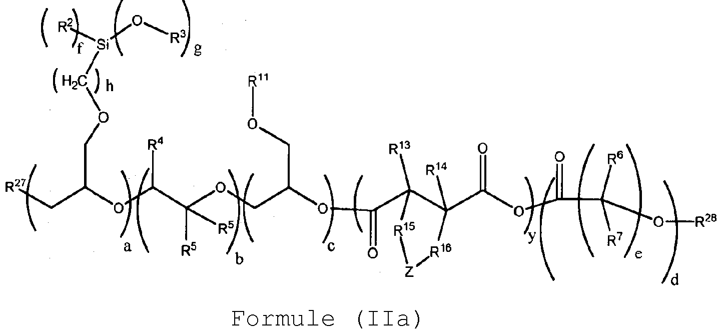 dans laquelle
a = 1 à 100,
b = 1 à 200,
c = 0 à 100,
d = 0 à 100,
w = 0 à 100
y = 0 à 50,
e = 1 à 10,
f = 0 à 2
g = 1 à 3
étant entendu que g + f = 3
h = 0 à 10,
étant entendu que les groupes portant les indices a, b, c, d et y sont librement permutables sur les chaînes moléculaires, les groupes portant l'indice y ne pouvant pas se succéder eux-mêmes et
étant entendu que les différents motifs monomères des fragments portant les indices a, b, c, d et y peuvent être formés sous forme de blocs entre eux, les différents blocs pouvant également être présents plusieurs fois et répartis statistiquement les uns avec les autres, ou être soumis à une répartition statistique et en outre librement permutables entre eux, dans le sens d'une disposition dans un ordre quelconque, avec la restriction que les groupes portant les indices w et y ne peuvent pas se succéder eux-mêmes ou succéder à l'autre groupe respectif, les radicaux R², R³, R⁴, R⁵, R⁶, R⁷, R¹¹, R¹³, R¹⁴, R¹⁵ et R¹⁶ étant définis comme dans la formule (Ia) et
R²⁷ = indépendamment les uns des autres, un radical hydrocarboné organique saturé ou insaturé, linéaire ou ramifié, qui peut contenir O, S et/ou N comme hétéroatomes, de préférence le radical hydrocarboné contient 1 à 50 atomes de carbone, de préférence 2, 3 ou 4 à 30 atomes de carbone,
les radicaux R²⁷ sont de préférence issus d'alcools monovalents tels que le méthanol, l'éthanol, le propanol, l'isopropanol, le butanol, l'iso-butanol, le tert-butanol, le mono-isobutyrate de 2,2,4-triméthyl-1,3-pentanediol (Texanol de la société Exxon), l'octanol, le 2-éthylhexanol, le 2-propylheptanol, le décanol, le dodécanol, un alcool gras en C₁₂/C₁₄, le phénol, tous les isomères de constitution du crésol, l'alcool benzylique, l'alcool stéarylique, de manière particulièrement préférée le butanol, le mono-isobutyrate de 2,2,4-triméthyl-1,3-pentanediol (Texanol de la société Exxon), le 2-éthylhexanol, l'alcool allylique, le 1-hexénol ou le 2-propylheptanol, en particulier le butanol ou l'alcool allylique,
R²⁸ = indépendamment les uns des autres, hydrogène ou un fragment des formules (II) ou (IIa) liés via UR ou AP.

9. Procédé pour la préparation de compositions contenant des produits d'alcoxylation (1) et (2) comprenant les étapes :
a. transformation d'au moins un initiateur (1) avec au moins un oxyde d'alkylène et
b. transformation d'au moins un initiateur (2) avec au moins un oxyde d'alkylène et
les initiateurs (1) et (2) étant des composés à fonctionnalité OH et l'initiateur (1) présentant une masse molaire supérieure à 400 g/mole, où il s'agit, dans le cas de valeurs moyennes, de la moyenne en nombre, et l'initiateur (2) présentant une masse molaire inférieure à 400 g/mole,
les produits d'alcoxylation (1) issus de l'initiateur (1) étant formés à partir d'oxyde d'alkylène, d'au moins un époxyde portant des groupes alcoxysilyle et le cas échéant d'autres monomères et les produits d'alcoxylation (2) issus de l'initiateur (2) étant formés à partir d'oxyde d'alkylène et le cas échéant d'au moins un époxyde portant des groupes alcoxysilyle et/ou d'autres monomères.

10. Procédé selon la revendication 9, **caractérisé en ce que** l'étape b) a lieu pendant le déroulement de l'alcoxylation de l'étape a).

11. Procédé selon l'une quelconque des revendications 9 ou 10, **caractérisé en ce que** la masse molaire de l'initiateur (1) est supérieure d'au moins 600 g/mole, de préférence d'au moins 1000 g/mole, à la masse molaire de l'initiateur (2).

12. Procédé selon l'une quelconque des revendications 9 à 11, **caractérisé en ce que** l'initiateur (1) porte t groupes OH et l'initiateur (2) porte t-1 groupes OH, où t = 2 à 8, de préférence 2 à 5.

13. Procédé selon l'une quelconque des revendications 9 à 12, comprenant les étapes :
c. transformation d'au moins un initiateur (1) avec 10 à 97% en poids d'oxyde de propylène, 0 à 60% en poids d'oxyde d'éthylène, 0 à 25% en poids d'alcoxysilylalkylglycidyléther et 0 à 25% en poids d'autres monomères, par rapport au poids total des monomères utilisés
d. transformation d'au moins un initiateur (2) avec 10 à 97% en poids d'oxyde de propylène, 0 à 60% en poids d'oxyde d'éthylène, 0 à 25% en poids d'alcoxysilylalkylglycidyléther et 0 à 25% en poids d'autres monomères, par rapport au poids total des monomères utilisés.

14. Procédé selon l'une quelconque des revendications 9 à 13 pour la préparation de produits d'alcoxylation selon la formule (I) ou la formule (IIa) selon la revendication 10, **caractérisé en ce qu'**on transforme au moins un composé de formule générale (V) 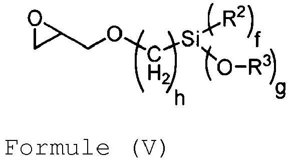 f, g, h, R² et R³ étant selon les formules (Ia) et (IIa) et le cas échéant au moins un oxyde d'alkylène.

15. Composition durcissable contenant au moins une composition selon l'une quelconque des revendications 1 à 8 et au moins un catalyseur de durcissement.
